(19) Europäisches Patentamt
European Patent Office
Office européen des brevets

(11) EP 3 524 628 A1

(12) **EUROPEAN PATENT APPLICATION**
published in accordance with Art. 153(4) EPC

(43) Date of publication:
**14.08.2019 Bulletin 2019/33**

(21) Application number: **17858324.1**

(22) Date of filing: **29.09.2017**

(51) Int Cl.:
***C08F 220/34*** *(2006.01)* ***C09K 3/00*** *(2006.01)*
***G02B 5/30*** *(2006.01)*

(86) International application number:
**PCT/JP2017/035728**

(87) International publication number:
**WO 2018/066486 (12.04.2018 Gazette 2018/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **06.10.2016 JP 2016198170**

(71) Applicant: **Zeon Corporation**
**Tokyo 100-8246 (JP)**

(72) Inventors:
- **SAKAMOTO Kei**
  **Tokyo 100-8246 (JP)**
- **OKUYAMA Kumi**
  **Tokyo 100-8246 (JP)**

(74) Representative: **Beckmann, Claus**
**Kraus & Weisert**
**Patentanwälte PartGmbB**
**Thomas-Wimmer-Ring 15**
**80539 München (DE)**

(54) **MIXTURE, POLYMERIZABLE COMPOSITION, POLYMER, OPTICAL FILM, OPTICALLY ANISOTROPIC OBJECT, POLARIZER, FLAT PANEL DISPLAY DEVICE, ORGANIC ELECTROLUMINESCENT DISPLAY DEVICE, ANTIREFLECTION FILM, AND METHOD OF USING POLYMERIZABLE COMPOUND**

(57) Provided is a polymerizable composition that is capable of forming an optical film, etc. having excellent reverse wavelength dispersibility, can be prepared at relatively low temperature, and has excellent stability around room temperature. A mixture comprises a polymerizable compound represented by the following Formula (I) and a polymerizable compound represented by the following Formula (II):

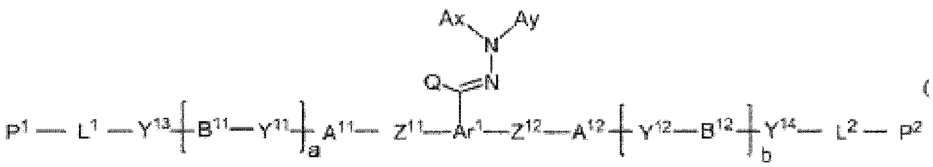
(I)

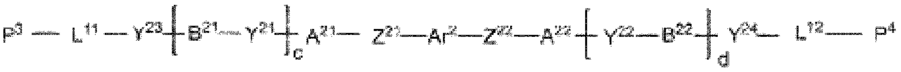
(II)

EP 3 524 628 A1

## Description

### TECHNICAL FIELD

The present disclosure relates to an optical film and an optically anisotropic product capable of uniform polarized light conversion over a wide wavelength range, and a polarizing plate, a flat panel display device, an organic electroluminescent display device, and an antireflection film using the optically anisotropic product.

The present disclosure also relates to a polymer usable in the preparation of the optical film and the optically anisotropic product, a mixture usable in the preparation of the polymer, and a polymerizable composition containing the mixture.

The present disclosure further relates to a method of using a predetermined polymerizable compound in order to suppress precipitation of a compound in a polymerizable composition.

### BACKGROUND

Retardation plates used in various devices such as flat panel display devices include quarter wavelength plates for converting linearly polarized light into circularly polarized light and half wavelength plates for converting the plane of vibration of linearly polarized light by 90 degrees. These retardation plates are capable of accurately providing a phase difference of 1/4λ or 1/2λ of the light wavelength for specific monochromatic light.

However, conventional retardation plates have a problem in that polarized light output through a retardation plate is converted into colored polarized light. A material forming the retardation plate has wavelength dispersibility for phase differences, and a distribution occurs in the polarization state of each wavelength for white light which is a composite wave in which light rays in the visible light range are mixed. This makes it impossible to adjust input light to polarized light of an accurate 1/4λ or 1/2λ phase difference in all wavelength regions.

To solve this problem, various wide band retardation plates capable of providing a uniform phase difference to light over a wide wavelength range, that is, retardation plates having reverse wavelength dispersibility, have been studied.

Meanwhile, with the functionality enhancement and widespread use of mobile information terminals such as mobile PCs and mobile phones, the need to reduce the thicknesses of flat panel display devices as much as possible has been growing. This has led to the demand for thinner retardation plates as their constituent members.

The most effective method for reducing the thicknesses of retardation plates in recent years is a method of producing a retardation plate by applying a polymerizable composition containing a low-molecular polymerizable compound to a film substrate to form an optical film. Hence, many polymerizable compounds capable of forming optical films having excellent reverse wavelength dispersibility or polymerizable compositions using such polymerizable compounds have been developed (for example, see PTL 1).

### CITATION LIST

#### Patent Literature

PTL 1: JP 2010-031223 A

### SUMMARY

#### (Technical Problem)

To ensure the coatability of the polymerizable composition and impart a desired thickness to the obtained optical film or optically anisotropic product (hereafter also collectively referred to as "optical film, etc."), the concentration of the polymerizable compound in the polymerizable composition needs to be at least a certain level. However, for example, the polymerizable compound described in PTL 1 has the following problem: The polymerizable compound may not have sufficient solubility in an industrially usable solvent, and, when the temperature is increased (e.g. 85 °C or more) in order to improve the solubility, part of the polymerizable compound polymerizes and turns into a gel. The polymerizable compound also has the following problem: When, after dissolving the polymerizable compound in the polymerizable composition at high temperature, the polymerizable composition is cooled to around room temperature (about 23 °C) before filtration for removal of foreign body or application to a film substrate, the polymerizable compound in the polymerizable composition precipitates.

There has thus been a need for a polymerizable composition that is capable of forming an optical film, etc. having excellent reverse wavelength dispersibility, can be prepared at relatively low temperature (e.g. less than 85 °C), and has excellent stability around room temperature.

It could be helpful to provide a means for advantageously solving these problems.

(Solution to Problem)

As a result of extensive studies made to achieve the object stated above, the following facts have been discovered: By adding a polymerizable compound represented by the following Formula (I) to a polymerizable composition, a compound in the polymerizable composition (a compound other than the polymerizable compound represented by the following Formula (I), specifically, a polymerizable compound represented by the following Formula (II)) can be dissolved in a solvent at relatively low temperature, and the stability of the polymerizable composition around room temperature can be ensured. In addition, by using a mixture of the polymerizable compound represented by the following Formula (I) and the polymerizable compound represented by the following Formula (II), a polymerizable composition that has excellent stability around room temperature and can be prepared at relatively low temperature can be obtained, and an optical film, etc. having excellent reverse wavelength dispersibility can be produced using the polymerizable composition. The present disclosure is based on these discoveries.

The below-described mixture, polymerizable composition, polymer, optical film, optically anisotropic product, polarizing plate, flat panel display device, organic electroluminescent display device, antireflection film, and method of using a polymerizable compound are thus provided.

[1] A mixture comprising:

a polymerizable compound represented by the following Formula (I):

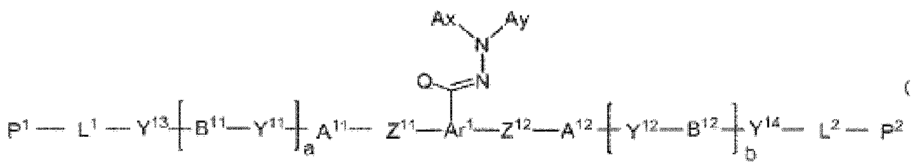

(I)

where $Ar^1$ represents an aromatic group that may have a substituent,
Q represents a hydrogen atom or an alkyl group with a carbon number of 1 to 6,
Ax represents an organic group having at least one aromatic ring selected from the group consisting of an aromatic hydrocarbon ring with a carbon number of 6 to 30 and an aromatic heterocyclic ring with a carbon number of 2 to 30, and the aromatic ring of Ax may have a substituent,
Ay represents a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, $-C(=O)-R^{11}$, $-SO_2-R^{12}$, $-CS-NH-R^{13}$, an aromatic hydrocarbon ring group with a carbon number of 6 to 30 that may have a substituent, or an aromatic heterocyclic group with a carbon number of 2 to 30 that may have a substituent, $R^{11}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, $R^{12}$ represents an alkyl group with a carbon number of 1 to 6, or an aromatic hydrocarbon ring group with a carbon number of 6 to 20 that may have a substituent, and $R^{13}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, an aromatic hydrocarbon ring group with a carbon number of 5 to 20 that may have a substituent, or an aromatic heterocyclic group with a carbon number of 5 to 20 that may have a substituent,
$Z^{11}$ and $Z^{12}$ each independently represent a single bond, $-O-CH_2-$, $-CH_2-O-$, $-C(=O)-O-$, $-O-C(=O)-$, $-C(=O)-S-$, $-S-C(=O)-$, $-NR^{21}-C(=O)-$, $-C(=O)-NR^{21}-$, $-CF_2-O-$, $-O-CF_2-$, $-CH_2-CH_2-$, $-CF_2-CF_2-$, $-O-CH_2-CH_2-O-$, $-CH=CH-C(=O)-O-$, $-O-C(=O)-CH=CH-$, $-CH_2-CH_2-C(=O)-O-$, $-O-C(=O)-CH_2-CH_2-$, $-CH_2-CH_2-O-C(=O)-$, $-C(=O)-O-CH_2-CH_2-$, $-CH_2-C(=O)-O-$, $-O-C(=O)-CH_2-$, $-CH_2-O-C(=O)-$, $-C(=O)-O-CH_2-$, $-CH=CH-$, $-N=CH-$, $-CH=N-$, $-N=C(CH_3)-$, $-C(CH_3)=N-$, $-N=N-$, or $-C≡C-$, and $R^{21}$ represents a hydrogen atom or an alkyl group with a carbon number of 1 to 6,
$A^{11}$, $A^{12}$, $B^{11}$, and $B^{12}$ each independently represent a cyclic aliphatic group that may have a substituent or an aromatic group that may have a substituent,
$Y^{11}$ to $Y^{14}$ each independently represent a single bond, $-O-$, $-C(=O)-$, $-C(=O)-O-$, $-O-C(=O)-$, $-NR^{31}-C(=O)-$,

-C(=O)-$NR^{31}$-, -O-C(=O)-O-, -$NR^{31}$-C(=O)-O-, -O-C(=O)-$NR^{31}$-, or -$NR^{31}$-C(=O)-$NR^{32}$-, and $R^{31}$ and $R^{32}$ each independently represent a hydrogen atom or an alkyl group with a carbon number of 1 to 6,

$L^1$ and $L^2$ each independently represent an organic group of any of an alkylene group with a carbon number of 1 to 20 and a group obtained by substituting at least one methylene group (-$CH_2$-) contained in an alkylene group with a carbon number of 1 to 20 by -O- or -C(=O)-, and a hydrogen atom contained in the organic group for $L^1$ and $L^2$ may be substituted by an alkyl group with a carbon number of 1 to 5, an alkoxy group with a carbon number of 1 to 5, or a halogen atom,

one of $P^1$ and $P^2$ represents a hydrogen atom or a polymerizable group, and the other one of $P^1$ and $P^2$ represents a polymerizable group, and

a and b are each independently 0 or 1; and

a polymerizable compound represented by the following Formula (II):

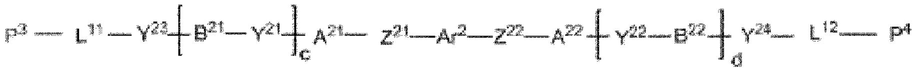 (II)

where $Ar^2$ represents any of the following Formulas (III-1) to (III-4):

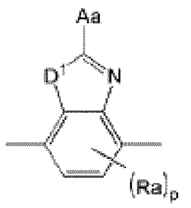
(III-1)

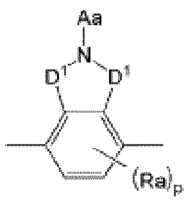
(III-2)

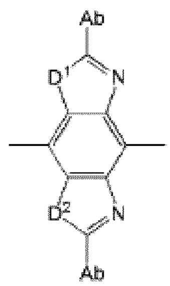
(III-3)

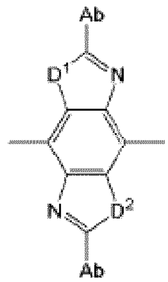
(III-4)

where Ra each independently represent a halogen atom, an alkyl group with a carbon number of 1 to 6, a cyano group, a nitro group, an alkylsulfinyl group with a carbon number of 1 to 6, an alkylsulfonyl group with a carbon number of 1 to 6, a carboxyl group, a fluoroalkyl group with a carbon number of 1 to 6, an alkoxy group with a carbon number of 1 to 6, an alkylthio group with a carbon number of 1 to 6, an N-alkylamino group with a carbon number of 1 to 6, an N,N-dialkylamino group with a carbon number of 2 to 12, an N-alkylsulfamoyl group with a carbon number of 1 to 6, or an N,N-dialkylsulfamoyl group with a carbon number of 2 to 12,

$D^1$ and $D^2$ each independently represent -$CR^{41}R^{42}$-, -S-, -$NR^{41}$-, -C(=O)-, or -O-, and $R^{41}$ and $R^{42}$ each independently represent a hydrogen atom or an alkyl group with a carbon number of 1 to 4,

Aa and Ab each independently represent an aromatic hydrocarbon ring group or an aromatic heterocyclic group that may be substituted,

p represents an integer of 0 to 2, and in the case where a plurality of Ra, $D^1$, or Ab are present, the plurality of Ra, $D^1$, or Ab may be the same or different,

$Z^{21}$ and $Z^{22}$ each independently represent a single bond, -O-$CH_2$-, -$CH_2$-O-, -C(=O)-O-, -O-C(=O)-, -C(=O)-S-, -S-C(=O)-, -$NR^{51}$-C(=O)-, -C(=O)-$NR^{51}$-, -$CF_2$-O-, -O-$CF_2$-, -$CH_2$-$CH_2$-, -$CF_2$-$CF_2$-, -O-$CH_2$-$CH_2$-O-, -CH=CH-C(=O)-O-, -O-C(=O)-CH=CH-, -$CH_2$-$CH_2$-C(=O)-O-, -O-C(=O)-$CH_2$-$CH_2$-, -$CH_2$-$CH_2$-O-C(=O)-, -C(=O)-O-$CH_2$-$CH_2$-, -$CH_2$-C(=O)-O-, -O-C(=O)-$CH_2$-, -$CH_2$-O-C(=O)-, -C(=O)-O-$CH_2$-, -CH=CH-, -N=CH-, -CH=N-, -N=C($CH_3$)-, -C($CH_3$)=N-, -N=N-, or -C=C-, and $R^{51}$ represents a hydrogen atom or an alkyl group with a carbon number of 1 to 6,

$A^{21}$, $A^{22}$, $B^{21}$, and $B^{22}$ each independently represent a cyclic aliphatic group that may have a substituent or an aromatic group that may have a substituent,

$Y^{21}$ to $Y^{24}$ each independently represent a single bond, -O-, -C(=O)-, -C(=O)-O-, -O-C(=O)-, -$NR^{61}$-C(=O)-, -C(=O)-$NR^{61}$-, -O-C(=O)-O-, -$NR^{61}$-C(=O)-O-, -O-C(=O)-$NR^{61}$-, or -$NR^{61}$-C(=O)-$NR^{62}$-, and $R^{61}$ and $R^{62}$ each independently represent a hydrogen atom or an alkyl group with a carbon number of 1 to 6,

$L^{11}$ and $L^{12}$ each independently represent an organic group of any of an alkylene group with a carbon number of 1 to 20 and a group obtained by substituting at least one methylene group (-$CH_2$-) contained in an alkylene group with a carbon number of 1 to 20 by -O- or -C(=O)-, and a hydrogen atom contained in

the organic group for $L^{11}$ and $L^{12}$ may be substituted by an alkyl group with a carbon number of 1 to 5, an alkoxy group with a carbon number of 1 to 5, or a halogen atom,
one of $P^3$ and $P^4$ represents a hydrogen atom or a polymerizable group, and the other one of $P^3$ and $P^4$ represents a polymerizable group, and
c and d are each independently 0 or 1.

[2] The mixture according to [1], wherein a proportion of the polymerizable compound represented by the Formula (I) in a total of the polymerizable compound represented by the Formula (I) and the polymerizable compound represented by the Formula (II) is 5 mass% or more and 90 mass% or less.
[3] The mixture according to [1] or [2], wherein Ay is an alkyl group with a carbon number of 1 to 20 that may have a substituent, an alkenyl group with a carbon number of 2 to 20 that may have a substituent, an alkynyl group with a carbon number of 2 to 20 that may have a substituent, an aromatic hydrocarbon ring group with a carbon number of 6 to 30 that may have a substituent, or an aromatic heterocyclic group with a carbon number of 2 to 30 that may have a substituent.
[4] The mixture according to any of [1] to [3], wherein Ax is a group represented by the following Formula (IV):

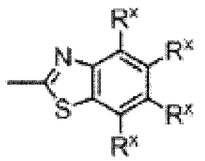

(IV)

where $R^X$ represents a hydrogen atom, a halogen atom, an alkyl group with a carbon number of 1 to 6, a cyano group, a nitro group, a fluoroalkyl group with a carbon number of 1 to 6, an alkoxy group with a carbon number of 1 to 6, $-OCF_3$, or $-C(=O)-O-R^2$, $R^2$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, a plurality of $R^X$ may all be the same or may be different, and at least one $C-R^X$ forming a ring may be substituted by a nitrogen atom.
[5] The mixture according to any of [1] to [4], wherein $Ar^1$ is a benzene ring group.
[6] The mixture according to [1] or [2], wherein the polymerizable compound represented by the Formula (I) is a polymerizable compound represented by the following Formula (V):

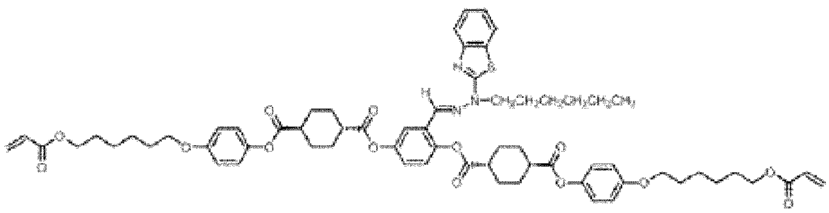

(V)

,

and the polymerizable compound represented by the Formula (II) is at least any of a polymerizable compound represented by the following Formula (VI):

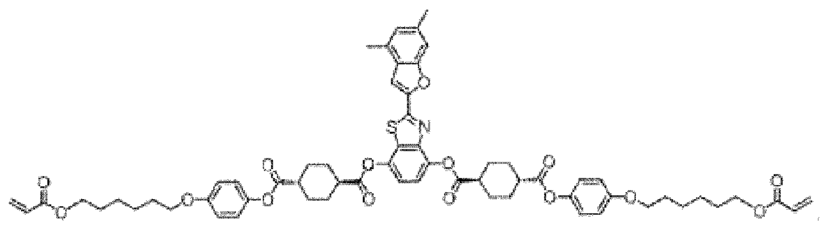

(VI)

and a polymerizable compound represented by the following Formula (VII):

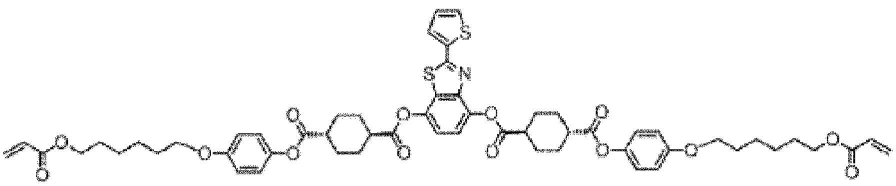

(VII)

.

[7] A polymerizable composition comprising: the mixture according to any of [1] to [6]; and a polymerization initiator.

[8] The polymerizable composition according to [7], further comprising a solvent.

[9] The polymerizable composition according to [8], wherein the solvent contains at least any of ethers and ketones.

[10] A polymer obtainable by polymerization of the mixture according to any of [1] to [6].

[11] A polymer obtainable by polymerization of the polymerizable composition according to any of [7] to [9].

[12] An optical film comprising the polymer according to [10] or [11] as a constituent material.

[13] An optically anisotropic product comprising a layer having the polymer according to [10] or [11] as a constituent material.

[14] A polarizing plate comprising: the optically anisotropic product according to [13]; and a polarizing film.

[15] A flat panel display device comprising: the polarizing plate according to [14]; and a liquid crystal panel.

[16] An organic electroluminescent display device comprising: the polarizing plate according to [14]; and an organic electroluminescent panel.

[17] An antireflection film comprising the polarizing plate according to [14].

[18] A method of using a polymerizable compound represented by the following Formula (I) to suppress precipitation of a compound in a polymerizable composition:

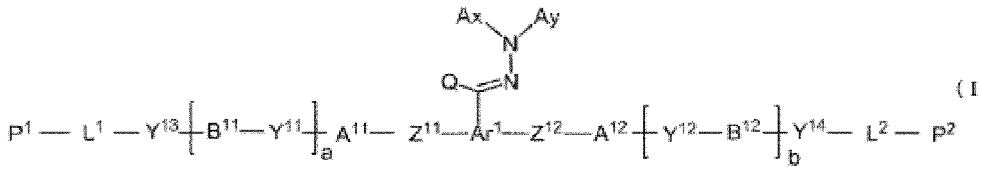

(I)

where $Ar^1$ represents an aromatic group that may have a substituent,

Q represents a hydrogen atom or an alkyl group with a carbon number of 1 to 6,

Ax represents an organic group having at least one aromatic ring selected from the group consisting of an aromatic hydrocarbon ring with a carbon number of 6 to 30 and an aromatic heterocyclic ring with a carbon number of 2 to 30, and the aromatic ring of Ax may have a substituent,

Ay represents a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, $-C(=O)-R^{11}$, $-SO_2-R^{12}$, $-CS-NH-R^{13}$, an aromatic hydrocarbon ring group with a carbon number of 6 to 30 that may have a substituent, or an aromatic heterocyclic group with a carbon number of 2 to 30 that may have a substituent, $R^{11}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, $R^{12}$ represents an alkyl group with a carbon number of 1 to 6, or an aromatic hydrocarbon ring group with a carbon number of 6 to 20 that may have a substituent, and $R^{13}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, an aromatic hydrocarbon ring group with a carbon number of 5 to 20 that may have a substituent, or an aromatic heterocyclic group with a carbon number of 5 to 20 that may have a substituent,

$Z^{11}$ and $Z^{12}$ each independently represent a single bond, $-O-CH_2-$, $-CH_2-O-$, $-C(=O)-O-$, $-O-C(=O)-$, $-C(=O)-S-$, $-S-C(=O)-$, $-NR^{21}-C(=O)-$, $-C(=O)-NR^{21}-$, $-CF_2-O-$, $-O-CF_2-$, $-CH_2-CH_2-$, $-CF_2-CF_2-$, $-O-CH_2-CH_2-O-$, $-CH=CH-C(=O)-O-$, $-O-C(=O)-CH=CH-$, $-CH_2-CH_2-C(=O)-O-$, $-O-C(=O)-CH_2-CH_2-$, $-CH_2-CH_2-O-C(=O)-$, $-C(=O)-O-CH_2-CH_2-$, $-CH_2-C(=O)-O-$, $-O-C(=O)-CH_2-$, $-CH_2-O-C(=O)-$, $-C(=O)-O-CH_2-$, $-CH=CH-$, $-N=CH-$, $-CH=N-$, $-N=C(CH_3)-$, $-C(CH_3)=N-$, $-N=N-$, or $-C=C-$, and $R^{21}$ represents a hydrogen atom or an alkyl group with a carbon number of 1 to 6,

$A^{11}$, $A^{12}$, $B^{11}$, and $B^{12}$ each independently represent a cyclic aliphatic group that may have a substituent or an aromatic group that may have a substituent,

$Y^{11}$ to $Y^{14}$ each independently represent a single bond, -O-, -C(=O)-, -C(=O)-O-, -O-C(=O)-, -$NR^{31}$-C(=O)-, -C(=O)-$NR^{31}$-, -O-C(=O)-O-, -$NR^{31}$-C(=O)-O-, -O-C(=O)-$NR^{31}$-, or -$NR^{31}$-C(=O)-$NR^{32}$-, and $R^{31}$ and $R^{32}$ each independently represent a hydrogen atom or an alkyl group with a carbon number of 1 to 6,

$L^1$ and $L^2$ each independently represent an organic group of any of an alkylene group with a carbon number of 1 to 20 and a group obtained by substituting at least one methylene group (-$CH_2$-) contained in an alkylene group with a carbon number of 1 to 20 by -O- or -C(=O)-, and a hydrogen atom contained in the organic group for $L^1$ and $L^2$ may be substituted by an alkyl group with a carbon number of 1 to 5, an alkoxy group with a carbon number of 1 to 5, or a halogen atom,

one of $P^1$ and $P^2$ represents a hydrogen atom or a polymerizable group, and the other one of $P^1$ and $P^2$ represents a polymerizable group, and

a and b are each independently 0 or 1.

(Advantageous Effect)

It is therefore possible to provide a polymerizable composition that is capable of forming an optical film and an optically anisotropic product having excellent reverse wavelength dispersibility, can be prepared at relatively low temperature, and has excellent stability around room temperature.

It is also possible to provide a mixture useful in the preparation of the polymerizable composition.

It is also possible to provide an optical film and an optically anisotropic product having excellent reverse wavelength dispersibility, and a polarizing plate, a flat panel display device, an organic electroluminescent (EL) display device, and an antireflection film using the optically anisotropic product.

It is further possible to provide a method of using a polymerizable compound to suppress precipitation of a compound in a polymerizable composition.

DETAILED DESCRIPTION

The presently disclosed techniques will be described in detail below. In the present disclosure, "may have a substituent" denotes "being unsubstituted or having a substituent". In the case where an alkyl group, an alkenyl group, a cycloalkyl group, an aromatic hydrocarbon ring group, an aromatic heterocyclic group, an aromatic group, a cyclic aliphatic group, a hydrocarbon ring group, a heterocyclic group, an aromatic hydrocarbon ring, an aromatic heterocyclic ring, or an aromatic ring in a general formula has a substituent, the carbon number of the group or the ring having the substituent does not include the carbon number of the substituent. For example, in the case where an aromatic hydrocarbon ring group with a carbon number of 6 to 30 has a substituent, the carbon number of the aromatic hydrocarbon ring group with a carbon number of 6 to 30 does not include the carbon number of the substituent. In the present disclosure, the term "alkyl group" denotes a chain (linear or branched) saturated hydrocarbon group, and the term "alkyl group" does not include "cycloalkyl group" which is a cyclic saturated hydrocarbon group.

A presently disclosed mixture can be used, for example, in the preparation of a presently disclosed polymerizable composition, without being limited thereto.

The presently disclosed polymerizable composition can be used, for example, in the preparation of a presently disclosed polymer, without being limited thereto.

The presently disclosed polymer can be used, for example, as a constituent material of a presently disclosed optical film and a constituent material of a layer of the presently disclosed optically anisotropic product, without being limited thereto. The presently disclosed optically anisotropic product can be used, for example, in a presently disclosed polarizing plate, without being limited thereto. The presently disclosed polarizing plate can be used, for example, in a presently disclosed flat panel display device, organic electroluminescent display device, and antireflection film, without being limited thereto.

A presently disclosed method of using a polymerizable compound can be used to suppress precipitation of a compound in a polymerizable composition.

(1) Mixture

The presently disclosed mixture is a mixture containing a polymerizable compound represented by the following Formula (I) (hereafter also referred to as "polymerizable compound (I)") and a polymerizable compound represented by the following Formula (II) (hereafter also referred to as "polymerizable compound (II)"). The mixture and a polymerizable composition containing the mixture can be advantageously used in the preparation of the below-described polymer, optical film, and optically anisotropic product.

By using the mixture containing the polymerizable compounds (I) and (II), a polymerizable composition that has excellent stability at room temperature and can be prepared at relatively low temperature is obtained. The reason

for this is not clear, but is presumed to be as follows. The polymerizable compound (I) can easily and stably dissolve in a solvent in a polymerizable composition, presumably because of the presence of a substituent (-C(Q)=N-N(Ax)(Ay)) on $Ar^1$. By containing the polymerizable compound (I) in the polymerizable composition, some kind of interaction takes place between the polymerizable compound (I) and a compound such as the polymerizable compound (II), thus enhancing the solubility of the compound such as the polymerizable compound (II) in the solvent and the stability of the compound such as the polymerizable compound (II) in the solvent.

The polymerizable compound (I) can not only increase the solubility of the polymerizable compound (II), but also form a polymer with the polymerizable compound (II) through a polymerization reaction. By polymerizing a polymerizable composition containing the polymerizable compounds (I) and (II) and having excellent stability, an optical film, etc. having excellent reverse wavelength dispersibility can be produced efficiently.

(1-1) Polymerizable compound (I)

The polymerizable compound (I) is represented by the following Formula (I).

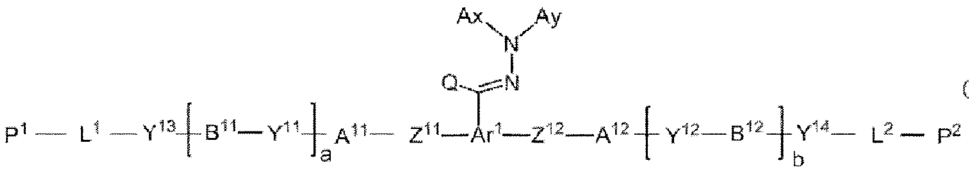

(I)

In Formula (I), a and b are each independently 0 or 1, and preferably 1.

In Formula (I), $Ar^1$ is an aromatic group that may have a substituent. The aromatic group for $Ar^1$ may be an aromatic hydrocarbon ring group or an aromatic heterocyclic group. In terms of achieving the desired effects of the present disclosure more favorably, an aromatic hydrocarbon ring group with a carbon number of 6 to 12 is preferable, a benzene ring group or a naphthalene ring group is more preferable, and a benzene ring group is further preferable.

Preferable structures as a benzene ring group or a naphthalene ring group are given below. In the following formulas, $Z^{11}$ and $Z^{12}$ are written for convenience's sake to clarify the bonding state (the definitions of $Z^{11}$ and $Z^{12}$ will be described later).

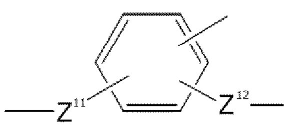

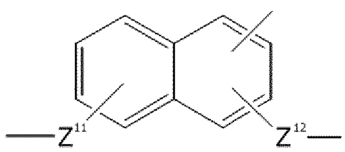

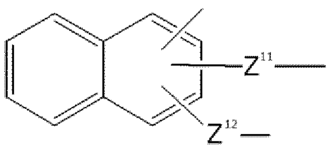

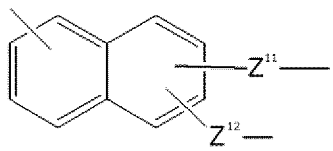

Of these, as $Ar^1$, groups represented by the following Formulas ($Ar^1$-11) to ($Ar^1$-25) are more preferable, groups represented by the following Formulas ($Ar^1$-11), ($Ar^1$-13), ($Ar^1$-15), ($Ar^1$-19), and ($Ar^1$-23) are further preferable, and groups represented by the following Formulas ($Ar^1$-11) and ($Ar^1$-23) are particularly preferable.

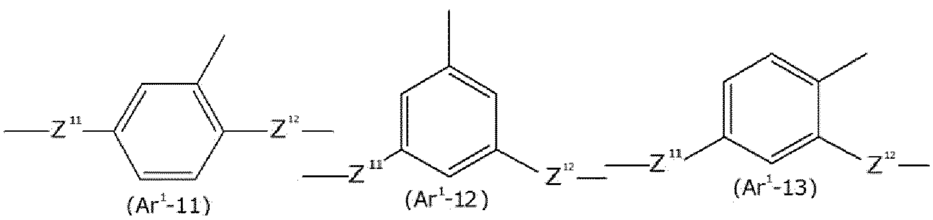

($Ar^1$-11) ($Ar^1$-12) ($Ar^1$-13)

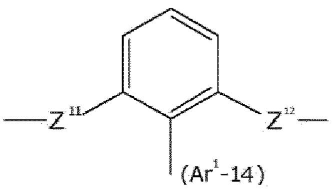
(Ar1-14)

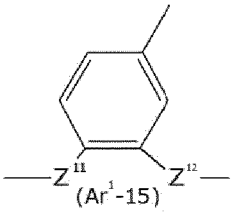
(Ar1-15)

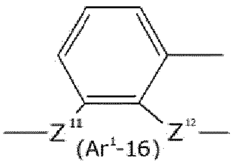
(Ar1-16)

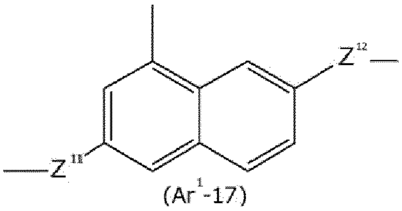
(Ar1-17)

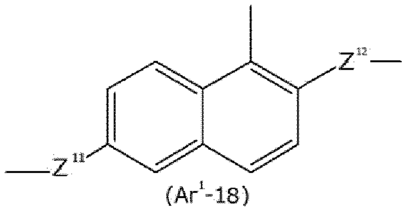
(Ar1-18)

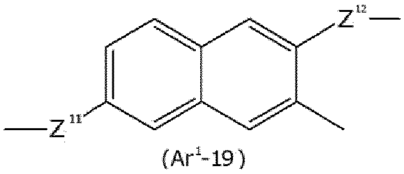
(Ar1-19)

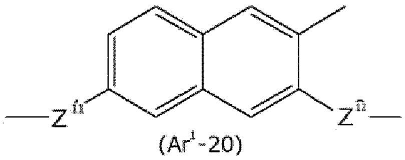
(Ar1-20)

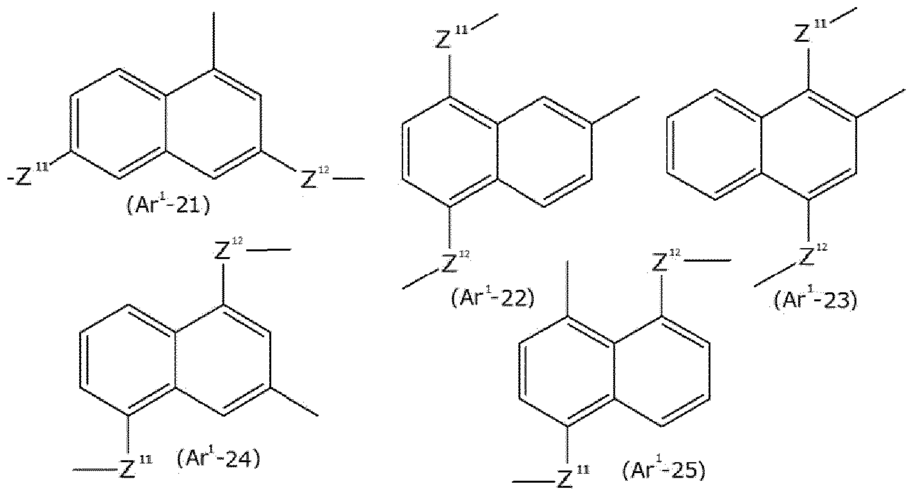
(Ar1-21) (Ar1-22) (Ar1-23) (Ar1-24) (Ar1-25)

Examples of the substituent which the aromatic group of $Ar^1$ and the rings in the foregoing specific examples of $Ar^1$ may have include: a halogen atom such as fluorine atom and chlorine atom; a cyano group; an alkyl group with a carbon number of 1 to 6 such as methyl group, ethyl group, and propyl group; an alkenyl group with a carbon number of 2 to 6 such as vinyl group and allyl group; an alkyl halide group with a carbon number of 1 to 6 such as trifluoromethyl group; an N,N-dialkylamino group with a carbon number of 1 to 12 such as dimethylamino group; an alkoxy group with a carbon number of 1 to 6 such as methoxy group, ethoxy group, and isopropoxy group; a nitro group; $-OCF_3$; $-C(=O)-R^1$; $-C(=O)-OR^1$; and $-SO_2R^1$. Here, $R^1$ represents: an alkyl group with a carbon number of 1 to 6 such as methyl group and ethyl group; or an aromatic hydrocarbon ring group with a carbon number of 6 to 20 such as phenyl group, 4-methylphenyl group, and 4-methoxyphenyl group. However, $Ar^1$ preferably does not have a substituent.

In the foregoing Formula (I), Ax represents an organic group having at least one aromatic ring selected from the group consisting of an aromatic hydrocarbon ring with a carbon number of 6 to 30 and an aromatic heterocyclic ring with a carbon number of 2 to 30. Ax is preferably an organic group having at least one aromatic ring selected from the group consisting of an aromatic hydrocarbon ring with a carbon number of 6 to 20 and an aromatic heterocyclic ring with a carbon number of 2 to 20.

In the present disclosure, "aromatic ring" denotes a cyclic structure having aromaticity in a broad sense according to Huckel's rule, i.e. a cyclic conjugated structure having (4n + 2) $\pi$ electrons, and a cyclic structure exhibiting aromaticity due to involvement of a lone electron pair of a heteroatom such as sulfur, oxygen, or nitrogen in $\pi$ electron system, such

as thiophene, furan, or benzothiazole.

The organic group having at least one aromatic ring selected from the group consisting of an aromatic hydrocarbon ring with a carbon number of 6 to 30 and an aromatic heterocyclic ring with a carbon number of 2 to 30 for Ax may have a plurality of aromatic rings, and may have both an aromatic hydrocarbon ring and an aromatic heterocyclic ring.

Examples of the aromatic hydrocarbon ring of Ax include benzene ring, naphthalene ring, anthracene ring, phenanthrene ring, pyrene ring, and fluorene ring.

Of these, the aromatic hydrocarbon ring is preferably benzene ring, naphthalene ring, or anthracene ring.

Examples of the aromatic heterocyclic ring of Ax include 1H-isoindole-1,3(2H)-dione ring, 1-benzofuran ring, 2-benzofuran ring, acridine ring, isoquinoline ring, imidazole ring, indole ring, oxadiazole ring, oxazole ring, oxazolopyrazine ring, oxazolopyridine ring, oxazolopyridazyl ring, oxazolopyrimidine ring, quinazoline ring, quinoxaline ring, quinoline ring, cinnoline ring, thiadiazole ring, thiazole ring, thiazolopyrazine ring, thiazolopyridine ring, thiazolopyridazine ring, thiazolopyrimidine ring, thiophene ring, triazine ring, triazole ring, naphthyridine ring, pyrazine ring, pyrazole ring, pyranone ring, pyran ring, pyridine ring, pyridazine ring, pyrimidine ring, pyrrole ring, phenanthridine ring, phthalazine ring, furan ring, benzo[c]thiophene ring, benzoisooxazole ring, benzoisothiazole ring, benzimidazole ring, benzooxadiazole ring, benzoxazole ring, benzothiadiazole ring, benzothiazole ring, benzothiophene ring, benzotriazine ring, benzotriazole ring, benzopyrazole ring, benzopyranone ring, dihydropyran ring, tetrahydropyran ring, dihydrofuran ring, and tetrahydrofuran ring.

Of these, the aromatic heterocyclic ring is preferably: a monocyclic aromatic heterocyclic ring such as furan ring, thiophene ring, oxazole ring, and thiazole ring; or a condensed cyclic aromatic heterocyclic ring such as benzothiazole ring, benzoxazole ring, quinoline ring, 1-benzofuran ring, 2-benzofuran ring, benzothiophene ring, thiazolopyridine ring, and thiazolopyrazine ring.

The aromatic ring of Ax may have a substituent. Examples of the substituent include: a halogen atom such as fluorine atom and chlorine atom; a cyano group; an alkyl group with a carbon number of 1 to 6 such as methyl group, ethyl group, and propyl group; an alkenyl group with a carbon number of 2 to 6 such as vinyl group and allyl group; an alkyl halide group with a carbon number of 1 to 6 such as trifluoromethyl group; an N,N-dialkylamino group with a carbon number of 1 to 12 such as dimethylamino group; an alkoxy group with a carbon number of 1 to 6 such as methoxy group, ethoxy group, and isopropoxy group; a nitro group; an aromatic hydrocarbon ring group with a carbon number of 6 to 20 such as phenyl group and naphthyl group; $-OCF_3$; $-C(=O)-R^2$; $-C(=O)-OR^2$; and $-SO_2R^3$. Here, $R^2$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent. $R^3$ represents: an alkyl group with a carbon number of 1 to 6 such as methyl group and ethyl group; or an aromatic hydrocarbon ring group with a carbon number of 6 to 20 that may have a substituent such as phenyl group, 4-methylphenyl group, and 4-methoxyphenyl group. Of these, the substituent of the aromatic ring of Ax is preferably a halogen atom, a cyano group, an alkyl group with a carbon number of 1 to 6, or an alkoxy group with a carbon number of 1 to 6.

Ax may have a plurality of substituents selected from the foregoing substituents. In the case where Ax has a plurality of substituents, the substituents may be the same or different.

Examples of the alkyl group with a carbon number of 1 to 20 of the alkyl group with a carbon number of 1 to 20 that may have a substituent for $R^2$ include methyl group, ethyl group, n-propyl group, isopropyl group, n-butyl group, isobutyl group, 1-methylpentyl group, 1-ethylpentyl group, sec-butyl group, t-butyl group, n-pentyl group, isopentyl group, neopentyl group, n-hexyl group, isohexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, n-nonadecyl group, and n-icosyl group. The carbon number of the alkyl group with a carbon number of 1 to 20 that may have a substituent is preferably 1 to 12, and further preferably 4 to 10.

Examples of the alkenyl group with a carbon number of 2 to 20 of the alkenyl group with a carbon number of 2 to 20 that may have a substituent for $R^2$ include vinyl group, propenyl group, isopropenyl group, butenyl group, isobutenyl group, pentenyl group, hexenyl group, heptenyl group, octenyl group, decenyl group, undecenyl group, dodecenyl group, tridecenyl group, tetradecenyl group, pentadecenyl group, hexadecenyl group, heptadecenyl group, octadecenyl group, nonadecenyl group, and icosenyl group. The carbon number of the alkenyl group with a carbon number of 2 to 20 that may have a substituent is preferably 2 to 12.

Examples of the substituent of the alkyl group with a carbon number of 1 to 20 and the alkenyl group with a carbon number of 2 to 20 for $R^2$ include: a halogen atom such as fluorine atom and chlorine atom; a cyano group; an N,N-dialkylamino group with a carbon number of 1 to 12 such as dimethylamino group; an alkoxy group with a carbon number of 1 to 20 such as methoxy group, ethoxy group, isopropoxy group, and butoxy group; an alkoxy group with a carbon number of 1 to 12 substituted by an alkoxy group with a carbon number of 1 to 12, such as methoxymethoxy group and methoxyethoxy group; a nitro group; an aromatic hydrocarbon ring group with a carbon number of 6 to 20 such as phenyl group and naphthyl group; an aromatic heterocyclic group with a carbon number of 2 to 20 such as triazolyl group, pyrrolyl group, furanyl group, and thiophenyl group; a cycloalkyl group with a carbon number of 3 to 8

such as cyclopropyl group, cyclopentyl group, and cyclohexyl group; a cycloalkyloxy group with a carbon number of 3 to 8 such as cyclopentyloxy group and cyclohexyloxy group; a cyclic ether group with a carbon number of 2 to 12 such as tetrahydrofuranyl group, tetrahydropyranyl group, dioxolanyl group, and dioxanyl group; an aryloxy group with a carbon number of 6 to 14 such as phenoxy group and naphthoxy group; a fluoroalkyl group with a carbon number of 1 to 12 at least one hydrogen atom of which is substituted by a fluorine atom, such as trifluoromethyl group, pentafluoroethyl group, and $-CH_2CF_3$; a benzofuryl group; a benzopyranyl group; a benzodioxolyl group; and a benzodioxanyl group. Of these, the substituent of the alkyl group with a carbon number of 1 to 20 and the alkenyl group with a carbon number of 2 to 20 for $R^2$ is preferably: a halogen atom such as fluorine atom and chlorine atom; a cyano group; an alkoxy group with a carbon number of 1 to 20 such as methoxy group, ethoxy group, isopropoxy group, and butoxy group; a nitro group; an aromatic hydrocarbon ring group with a carbon number of 6 to 20 such as phenyl group and naphthyl group; an aromatic heterocyclic group with a carbon number of 2 to 20 such as furanyl group and thiophenyl group; a cycloalkyl group with a carbon number of 3 to 8 such as cyclopropyl group, cyclopentyl group, and cyclohexyl group; and a fluoroalkyl group with a carbon number of 1 to 12 at least one hydrogen atom of which is substituted by a fluorine atom, such as trifluoromethyl group, pentafluoroethyl group, and $-CH_2CF_3$.

The alkyl group with a carbon number of 1 to 20 and the alkenyl group with a carbon number of 2 to 20 for $R^2$ may have a plurality of substituents selected from the foregoing substituents. In the case where the alkyl group with a carbon number of 1 to 20 and the alkenyl group with a carbon number of 2 to 20 for $R^2$ have a plurality of substituents, the plurality of substituents may be the same or different.

Examples of the cycloalkyl group with a carbon number of 3 to 12 of the cycloalkyl group with a carbon number of 3 to 12 that may have a substituent for $R^2$ include cyclopropyl group, cyclobutyl group, cyclopentyl group, cyclohexyl group, and cyclooctyl group. Of these, cyclopentyl group and cyclohexyl group are preferable.

Examples of the substituent of the cycloalkyl group with a carbon number of 3 to 12 for $R^2$ include: a halogen atom such as fluorine atom and chlorine atom; a cyano group; an N,N-dialkylamino group with a carbon number of 1 to 12 such as dimethylamino group; an alkyl group with a carbon number of 1 to 6 such as methyl group, ethyl group, and propyl group; an alkoxy group with a carbon number of 1 to 6 such as methoxy group, ethoxy group, and isopropoxy group; a nitro group; and an aromatic hydrocarbon ring group with a carbon number of 6 to 20 such as phenyl group and naphthyl group. Of these, the substituent of the cycloalkyl group with a carbon number of 3 to 12 for $R^2$ is preferably: a halogen atom such as fluorine atom and chlorine atom; a cyano group; an alkyl group with a carbon number of 1 to 6 such as methyl group, ethyl group, and propyl group; an alkoxy group with a carbon number of 1 to 6 such as methoxy group, ethoxy group, and isopropoxy group; a nitro group; and an aromatic hydrocarbon ring group with a carbon number of 6 to 20 such as phenyl group and naphthyl group.

The cycloalkyl group with a carbon number of 3 to 12 for $R^2$ may have a plurality of substituents. In the case where the cycloalkyl group with a carbon number of 3 to 12 for $R^2$ has a plurality of substituents, the plurality of substituents may be the same or different.

Examples of the aromatic hydrocarbon ring group with a carbon number of 5 to 12 of the aromatic hydrocarbon ring group with a carbon number of 5 to 12 that may have a substituent for $R^2$ include phenyl group, 1-naphthyl group, and 2-naphthyl group. Of these, phenyl group is preferable.

Examples of the substituent of the aromatic hydrocarbon ring group with a carbon number of 5 to 12 that may have a substituent include: a halogen atom such as fluorine atom and chlorine atom; a cyano group; an N,N-dialkylamino group with a carbon number of 1 to 12 such as dimethylamino group; an alkoxy group with a carbon number of 1 to 20 such as methoxy group, ethoxy group, isopropoxy group, and butoxy group; an alkoxy group with a carbon number of 1 to 12 substituted by an alkoxy group with a carbon number of 1 to 12, such as methoxymethoxy group and methoxyethoxy group; a nitro group; an aromatic hydrocarbon ring group with a carbon number of 6 to 20 such as phenyl group and naphthyl group; an aromatic heterocyclic group with a carbon number of 2 to 20 such as triazolyl group, pyrrolyl group, furanyl group, and thiophenyl group; a cycloalkyl group with a carbon number of 3 to 8 such as cyclopropyl group, cyclopentyl group, and cyclohexyl group; a cycloalkyloxy group with a carbon number of 3 to 8 such as cyclopentyloxy group and cyclohexyloxy group; a cyclic ether group with a carbon number of 2 to 12 such as tetrahydrofuranyl group, tetrahydropyranyl group, dioxolanyl group, and dioxanyl group; an aryloxy group with a carbon number of 6 to 14 such as phenoxy group and naphthoxy group; a fluoroalkyl group with a carbon number of 1 to 12 at least one hydrogen atom of which is substituted by a fluorine atom, such as trifluoromethyl group, pentafluoroethyl group, and $-CH_2CF_3$; $-OCF_3$; a benzofuryl group; a benzopyranyl group; a benzodioxolyl group; and a benzodioxanyl group. Of these, the substituent of the aromatic hydrocarbon ring group with a carbon number of 5 to 12 is preferably at least one substituent selected from: a halogen atom such as fluorine atom and chlorine atom; a cyano group; an alkoxy group with a carbon number of 1 to 20 such as methoxy group, ethoxy group, isopropoxy group, and butoxy group; a nitro group; an aromatic hydrocarbon ring group with a carbon number of 6 to 20 such as phenyl group and naphthyl group; an aromatic heterocyclic group with a carbon number of 2 to 20 such as furanyl group and thiophenyl group; a cycloalkyl group with a carbon number of 3 to 8 such as cyclopropyl group, cyclopentyl group, and cyclohexyl group; and a fluoroalkyl group with a carbon number of 1 to 12 at least one hydrogen atom of which is substituted by a fluorine atom, such as trifluoromethyl

group, pentafluoroethyl group, and $-CH_2CF_3$.

The aromatic hydrocarbon ring group with a carbon number of 5 to 12 may have a plurality of substituents. In the case where the aromatic hydrocarbon ring group with a carbon number of 5 to 12 has a plurality of substituents, the substituents may be the same or different.

The aromatic ring of Ax may have a plurality of substituents that may be the same or different, and two adjacent substituents may be joined together to form a ring which may be a monocyclic, condensed polycyclic, unsaturated, or saturated ring.

Examples of the organic group having at least one aromatic ring selected from the group consisting of an aromatic hydrocarbon ring with a carbon number of 6 to 30 and an aromatic heterocyclic ring with a carbon number of 2 to 30 for Ax include the following 1) to 5):

1) hydrocarbon ring group with a carbon number of 6 to 40 having at least one aromatic hydrocarbon ring with a carbon number of 6 to 30;
2) heterocyclic group with a carbon number of 2 to 40 having at least one aromatic ring selected from the group consisting of an aromatic hydrocarbon ring with a carbon number of 6 to 30 and an aromatic heterocyclic ring with a carbon number of 2 to 30;
3) alkyl group with a carbon number of 1 to 12 substituted by at least one of an aromatic hydrocarbon ring group with a carbon number of 6 to 30 and an aromatic heterocyclic group with a carbon number of 2 to 30;
4) alkenyl group with a carbon number of 2 to 12 substituted by at least one of an aromatic hydrocarbon ring group with a carbon number of 6 to 30 and an aromatic heterocyclic group with a carbon number of 2 to 30; and
5) alkynyl group with a carbon number of 2 to 12 substituted by at least one of an aromatic hydrocarbon ring group with a carbon number of 6 to 30 and an aromatic heterocyclic group with a carbon number of 2 to 30.

Specific examples of the aromatic hydrocarbon ring in 1) "hydrocarbon ring group with a carbon number of 6 to 40 having at least one aromatic hydrocarbon ring with a carbon number of 6 to 30" are the same as those listed as specific examples of the aromatic hydrocarbon ring of Ax. Examples of the hydrocarbon ring group in 1) include aromatic hydrocarbon ring group with a carbon number of 6 to 30 (e.g. phenyl group, naphthyl group, anthracenyl group, phenanthrenyl group, pyrenyl group, and fluorenyl group), indanyl group, 1,2,3,4-tetrahydronaphthyl group, and 1,4-dihydronaphthyl group.

Specific examples of the aromatic hydrocarbon ring and the aromatic heterocyclic ring in 2) "heterocyclic group with a carbon number of 2 to 40 having at least one aromatic ring selected from the group consisting of an aromatic hydrocarbon ring with a carbon number of 6 to 30 and an aromatic heterocyclic ring with a carbon number of 2 to 30" are the same as those listed as specific examples of the aromatic hydrocarbon ring and the aromatic heterocyclic ring of Ax. Examples of the heterocyclic group in 2) include aromatic heterocyclic group with a carbon number of 2 to 30 (e.g. phthalimide group, 1-benzofuranyl group, 2-benzofuranyl group, acrydinyl group, isoquinolinyl group, imidazolyl group, indolinyl group, furazanyl group, oxazolyl group, oxazolopyrazinyl group, oxazolopyridinyl group, oxazolopyridazinyl group, oxazolopyrimidinyl group, quinazolinyl group, quinoxalinyl group, quinolyl group, cinnolinyl group, thiadiazolyl group, thiazolyl group, thiazolopyrazinyl group, thiazolopyridinyl group, thiazolopyridazinyl group, thiazolopyrimidinyl group, thienyl group, triazinyl group, triazolyl group, naphthyridinyl group, pyrazinyl group, pyrazolyl group, pyranonyl group, pyranyl group, pyridyl group, pyridazinyl group, pyrimidinyl group, pyrrolyl group, phenanthridinyl group, phthalazinyl group, furanyl group, benzo[c]thienyl group, benzoisoxazolyl group, benzoisothiazolyl group, benzoimidazolyl group, benzoxazolyl group, benzothiadiazolyl group, benzothiazolyl group, benzothiophenyl group, benzotriadinyl group, benzotriazolyl group, benzopyrazolyl group, benzopyranonyl group, dihydropyranyl group, tetrahydropyranyl group, dihydrofuranyl group, and tetrahydrofuranyl group), 2,3-dihydroindolyl group, 9,10-dihydroacridinyl group, and 1,2,3,4-tetrahydroquinolyl group.

Specific examples of the alkyl group with a carbon number of 1 to 12 in 3) "alkyl group with a carbon number of 1 to 12 substituted by at least one of an aromatic hydrocarbon ring group with a carbon number of 6 to 30 and an aromatic heterocyclic group with a carbon number of 2 to 30" include methyl group, ethyl group, propyl group, and isopropyl group. Specific examples of the aromatic hydrocarbon ring group with a carbon number of 6 to 30 and the aromatic heterocyclic group with a carbon number of 2 to 30 in 3) are the same as those listed as specific examples of the aromatic hydrocarbon ring group with a carbon number of 6 to 30 and the aromatic heterocyclic group with a carbon number of 2 to 30 in 1) and 2).

Specific examples of the alkenyl group with a carbon number of 2 to 12 in 4) "alkenyl group with a carbon number of 2 to 12 substituted by at least one of an aromatic hydrocarbon ring group with a carbon number of 6 to 30 and an aromatic heterocyclic group with a carbon number of 2 to 30" include vinyl group and allyl group. Specific examples of the aromatic hydrocarbon ring group with a carbon number of 6 to 30 and the aromatic heterocyclic group with a carbon number of 2 to 30 in 4) are the same as those listed as specific examples of the aromatic hydrocarbon ring group with a carbon number of 6 to 30 and the aromatic heterocyclic group with a carbon number of 2 to 30 in 1) and 2).

Specific examples of the alkynyl group with a carbon number of 2 to 12 in 5) "alkynyl group with a carbon number of 2 to 12 substituted by at least one of an aromatic hydrocarbon ring group with a carbon number of 6 to 30 and an aromatic heterocyclic group with a carbon number of 2 to 30" include ethynyl group and propynyl group. Specific examples of the aromatic hydrocarbon ring group with a carbon number of 6 to 30 and the aromatic heterocyclic group with a carbon number of 2 to 30 in 5) are the same as those listed as specific examples of the aromatic hydrocarbon ring group with a carbon number of 6 to 30 and the aromatic heterocyclic group with a carbon number of 2 to 30 in 1) and 2).

Each of the organic groups listed in 1) to 5) may have one or more substituents. In the case where the organic group has a plurality of substituents, the plurality of substituents may be the same or different.

Examples of the substituent(s) include: a halogen atom such as fluorine atom and chlorine atom; a cyano group; an alkyl group with a carbon number of 1 to 6 such as methyl group, ethyl group, and propyl group; an alkenyl group with a carbon number of 2 to 6 such as vinyl group and allyl group; an alkyl halide group with a carbon number of 1 to 6 such as trifluoromethyl group; an N,N-dialkylamino group with a carbon number of 1 to 12 such as dimethylamino group; an alkoxy group with a carbon number of 1 to 6 such as methoxy group, ethoxy group, and isopropoxy group; a nitro group; an aromatic hydrocarbon ring group with a carbon number of 6 to 20 such as phenyl group and naphthyl group; $-OCF_3$; $-C(=O)-R^2$; $-C(=O)-OR^2$; and $-SO_2R^3$. Here, $R^2$ and $R^3$ are as defined above.

Of these, the substituent of each of the organic groups listed in 1) to 5) is preferably at least one substituent selected from a halogen atom, a cyano group, an alkyl group with a carbon number of 1 to 6, and an alkoxy group with a carbon number of 1 to 6.

Preferable specific examples of the organic group having at least one aromatic ring selected from the group consisting of an aromatic hydrocarbon ring with a carbon number of 6 to 30 and an aromatic heterocyclic ring with a carbon number of 2 to 30 for Ax are given below. The present disclosure is, however, not limited to such. In the following formulas, "-" represents atomic bonding with an N atom (i.e. N atom that bonds with Ax in Formula (I)) extending from any position in the ring.

1) Hydrocarbon ring group with a carbon number of 6 to 40 having at least one aromatic hydrocarbon ring with a carbon number of 6 to 30

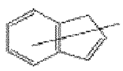 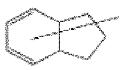 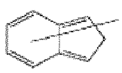 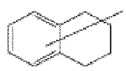 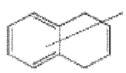 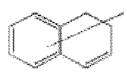

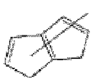 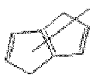 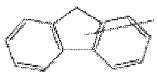 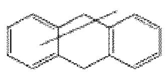 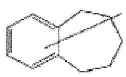 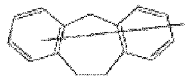

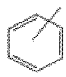 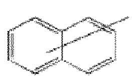 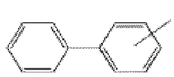 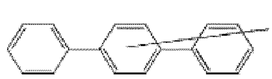 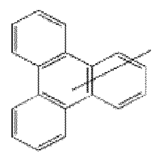

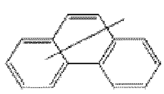 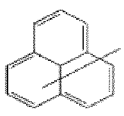 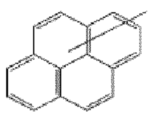 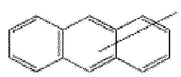

Particularly, examples of the aromatic hydrocarbon ring group with a carbon number of 6 to 30 include the following.

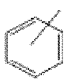 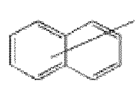 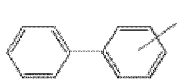 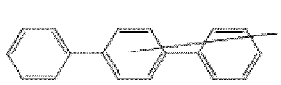 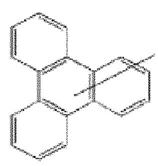

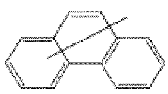 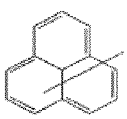 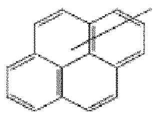 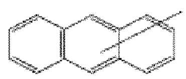

2) Heterocyclic group with a carbon number of 2 to 40 having at least one aromatic ring selected from the group consisting of an aromatic hydrocarbon ring with a carbon number of 6 to 30 and an aromatic heterocyclic ring with a carbon number of 2 to 30

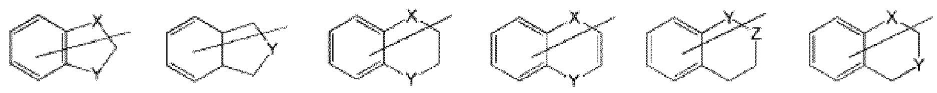

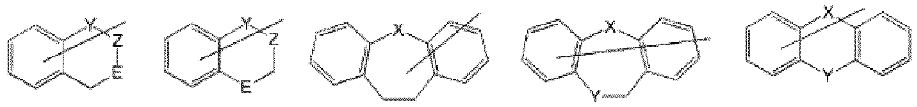

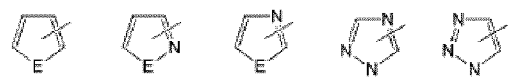

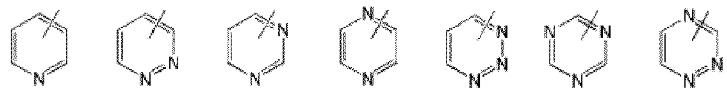

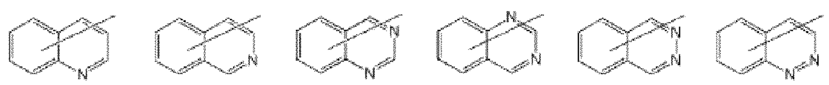

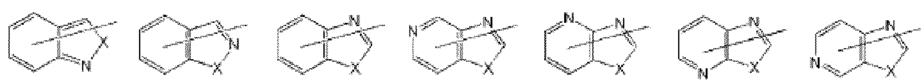

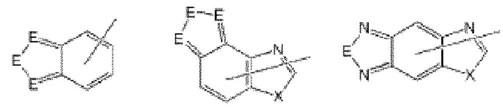

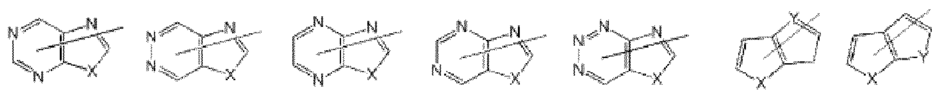

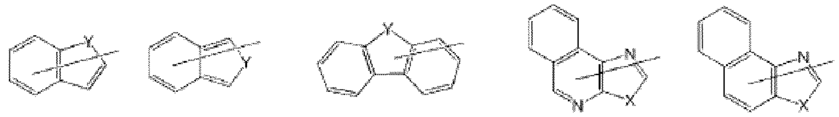

[where X represents a carbon atom, $-NR^z-$, an oxygen atom, a sulfur atom, -SO-, or $-SO_2-$, Y and Z each independently represent $-NR^z-$, an oxygen atom, a sulfur atom, -SO-, or $-SO_2-$, and E represents $-NR^z-$, an oxygen atom, or a sulfur atom. Here, $R^z$ represents a hydrogen atom, or an alkyl group with a carbon number of 1 to 6 such as methyl group, ethyl group, and propyl group (in each formula, oxygen atom, sulfur atom, -SO-, and $-SO_2-$ are not adjacent to each other).]

Particularly, examples of the aromatic heterocyclic group with a carbon number of 2 to 30 include the following.

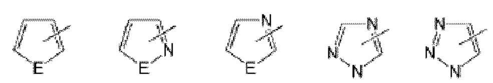

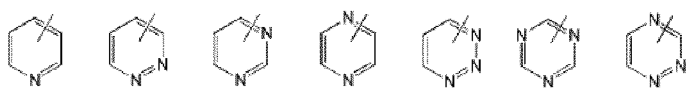

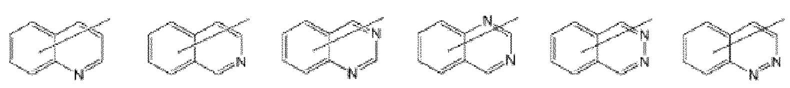

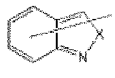 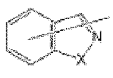 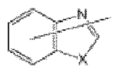 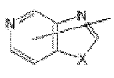 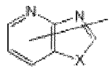 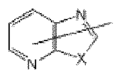 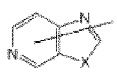

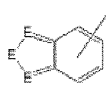 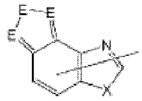 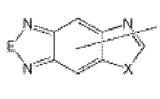

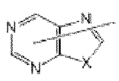 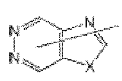 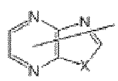 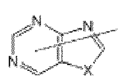 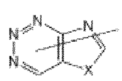 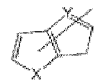 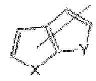

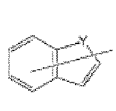 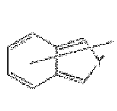 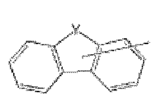 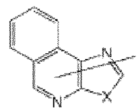 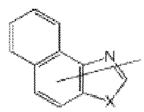

[where E, X, and Y are as defined above.]

3) Alkyl group with a carbon number of 1 to 12 substituted by at least one of an aromatic hydrocarbon ring group with a carbon number of 6 to 30 and an aromatic heterocyclic group with a carbon number of 2 to 30

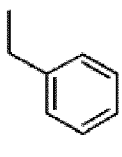 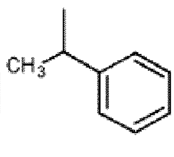 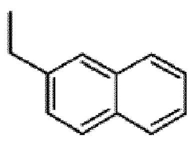 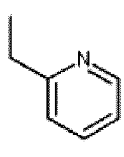 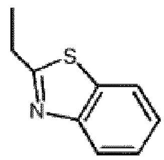

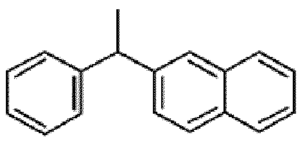 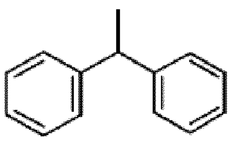 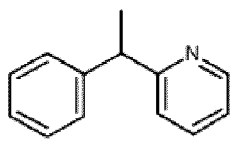

4) Alkenyl group with a carbon number of 2 to 12 substituted by at least one of an aromatic hydrocarbon ring group with a carbon number of 6 to 30 and an aromatic heterocyclic group with a carbon number of 2 to 30

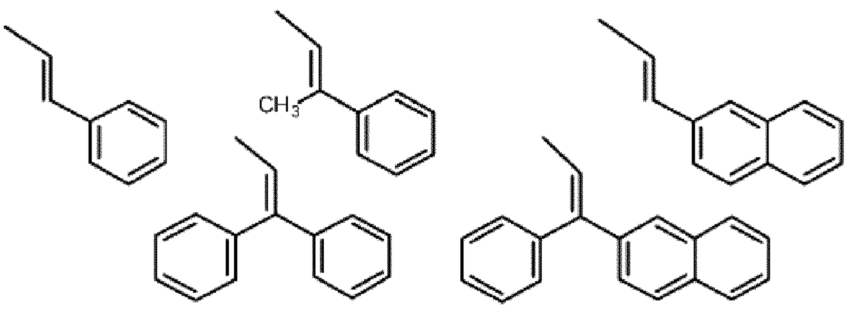

5) Alkynyl group with a carbon number of 2 to 12 substituted by at least one selected from the group consisting of an aromatic hydrocarbon ring and an aromatic heterocyclic ring

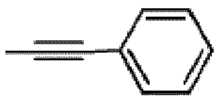 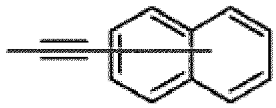

The ring of each preferable specific example of Ax described above may have one or more substituents. In the

case where the ring has a plurality of substituents, the plurality of substituents may be the same or different. Examples of the substituent(s) include: a halogen atom such as fluorine atom and chlorine atom; a cyano group; an alkyl group with a carbon number of 1 to 6 such as methyl group, ethyl group, and propyl group; an alkenyl group with a carbon number of 2 to 6 such as vinyl group and allyl group; an alkyl halide group with a carbon number of 1 to 6 such as trifluoromethyl group; an N,N-dialkylamino group with a carbon number of 1 to 12 such as dimethylamino group; an alkoxy group with a carbon number of 1 to 6 such as methoxy group, ethoxy group, and isopropoxy group; a nitro group; an aromatic hydrocarbon ring group with a carbon number of 6 to 20 such as phenyl group and naphthyl group; $-OCF_3$; $-C(=O)-R^2$; $-C(=O)-OR^2$; and $-SO_2R^3$.

Here, $R^2$ and $R^3$ are as defined above. Of these, the substituent of the foregoing ring of Ax is preferably a halogen atom, a cyano group, an alkyl group with a carbon number of 1 to 6, or an alkoxy group with a carbon number of 1 to 6.

Of these, Ax is preferably an aromatic hydrocarbon ring group with a carbon number of 6 to 30, an aromatic heterocyclic group with a carbon number of 2 to 30, or the following group.

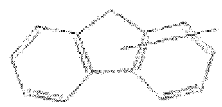

Ax is more preferably an aromatic hydrocarbon ring group with a carbon number of 6 to 20 or an aromatic heterocyclic group with a carbon number of 4 to 20, and further preferably any of the following groups. Ax is, however, not limited to such.

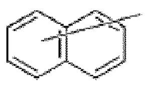
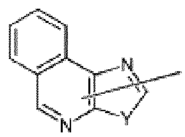
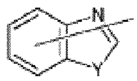
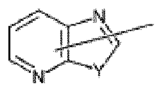
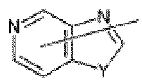
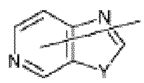
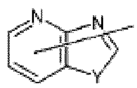
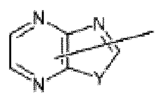
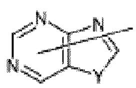
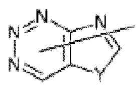
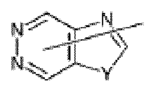
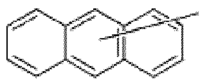

[where Y is as defined above.]

Each of the foregoing rings may have one or more substituents, as mentioned above. In the case where the ring has a plurality of substituents, the plurality of substituents may be the same or different. Examples of the substituent(s) include: a halogen atom such as fluorine atom and chlorine atom; a cyano group; an alkyl group with a carbon number of 1 to 6 such as methyl group, ethyl group, and propyl group; an alkenyl group with a carbon number of 2 to 6 such as vinyl group and allyl group; an alkyl halide group with a carbon number of 1 to 6 such as trifluoromethyl group and pentafluoroethyl group; an N,N-dialkylamino group with a carbon number of 1 to 12 such as dimethylamino group; an alkoxy group with a carbon number of 1 to 6 such as methoxy group, ethoxy group, and isopropoxy group; a nitro group; an aromatic hydrocarbon ring group with a carbon number of 6 to 20 such as phenyl group and naphthyl group; $-C(=O)-R^2$; $-C(=O)-OR^2$; and $-SO_2R^3$.

Here, $R^2$ and $R^3$ are as defined above.

Of these, the substituent of the foregoing ring is preferably a halogen atom, a cyano group, an alkyl group with a carbon number of 1 to 6, or an alkoxy group with a carbon number of 1 to 6.

As Ax, a group represented by the following Formula (IV) is particularly preferable.

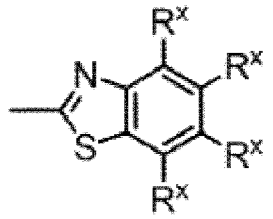

(IV)

In the foregoing Formula (IV), $R^X$ represents: a hydrogen atom; a halogen atom such as fluorine atom, chlorine atom, and bromine atom; an alkyl group with a carbon number of 1 to 6 such as methyl group, ethyl group, and propyl group; a cyano group; a nitro group; a fluoroalkyl group with a carbon number of 1 to 6 such as trifluoromethyl group and pentafluoroethyl group; an alkoxy group with a carbon number of 1 to 6 such as methoxy group, ethoxy group, and isopropoxy group; $-OCF_3$; or $-C(=O)-O-R^2$. $R^2$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, as mentioned above.

The plurality of $R^X$ may all be the same or different, and any C-$R^X$ forming the ring may be substituted by a nitrogen atom.

Specific examples of the group obtained by substituting C-$R^X$ of the group represented by the foregoing Formula (IV) by a nitrogen atom are given below. The group obtained by substituting C-$R^X$ by a nitrogen atom is, however, not limited to such.

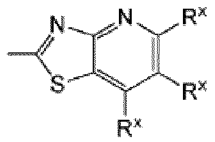 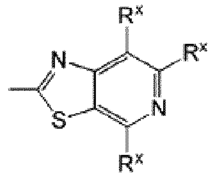 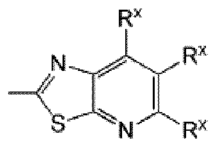 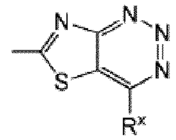

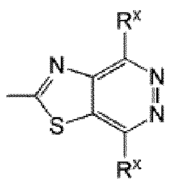 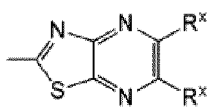 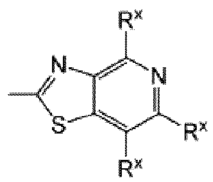 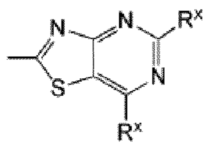

[where $R^X$ is as defined above.]

Of these, Ax is preferably such that all $R^X$ of the group represented by the foregoing Formula (IV) are hydrogen atoms.

Ay in the foregoing Formula (I) is a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, $-C(=O)-R^{11}$, $-SO_2-R^{12}$, $-CS-NH-R^{13}$, an aromatic hydrocarbon ring group with a carbon number of 6 to 30 that may have a substituent, or an aromatic heterocyclic group with a carbon number of 2 to 30 that may have a substituent.

Here, $R^{11}$ is an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent. $R^{12}$ is an alkyl group with a carbon number of 1 to 6, or an aromatic hydrocarbon ring group with a carbon number of 6 to 20 that may have a substituent. $R^{13}$ is an alkyl group with a carbon number of 1 to 20 that may have a substituent, an alkenyl group with a carbon number of 2 to 20 that may have a substituent, a cycloalkyl group with a carbon number of 3 to 12 that may have a substituent, an aromatic hydrocarbon ring group with a carbon number of 5 to 20 that may have a substituent, or an aromatic heterocyclic group with a carbon number of 5 to 20 that may have a substituent.

Examples of the alkyl group with a carbon number of 1 to 20 and its substituent of the alkyl group with a carbon number of 1 to 20 that may have a substituent, the alkenyl group with a carbon number of 2 to 20 and its substituent of the alkenyl group with a carbon number of 2 to 20 that may have a substituent, the cycloalkyl group with a carbon number of 3 to 12 and its substituent of the cycloalkyl group with a carbon number of 3 to 12 that may have a substituent, and

the aromatic hydrocarbon ring group with a carbon number of 5 to 12 and its substituent of the aromatic hydrocarbon ring group with a carbon number of 5 to 12 that may have a substituent for $R^{11}$ are the same as those listed above as specific examples of the alkyl group with a carbon number of 1 to 20 and its substituent, the alkenyl group with a carbon number of 2 to 20 and its substituent, the cycloalkyl group with a carbon number of 3 to 12 and its substituent, and the aromatic hydrocarbon ring group with a carbon number of 5 to 12 and its substituent for $R^2$.

Examples of the alkyl group with a carbon number of 1 to 6 for $R^{12}$ include methyl group, ethyl group, n-propyl group, and isopropyl group. Specific examples of the aromatic hydrocarbon ring group with a carbon number of 6 to 20 of the aromatic hydrocarbon ring group with a carbon number of 6 to 20 that may have a substituent for $R^{12}$ include phenyl group, 4-methylphenyl group, and 4-methoxyphenyl group.

Examples of the alkyl group with a carbon number of 1 to 20 and its substituent of the alkyl group with a carbon number of 1 to 20 that may have a substituent, the alkenyl group with a carbon number of 2 to 20 and its substituent of the alkenyl group with a carbon number of 2 to 20 that may have a substituent, and the cycloalkyl group with a carbon number of 3 to 12 and its substituent of the cycloalkyl group with a carbon number of 3 to 12 that may have a substituent for $R^{13}$ are the same as those listed above as specific examples of the alkyl group with a carbon number of 1 to 20 and its substituent, the alkenyl group with a carbon number of 2 to 20 and its substituent, and the cycloalkyl group with a carbon number of 3 to 12 and its substituent for $R^2$. Examples of the aromatic hydrocarbon ring group with a carbon number of 5 to 20 that may have a substituent for $R^{13}$ include phenyl group, 1-naphthyl group, and 2-naphthyl group. Examples of the aromatic heterocyclic group with a carbon number of 5 to 20 that may have a substituent include pyridinyl group and quinolyl group.

Examples of the alkyl group with a carbon number of 1 to 20 and its substituent of the alkyl group with a carbon number of 1 to 20 that may have a substituent, the alkenyl group with a carbon number of 2 to 20 and its substituent of the alkenyl group with a carbon number of 2 to 20 that may have a substituent, and the cycloalkyl group with a carbon number of 3 to 12 and its substituent of the cycloalkyl group with a carbon number of 3 to 12 that may have a substituent for Ay are the same as those listed above as specific examples of the alkyl group with a carbon number of 1 to 20 and its substituent, the alkenyl group with a carbon number of 2 to 20 and its substituent, and the cycloalkyl group with a carbon number of 3 to 12 and its substituent for $R^2$. Examples of the alkyl group with a carbon number of 1 to 20 that may have a substituent, the alkenyl group with a carbon number of 2 to 20 that may have a substituent, and the cycloalkyl group with a carbon number of 3 to 12 that may have a substituent for Ay may have a plurality of substituents described above. In the case where the group has a plurality of substituents, the plurality of substituents may be the same or different.

Examples of the alkynyl group with a carbon number of 2 to 20 of the alkynyl group with a carbon number of 2 to 20 that may have a substituent for Ay include ethynyl group, propynyl group, 2-propynyl group (propargyl group), butynyl group, 2-butynyl group, 3-butynyl group, pentynyl group, 2-pentynyl group, hexynyl group, 5-hexynyl group, heptynyl group, octynyl group, 2-octynyl group, nonanyl group, decanyl group, and 7-decanyl group.

Examples of the substituent of the alkynyl group with a carbon number of 2 to 20 that may have a substituent include: a halogen atom such as fluorine atom and chlorine atom; a cyano group; an N,N-dialkylamino group with a carbon number of 1 to 12 such as dimethylamino group; an alkoxy group with a carbon number of 1 to 20 such as methoxy group, ethoxy group, isopropoxy group, and butoxy group; an alkoxy group with a carbon number of 1 to 12 substituted by an alkoxy group with a carbon number of 1 to 12, such as methoxymethoxy group and methoxyethoxy group; a nitro group; an aromatic hydrocarbon ring group with a carbon number of 6 to 20 such as phenyl group and naphthyl group; an aromatic heterocyclic group with a carbon number of 2 to 20 such as triazolyl group, pyrrolyl group, furanyl group, and thiophenyl group; a cycloalkyl group with a carbon number of 3 to 8 such as cyclopropyl group, cyclopentyl group, and cyclohexyl group; a cycloalkyloxy group with a carbon number of 3 to 8 such as cyclopentyloxy group and cyclohexyloxy group; a cyclic ether group with a carbon number of 2 to 12 such as tetrahydrofuranyl group, tetrahydropyranyl group, dioxolanyl group, and dioxanyl group; an aryloxy group with a carbon number of 6 to 14 such as phenoxy group and naphthoxy group; a fluoroalkyl group with a carbon number of 1 to 12 at least one hydrogen atom of which is substituted by a fluorine atom, such as trifluoromethyl group, pentafluoroethyl group, and $-CH_2CF_3$; a benzofuryl group; a benzopyranyl group; a benzodioxolyl group; a benzodioxanyl group; $-C(=O)-R^2$; $-C(=O)-OR^2$; $-SO_2R^3$; $-SR^2$; an alkoxy group with a carbon number of 1 to 12 substituted by $-SR^2$; and a hydroxy group. Here, $R^2$ and $R^3$ are as defined above.

The alkynyl group with a carbon number of 2 to 20 for Ay may have a plurality of substituents described above. In the case where the group has a plurality of substituents, the plurality of substituents may be the same or different.

Examples of the aromatic hydrocarbon ring group with a carbon number of 6 to 30 and the aromatic heterocyclic group with a carbon number of 2 to 30 and their substituents for Ay are the same as those listed above as the aromatic hydrocarbon ring group with a carbon number of 6 to 30 and the aromatic heterocyclic group with a carbon number of 2 to 30 and their substituents for Ax. The carbon number of the aromatic hydrocarbon ring group for Ay is preferably 6 to 20, more preferably 6 to 18, and further preferably 6 to 12. The carbon number of the aromatic heterocyclic group for Ay is preferably 2 to 20, and more preferably 2 to 18. The aromatic hydrocarbon ring group with a carbon number of 6 to 30 and the aromatic heterocyclic group with a carbon number of 2 to 30 for Ay may each have a plurality of substituents

described above. In the case where the group has a plurality of substituents, the plurality of substituents may be the same or different.

Of these, Ay is preferably a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, an aromatic hydrocarbon ring group with a carbon number of 6 to 18 that may have a substituent, or an aromatic heterocyclic group with a carbon number of 2 to 18 that may have a substituent, and more preferably a hydrogen atom, an alkyl group with a carbon number of 1 to 18 that may have a substituent, an alkenyl group with a carbon number of 2 to 18 that may have a substituent, an alkynyl group with a carbon number of 2 to 18 that may have a substituent, a cycloalkyl group with a carbon number of 5 to 10 that may have a substituent, or an aromatic hydrocarbon ring group with a carbon number of 6 to 12.

In the foregoing Formula (I), Q represents a hydrogen atom or an alkyl group with a carbon number of 1 to 6. Examples of the alkyl group with a carbon number of 1 to 6 for Q include methyl group, ethyl group, n-propyl group, and isopropyl.

In the foregoing Formula (I), $Z^{11}$ and $Z^{12}$ each independently represent a single bond, -O-$CH_2$-, -$CH_2$-O-, -C(=O)-O-, -O-C(=O)-, -C(=O)-S-, -S-C(=O)-, -$NR^{21}$-C(=O)-, -C(=O)-$NR^{21}$-, -$CF_2$-O-, -O-$CF_2$-, -$CH_2$-$CH_2$-, -$CF_2$-$CF_2$-, -O-$CH_2$-$CH_2$-O-, -CH=CH-C(=O)-O-, -O-C(=O)-CH=CH-, -$CH_2$-$CH_2$-C(=O)-O-, -O-C(=O)-$CH_2$-$CH_2$-, -$CH_2$-$CH_2$-O-C(=O)-, -C(=O)-O-$CH_2$-$CH_2$-, -$CH_2$-C(=O)-O-, -O-C(=O)-$CH_2$-, -$CH_2$-O-C(=O)-, -C(=O)-O-$CH_2$-, -CH=CH-, -N=CH-, -CH=N-, -N=C($CH_3$)-, -C($CH_3$)=N-, -N=N-, or -C=C-. $R^{21}$ represents a hydrogen atom or an alkyl group with a carbon number of 1 to 6. Of these, $Z^{11}$ is preferably -C(=O)-O-, and $Z^{12}$ is preferably -O-C(=O)-.

In the foregoing Formula (I), $A^{11}$ and $A^{12}$ each independently represent a cyclic aliphatic group that may have a substituent or an aromatic group that may have a substituent. Of these, $A^{11}$ and $A^{12}$ are each preferably a cyclic aliphatic group that may have a substituent.

The cyclic aliphatic group that may have a substituent is preferably a cyclic aliphatic group with a carbon number of 5 to 20 that may have a substituent.

Specific examples of the cyclic aliphatic group for $A^{11}$ and $A^{12}$ include: a cycloalkanediyl group with a carbon number of 5 to 20 such as cyclopentane-1,3-diyl, cyclohexane-1,4-diyl, 1,4-cycloheptane-1,4-diyl, and cycloctane-1,5-diyl; and a bicycloalkanediyl group with a carbon number of 5 to 20 such as decahydronaphthalene-1,5-diyl and decahydronaphthalene-2,6-diyl. Of these, trans structure is preferable.

The aromatic group that may have a substituent is preferably an aromatic group with a carbon number of 2 to 20 that may have a substituent.

Specific examples of the aromatic group for $A^{11}$ and $A^{12}$ include: an aromatic hydrocarbon ring group with a carbon number of 6 to 20 such as 1,4-phenylene group, 1,4-naphthylene group, 1,5-naphthylene group, 2,6-naphthylene group, and 4,4'-biphenylene group; and an aromatic heterocyclic group with a carbon number of 2 to 20 such as furan-2,5-diyl, thiophene-2,5-diyl, pyridine-2,5-diyl, and pyrazine-2,5-diyl.

Examples of the substituent of the cyclic aliphatic group and the aromatic group for $A^{11}$ and $A^{12}$ include: a halogen atom such as fluorine atom, chlorine atom, and bromine atom; an alkyl group with a carbon number of 1 to 6 such as methyl group and ethyl group; an alkoxy group with a carbon number of 1 to 5 such as methoxy group and isopropoxy group; a nitro group; and a cyano group. The cyclic aliphatic group and the aromatic group may each have at least one substituent selected from the foregoing substituents. In the case where the group has a plurality of substituents, the substituents may be the same or different.

In the foregoing Formula (I), in the case where a and/or b is 1, $Y^{11}$ and $Y^{12}$ are each independently a single bond, -O-, -C(=O)-, -C(=O)-O-, -O-C(=O)-, -$NR^{31}$-C(=O)-, -C(=O)-$NR^{31}$-, -O-C(=O)-O-, -$NR^{31}$-C(=O)-O-, -O-C(=O)-$NR^{31}$-, or -$NR^{31}$-C(=O)-$NR^{32}$-. Here, $R^{31}$ and $R^{32}$ are each independently a hydrogen atom or an alkyl group with a carbon number of 1 to 6. Of these, $Y^{11}$ and $Y^{12}$ are preferably each independently -O-, -C(=O)-O-, or -O-C(=O)-.

Examples of the alkyl group with a carbon number of 1 to 6 for $R^{31}$ and $R^{32}$ include methyl group, ethyl group, n-propyl group, and isopropyl group.

In the case where a and/or b is 1, $B^{11}$ and $B^{12}$ are each independently a cyclic aliphatic group that may have a substituent or an aromatic group that may have a substituent. Of these, $B^{11}$ and $B^{12}$ are preferably an aromatic group that may have a substituent.

The cyclic aliphatic group that may have a substituent is preferably a cyclic aliphatic group with a carbon number of 5 to 20 that may have a substituent.

Specific examples of the cyclic aliphatic group for $B^{11}$ and $B^{12}$ are the same as those listed above as the cyclic aliphatic group for $A^{11}$ and $A^{12}$ in the foregoing Formula (I).

The aromatic group that may have a substituent is preferably an aromatic group with a carbon number of 2 to 20 that may have a substituent.

Specific examples of the aromatic group for $B^{11}$ and $B^{12}$ are the same as those listed above as the aromatic group for $A^{11}$ and $A^{12}$ in the foregoing Formula (I).

Specific examples of the substituent of the cyclic aliphatic group and the aromatic group for $B^{11}$ and $B^{12}$ are the same as those listed above as the substituent of the cyclic aliphatic group and the aromatic group for $A^{11}$ and $A^{12}$ in the foregoing Formula (I).

In the foregoing Formula (I), $Y^{13}$ and $Y^{14}$ are each independently a single bond, -O-, -C(=O)-, -C(=O)-O-, -O-C(=O)-, $-NR^{31}-C(=O)-$, $-C(=O)-NR^{31}-$, -O-C(=O)-O-, $-NR^{31}-C(=O)-O-$, $-O-C(=O)-NR^{31}-$, or $-NR^{31}-C(=O)-NR^{32}-$. Here, $R^{31}$ and $R^{32}$ are each independently a hydrogen atom or an alkyl group with a carbon number of 1 to 6. Of these, $Y^{13}$ and $Y^{14}$ are preferably each independently -O-, -C(=O)-O-, or -O-C(=O)-.

Examples of the alkyl group with a carbon number of 1 to 6 for $R^{31}$ and $R^{32}$ include methyl group, ethyl group, n-propyl group, and isopropyl group.

In the foregoing Formula (I), $L^1$ and $L^2$ are each independently an organic group of any of an alkylene group with a carbon number of 1 to 20 and a group obtained by substituting at least one methylene group ($-CH_2-$) contained in an alkylene group with a carbon number of 1 to 20 by -O- or -C(=O)-. Here, a hydrogen atom contained in the organic group for $L^1$ and $L^2$ may be substituted by at least one substituent selected from the group consisting of an alkyl group with a carbon number of 1 to 5, an alkoxy group with a carbon number of 1 to 5, and a halogen atom. In the "group obtained by substituting at least one methylene group ($-CH_2-$) contained in an alkylene group with a carbon number of 1 to 20 by -O- or -C(=O)-", -O- preferably does not substitute continuous methylene groups in the alkylene group (i.e. does not form a structure of -O-O-), and -C(=O)- preferably does not substitute continuous methylene groups in the alkylene group (i.e. does not form a structure of -C(=O)-C(=O)-).

The organic group for $L^1$ and $L^2$ is preferably an alkylene group with a carbon number of 1 to 20 that may be substituted by a fluorine atom or a group represented by $-(CH_2)_j-C(=O)-O-(CH_2)_k-$ that may be substituted by a fluorine atom (where j and k are each an integer of 2 to 12, and preferably an integer of 2 to 8), more preferably an alkylene group with a carbon number of 2 to 12 that may be substituted by a fluorine atom, further preferably an unsubstituted alkylene group with a carbon number of 2 to 12, and particularly preferably a group represented by $-(CH_2)_1-$ (where 1 is an integer of 2 to 12, and preferably an integer of 2 to 8).

In the foregoing Formula (I), it is necessary that one of $P^1$ and $P^2$ is a hydrogen atom or a polymerizable group and the other one of $P^1$ and $P^2$ is a polymerizable group. It is preferable that $P^1$ and $P^2$ are both a polymerizable group.

Examples of the polymerizable group for $P^1$ and $P^2$ include a group represented by $CH_2=CR^p-C(=O)-O-$ such as acryloyloxy group and methacryloyloxy group ($R^p$ represents hydrogen atom, methyl group, or chlorine atom), vinyl group, p-stilbene group, acryloyl group, methacryloyl group, carboxyl group, methylcarbonyl group, hydroxy group, amide group, alkylamino group with a carbon number of 1 to 4, amino group, epoxy group, oxetanyl group, aldehyde group, isocyanate group, and thioisocyanate group. Of these, a group represented by $CH_2=CR^p-C(=O)-O-$ is preferable, $CH_2=CH-C(=O)-O-$ (acryloyloxy group) and $CH_2=C(CH_3)-C(=O)-O-$(methacryloyloxy group) are more preferable, and an acryloyloxy group is further preferable. In the case where two $R^p$ are present in the polymerizable compound (I), they may be the same or different.

In terms of obtaining an optical film, etc. having excellent reverse wavelength dispersibility, the polymerizable compound (I) preferably has a structure that is approximately bilaterally symmetric with respect to $Ar^1$. Specifically, the polymerizable compound (I) preferably has a symmetric structure with respect to the side (*) on which $P^1-L^1-Y^{13}-[B^{11}-Y^{11}]_a-A^{11}-Z^{11}-(*)$ and $(*)-Z^{12}-A^{12}-[Y^{12}-B^{12}]_b-Y^{14}-L^2-P^2$ bond with $Ar^1$.

The expression "having a symmetric structure with respect to (*)" means, for example, to have a structure of -C(=O)-O-(*) and (*)-O-C(=O)-, a structure of -O-(*) and (*)-O-, or a structure of -O-C(=O)-(*) and (*)-C(=O)-O-.

The polymerizable compound (I) can be synthesized by combining synthesis reactions known in the art. Specifically, the polymerizable compound (I) can be synthesized with reference to methods described in various literatures (e.g. March's Advanced Organic Chemistry (Wiley), S.R. Sandler and W. Karo "Organic Functional Group Preparations", jointly translated by Naoki Inamoto (Hirokawa Shoten)) and WO 2014/010325 A1.

(1-2) Polymerizable compound (II)

The polymerizable compound (II) is represented by the following Formula (II).

$$P^3-L^{11}-Y^{23}\left[B^{21}-Y^{21}\right]_c A^{21}-Z^{21}-Ar^2-Z^{22}-A^{22}\left[Y^{22}-B^{22}\right]_d Y^{24}-L^{12}-P^4 \quad (II)$$

In Formula (II), c and d are each independently 0 or 1, and preferably 1.

In Formula (II), $Ar^2$ is any of the groups represented by the following Formulas (III-1) to (III-4).

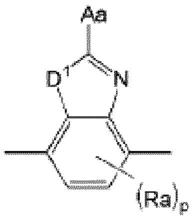 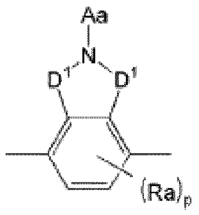 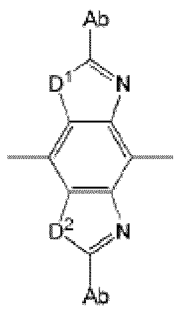 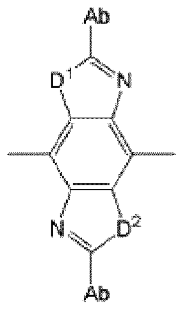

(III-1) (III-2) (III-3) (III-4)

In Formulas (III-1) to (III-4), Ra are each independently a halogen atom, an alkyl group with a carbon number of 1 to 6, a cyano group, a nitro group, an alkylsulfinyl group with a carbon number of 1 to 6, an alkylsulfonyl group with a carbon number of 1 to 6, a carboxyl group, a fluoroalkyl group with a carbon number of 1 to 6, an alkoxy group with a carbon number of 1 to 6, an alkylthio group with a carbon number of 1 to 6, an N-alkylamino group with a carbon number of 1 to 6, an N,N-dialkylamino group with a carbon number of 2 to 12, an N-alkylsulfamoyl group with a carbon number of 1 to 6, or an N,N-dialkylsulfamoyl group with a carbon number of 2 to 12. In each of Formulas (III-1) to (III-4), in the case where there are a plurality of Ra, these substituents may be the same or different.

Examples of the halogen atom for Ra include fluorine atom, chlorine atom, bromine atom, and iodine atom. Fluorine atom, chlorine atom, and bromine atom are preferable.

Examples of the alkyl group with a carbon number of 1 to 6 for Ra include methyl group, ethyl group, n-propyl group, isopropyl group, n-butyl group, isobutyl group, sec-butyl group, tert-butyl group, pentyl group, and hexyl group. Alkyl group with a carbon number of 1 to 4 is preferable, alkyl group with a carbon number of 1 to 2 is more preferable, and methyl group is particularly preferable.

Examples of the alkylsulfinyl group with a carbon number of 1 to 6 for Ra include methylsulfinyl group, ethylsulfinyl group, propylsulfinyl group, isopropylsulfinyl group, butylsulfinyl group, isobutylsulfinyl group, sec-butylsulfinyl group, tert-butylsulfinyl group, pentylsulfinyl group, and hexyl group sulfinyl. Alkylsulfinyl group with a carbon number of 1 to 4 is preferable, alkylsulfinyl group with a carbon number of 1 to 2 is more preferable, and methylsulfinyl group is particularly preferable.

Examples of the alkylsulfonyl group with a carbon number of 1 to 6 for Ra include methylsulfonyl group, ethylsulfonyl group, propylsulfonyl group, isopropylsulfonyl group, butylsulfonyl group, isobutylsulfonyl group, sec-butylsulfonyl group, tert-butylsulfonyl group, pentylsulfonyl group, and hexylsulfonyl group. Alkylsulfonyl group with a carbon number of 1 to 4 is preferable, alkylsulfonyl group with a carbon number of 1 to 2 is more preferable, and methylsulfonyl group is particularly preferable.

Examples of the fluoroalkyl group with a carbon number of 1 to 6 for Ra include fluoromethyl group, trifluoromethyl group, fluoroethyl group, pentafluoroethyl group, heptafluoropropyl group, and nonafluorobutyl group. Fluoroalkyl group with a carbon number of 1 to 4 is preferable, fluoroalkyl group with a carbon number of 1 to 2 is more preferable, and trifluoromethyl group is particularly preferable.

Examples of the alkoxy group with a carbon number of 1 to 6 for Ra include methoxy group, ethoxy group, propoxy group, isopropoxy group, butoxy group, isobutoxy group, sec-butoxy group, tert-butoxy group, pentyloxy group, and hexyloxy group. Alkoxy group with a carbon number of 1 to 4 is preferable, alkoxy group with a carbon number of 1 to 2 is more preferable, and methoxy group is particularly preferable.

Examples of the alkylthio group with a carbon number of 1 to 6 for Ra include methylthio group, ethylthio group, propylthio group, isopropylthio group, butylthio group, isobutylthio group, sec-butylthio group, tert-butylthio group, pentylthio group, and hexylthio group. Alkylthio group with a carbon number of 1 to 4 is preferable, alkylthio group with a carbon number of 1 to 2 is more preferable, and methylthio group is particularly preferable.

Examples of the N-alkylamino group with a carbon number of 1 to 6 for Ra include N-methylamino group, N-ethylamino group, N-propylamino group, N-isopropylamino group, N-butylamino group, N-isobutylamino group, N-sec-butylamino group, N-tert-butylamino group, N-pentylamino group, and N-hexylamino group. N-alkylamino group with a carbon number of 1 to 4 is preferable, N-alkylamino group with a carbon number of 1 to 2 is more preferable, and N-methylamino group is particularly preferable.

Examples of the N,N-dialkylamino group with a carbon number of 2 to 12 for Ra include N,N-dimethylamino group, N-methyl-N-ethylamino group, N,N-diethylamino group, N,N-dipropylamino group, N,N-diisopropylamino group, N,N-dibutylamino group, N,N-diisobutylamino group, N,N-dipentylamino group, and N,N-dihexylamino group. N,N-dialkylamino group with a carbon number of 2 to 8 is preferable, N,N-dialkylamino group with a carbon number of 2 to 4 is more preferable, and N,N-dimethylamino group is particularly preferable.

Examples of the N-alkylsulfamoyl group with a carbon number of 1 to 6 for Ra include N-methylsulfamoyl group, N-ethylsulfamoyl group, N-propylsulfamoyl group, N-isopropylsulfamoyl group, N-butylsulfamoyl group, N-isobutylsulfamoyl group, N-sec-butylsulfamoyl group, N-tert-butylsulfamoyl group, N-pentylsulfamoyl group, and N-hexylsulfamoyl group. N-alkylsulfamoyl group with a carbon number of 1 to 4 is preferable, N-alkylsulfamoyl group with a carbon number of 1 to 2 is more preferable, and N-methylsulfamoyl group is particularly preferable.

Examples of the N,N-dialkylsulfamoyl group with a carbon number of 2 to 12 for Ra include N,N-dimethylsulfamoyl group, N-methyl-N-ethylsulfamoyl group, N,N-diethylsulfamoyl group, N,N-dipropylsulfamoyl group, N,N-diisopropylsulfamoyl group, N,N-dibutylsulfamoyl group, N,N-diisobutylsulfamoyl group, N,N-dipentylsulfamoyl group, and N,N-dihexylsulfamoyl group. N,N-dialkylsulfamoyl group with a carbon number of 2 to 8 is preferable, N,N-dialkylsulfamoyl group with a carbon number of 2 to 4 is more preferable, and N,N-dimethylsulfamoyl group is particularly preferable.

Ra is preferably halogen atom, methyl group, cyano group, nitro group, carboxyl group, methylsulfonyl group, trifluoromethyl group, methoxy group, methylthio group, N-methylamino group, N,N-dimethylamino group, N-methylsulfamoyl group, or N,N-dimethylsulfamoyl group.

In Formulas (III-1) to (III-4), $D^1$ and $D^2$ are each independently $-CR^{41}R^{42}-$, -S-, $-NR^{41}-$, -C(=O)-, or -O-. Here, $R^{41}$ and $R^{42}$ are each independently a hydrogen atom or an alkyl group with a carbon number of 1 to 4. In the group represented by Formula (III-2), two $D^1$ may be the same or different. Examples of the alkyl group with a carbon number of 1 to 4 in $R^{41}$ and $R^{42}$ include methyl group, ethyl group, n-propyl group, isopropyl group, butyl group, isobutyl group, and tert-butyl group. Alkyl group with a carbon number of 1 to 2 is preferable, and methyl group is more preferable.

$D^1$ is preferably -S-, -C(=O)-, -NH-, or $-N(CH_3)-$, and $D^2$ is preferably -S- or -C(=O)-.

In Formulas (III-1) to (III-4), Aa and Ab are each independently an aromatic hydrocarbon ring group or an aromatic heterocyclic group that may be substituted. In the group represented by Formula (III-3), two Ab may be the same or different.

Examples of the aromatic hydrocarbon ring group in Aa and Ab include an aromatic hydrocarbon ring group with a carbon number of 6 to 20 such as phenyl group, naphthyl group, anthryl group, phenanthryl group, and biphenyl group. Phenyl group and naphthyl group are preferable, and phenyl group is more preferable.

Examples of the aromatic heterocyclic group in Aa and Ab include an aromatic heterocyclic group with a carbon number of 4 to 20 containing at least one heteroatom such as nitrogen atom, oxygen atom, or sulfur atom, such as furyl group, pyrrolyl group, thienyl group, pyridinyl group, thiazolyl group, benzothiazolyl group, and benzofuryl group. Furyl group, pyrrolyl group, thienyl group, pyridinyl group, thiazolyl group, and benzofuryl group are preferable.

The aromatic hydrocarbon ring group and the aromatic heterocyclic group in Aa and Ab may have one or more substituents. Examples of the substituent(s) include a halogen atom, an alkyl group with a carbon number of 1 to 6, a cyano group, a nitro group, an alkylsulfinyl group with a carbon number of 1 to 6, an alkylsulfonyl group with a carbon number of 1 to 6, a carboxyl group, a fluoroalkyl group with a carbon number of 1 to 6, an alkoxy group with a carbon number of 1 to 6, an alkylthio group with a carbon number of 1 to 6, an N-alkylamino group with a carbon number of 1 to 6, an N,N-dialkylamino group with a carbon number of 2 to 12, an N-alkylsulfamoyl group with a carbon number of 1 to 6, and an N,N-dialkylsulfamoyl group with a carbon number of 2 to 12. Of these, halogen atom, alkyl group with a carbon number of 1 to 2, cyano group, nitro group, alkylsulfonyl group with a carbon number of 1 to 2, fluoroalkyl group with a carbon number of 1 to 2, alkoxy group with a carbon number of 1 to 2, alkylthio group with a carbon number of 1 to 2, N-alkylamino group with a carbon number of 1 to 2, N,N-dialkylamino group with a carbon number of 2 to 4, and alkylsulfamoyl group with a carbon number of 1 to 2 are preferable. In each of Aa and Ab, in the case where there are two or more substituents, they may be the same or different.

Examples of the halogen atom, the alkyl group with a carbon number of 1 to 6, the alkylsulfinyl group with a carbon number of 1 to 6, the alkylsulfonyl group with a carbon number of 1 to 6, the fluoroalkyl group with a carbon number of 1 to 6, the alkoxy group with a carbon number of 1 to 6, the alkylthio group with a carbon number of 1 to 6, the N-alkylamino group with a carbon number of 1 to 6, the N,N-dialkylamino group with a carbon number of 2 to 12, the N-alkylsulfamoyl group with a carbon number of 1 to 6, and the N,N-dialkylsulfamoyl group with a carbon number of 2 to 12 for Aa and Ab are the same as those listed above as Ra.

Aa and Ab are preferably each independently any of the groups represented by the following Formulas (A-1) to (A-7).

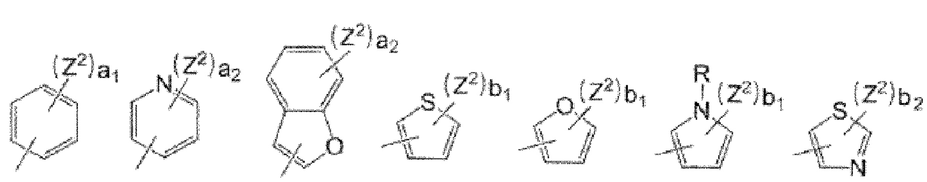

(A-1) (A-2) (A-3) (A-4) (A-5) (A-6) (A-7)

In Formulas (A-1) to (A-7), $Z^2$ is a halogen atom, an alkyl group with a carbon number of 1 to 6, a cyano group, a nitro group, an alkylsulfinyl group with a carbon number of 1 to 6, an alkylsulfonyl group with a carbon number of 1 to 6, a carboxyl group, a fluoroalkyl group with a carbon number of 1 to 6, an alkoxy group with a carbon number of 1 to 6, an alkylthio group with a carbon number of 1 to 6, an N-alkylamino group with a carbon number of 1 to 6, an N,N-dialkylamino group with a carbon number of 2 to 12, an N-alkylsulfamoyl group with a carbon number of 1 to 6, or an N,N-dialkylsulfamoyl group with a carbon number of 2 to 12.

$a_1$ is an integer of 0 to 5, $a_2$ is an integer of 0 to 4, $b_1$ is an integer of 0 to 3, and $b_2$ is an integer of 0 to 2. R is a hydrogen atom or a methyl group.

Examples of the halogen atom, the alkyl group with a carbon number of 1 to 6, the alkylsulfinyl group with a carbon number of 1 to 6, the alkylsulfonyl group with a carbon number of 1 to 6, the fluoroalkyl group with a carbon number of 1 to 6, the alkoxy group with a carbon number of 1 to 6, the alkylthio group with a carbon number of 1 to 6, the N-alkylamino group with a carbon number of 1 to 6, the N,N-dialkylamino group with a carbon number of 2 to 12, the N-alkylsulfamoyl group with a carbon number of 1 to 6, and the N,N-dialkylsulfamoyl group with a carbon number of 2 to 12 for $Z^2$ are the same as those listed above as Ra.

$Z^2$ is preferably a halogen atom, a methyl group, a cyano group, a nitro group, a sulfone group, a carboxyl group, a trifluoromethyl group, a methoxy group, a methylthio group, an N,N-dimethylamino group, or an N-methylamino group.

Aa and Ab are preferably each independently a group represented by Formula (A-1), (A-3), or (A-4), particularly in terms of the optical properties of the polymerizable compound (II) and the costs.

In the foregoing Formulas (III-1) to (III-4), p is an integer of 0 to 2, and preferably 0 or 1.

In the foregoing Formula (II), $Ar^2$ is more preferably any of the groups represented by the following Formulas (Ar-1) to (Ar-4).

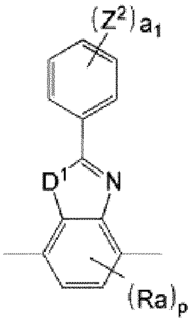
(Ar-1)

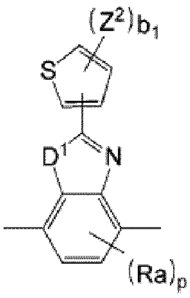
(Ar-2)

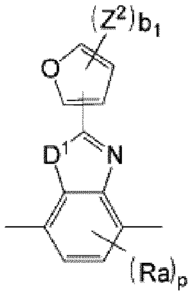
(Ar-3)

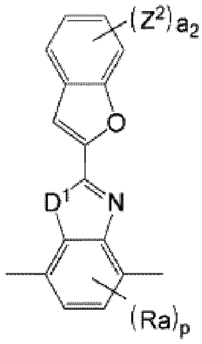
(Ar-4)

In Formulas (Ar-1) to (Ar-4), Ra, $D^1$, $Z^2$, p, $a_1$, $a_2$, and $b_1$ are as defined above.

The following Formulas (ar-1) to (ar-94) represent specific examples of $Ar^2$.

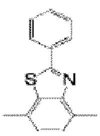
(ar-1)

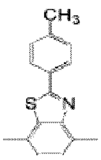
(ar-2)

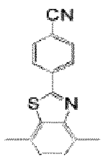
(ar-3)

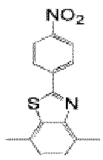
(ar-4)

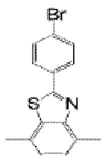
(ar-5)

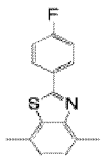
(ar-6)

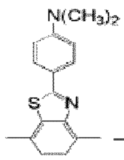
(ar-7)

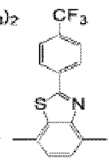
(ar-8)

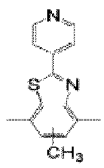
(ar-9)

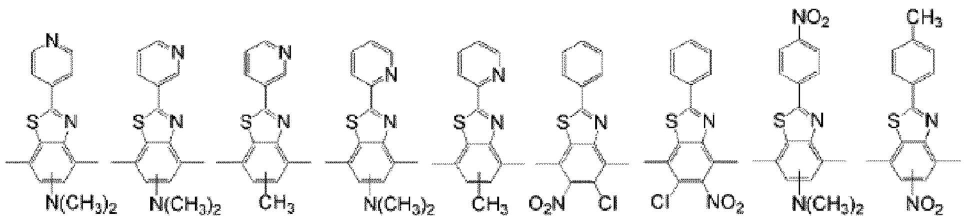

(ar-10) (ar-11) (ar-12) (ar-13) (ar-14) (ar-15) (ar-16) (ar-17) (ar-18)

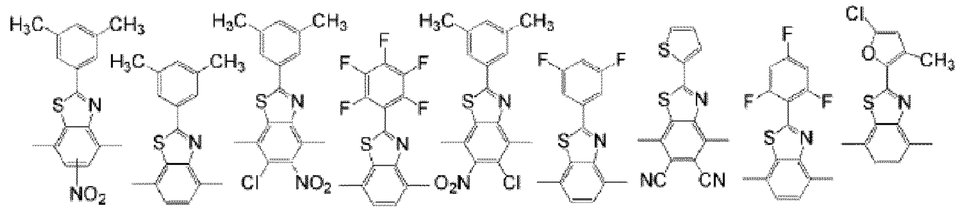

(ar-19) (ar-20) (ar-21) (ar-22) (ar-23) (ar-24) (ar-25) (ar-26) (ar-27)

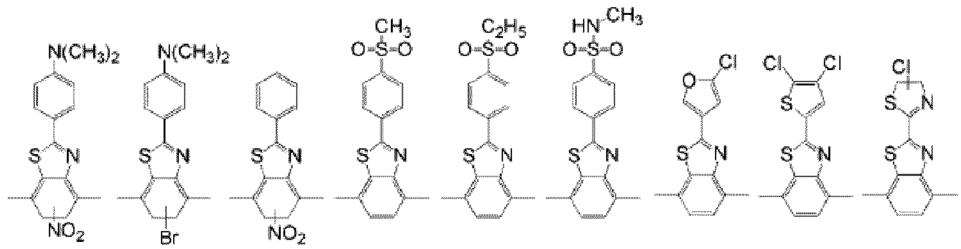

(ar-28) (ar-29) (ar-30) (ar-31) (ar-32) (ar-33) (ar-34) (ar-35) (ar-36)

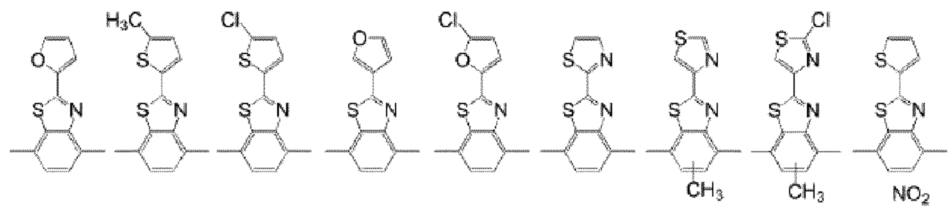

(ar-37) (ar-38) (ar-39) (ar-40) (ar-41) (ar-42) (ar-43) (ar-44) (ar-45)

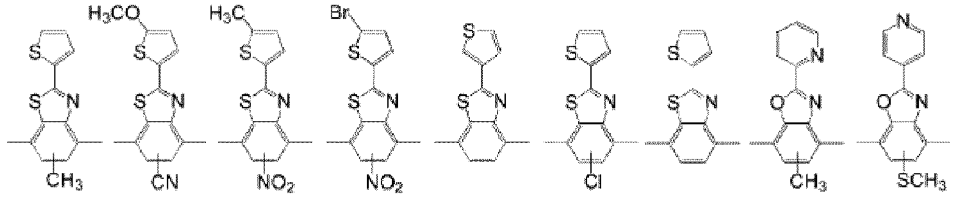

(ar-46) (ar-47) (ar-48) (ar-49) (ar-50) (ar-51) (ar-52) (ar-53) (ar-54)

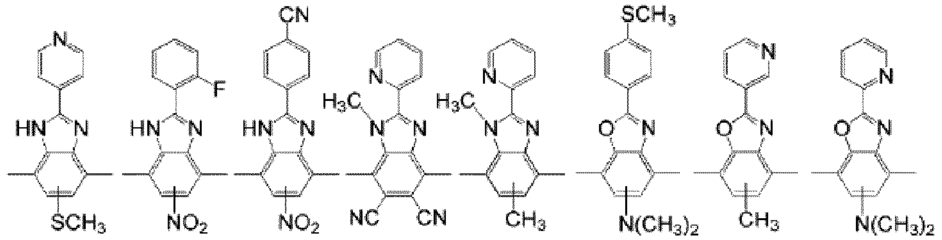

(ar-55) (ar-56) (ar-57) (ar-58) (ar-59) (ar-60) (ar-61) (ar-62)

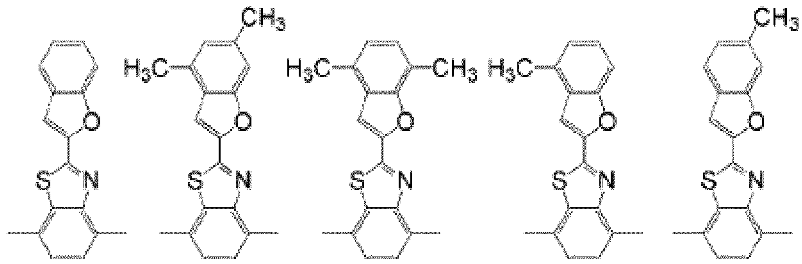

(ar-63) (ar-64) (ar-65) (ar-66) (ar-67)

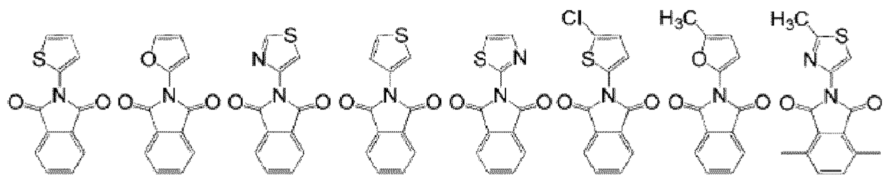

(ar-68) (ar-69) (ar-70) (ar-71) (ar-72) (ar-73) (ar-74) (ar-75)

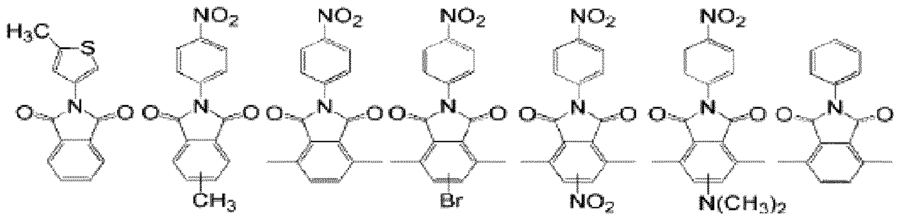

(ar-76) (ar-77) (ar-78) (ar-79) (ar-80) (ar-81) (ar-82)

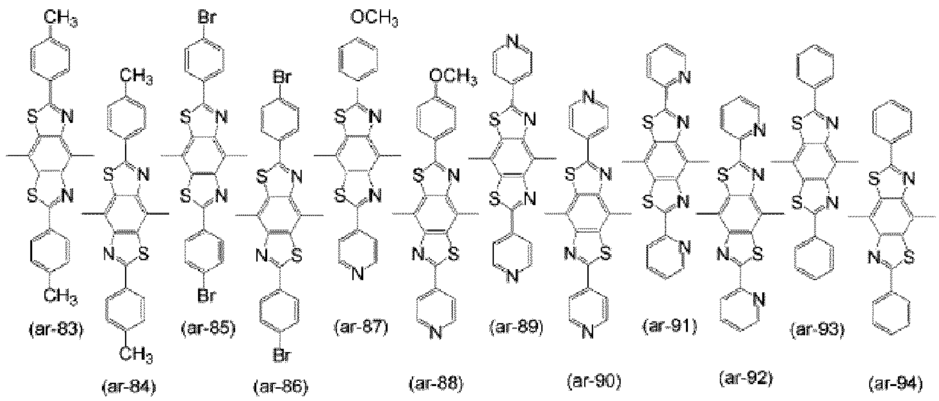

(ar-83) (ar-84) (ar-85) (ar-86) (ar-87) (ar-88) (ar-89) (ar-90) (ar-91) (ar-92) (ar-93) (ar-94)

In the foregoing Formula (II), $Z^{21}$ and $Z^{22}$ are each independently a single bond, -O-$CH_2$-, -$CH_2$-O-, -C(=O)-O-, -O-C(=O)-, -C(=O)-S-, -S-C(=O)-, -$NR^{51}$-C(=O)-, -C(=O)-$NR^{51}$-, -$CF_2$-O-, -O-$CF_2$-, -$CH_2$-$CH_2$-, -$CF_2$-$CF_2$-, -O-$CH_2$-$CH_2$-O-, -CH=CH-C(=O)-O-, -O-C(=O)-CH=CH-, -$CH_2$-$CH_2$-C(=O)-O-, -O-C(=O)-$CH_2$-$CH_2$-, -$CH_2$-$CH_2$-O-C(=O)-, -C(=O)-O-$CH_2$-$CH_2$-, -$CH_2$-C(=O)-O-, -O-C(=O)-$CH_2$-, -$CH_2$-O-C(=O)-, -C(=O)-O-$CH_2$-, -CH=CH-, -N=CH-, -CH=N-, -N=C($CH_3$)-, -C($CH_3$)=N-, -N=N-, or -C=C-. $R^{51}$ is a hydrogen atom or an alkyl group with a carbon number of 1 to 6. Of these, $Z^{21}$ is preferably -C(=O)-O-, and $Z^{22}$ is preferably -O-C(=O)-.

In the foregoing Formula (II), $A^{21}$ and $A^{22}$ are each independently a cyclic aliphatic group that may have a substituent or an aromatic group that may have a substituent. Of these, $A^{21}$ and $A^{22}$ are preferably a cyclic aliphatic group that may have a substituent.

The cyclic aliphatic group that may have a substituent is preferably a cyclic aliphatic group with a carbon number of 5 to 20 that may have a substituent.

Specific examples of the cyclic aliphatic group for $A^{21}$ and $A^{22}$ are the same as those listed above as the cyclic aliphatic group for $A^{11}$ and $A^{12}$ in the polymerizable compound (I).

The aromatic group that may have a substituent is preferably an aromatic group with a carbon number of 2 to 20 that may have a substituent.

Specific examples of the aromatic group for $A^{21}$ and $A^{22}$ are the same as those listed above as the aromatic group for $A^{11}$ and $A^{12}$ in the polymerizable compound (I).

Examples of the substituent of the cyclic aliphatic group and the aromatic group for $A^{21}$ and $A^{22}$ are the same as those listed above as the substituent of the cyclic aliphatic group and the aromatic group for $A^{11}$ and $A^{12}$ in the polymerizable compound (I). In the case where the group has a plurality of substituents, these substituents may be the same or different.

In the foregoing Formula (II), in the case where c and/or d is 1, $Y^{21}$ and $Y^{22}$ are each independently a single bond, -O-, -C(=O)-, -C(=O)-O-, -O-C(=O)-, $-NR^{61}-C(=O)-$, $-C(=O)-NR^{61}-$, -O-C(=O)-O-, $-NR^{61}-C(=O)-O-$, $-O-C(=O)-NR^{61}-$, or $-NR^{61}-C(=O)-NR^{62}-$. Here, $R^{61}$ and $R^{62}$ are each independently a hydrogen atom or an alkyl group with a carbon number of 1 to 6. Of these, $Y^{21}$ and $Y^{22}$ are preferably each independently -O-, -C(=O)-O-, or -O-C(=O)-.

Examples of the alkyl group with a carbon number of 1 to 6 for $R^{61}$ and $R^{62}$ include methyl group, ethyl group, propyl group, and isopropyl group.

In the case where c and/or d is 1, $B^{21}$ and $B^{22}$ are each independently a cyclic aliphatic group that may have a substituent or an aromatic group that may have a substituent. Of these, $B^{21}$ and $B^{22}$ are preferably an aromatic group that may have a substituent.

The cyclic aliphatic group that may have a substituent is preferably a cyclic aliphatic group with a carbon number of 5 to 20 that may have a substituent.

Specific examples of the cyclic aliphatic group for $B^{21}$ and $B^{22}$ are the same as those listed above as the cyclic aliphatic group for $A^{11}$ and $A^{12}$ in the polymerizable compound (I).

The aromatic group that may have a substituent is preferably an aromatic group with a carbon number of 2 to 20 that may have a substituent.

Specific examples of the aromatic group for $B^{21}$ and $B^{22}$ are the same as those listed above as the aromatic group for $A^{11}$ and $A^{12}$ in the polymerizable compound (I).

Examples of the substituent of the cyclic aliphatic group and the aromatic group for $B^{21}$ and $B^{22}$ are the same as those listed above as the substituent of the cyclic aliphatic group and the aromatic group for $A^{11}$ and $A^{12}$ in the polymerizable compound (I).

In the foregoing Formula (II), $Y^{23}$ and $Y^{24}$ are each independently a single bond, -O-, -C(=O)-, -C(=O)-O-, -O-C(=O)-, $-NR^{61}-C(=O)-$, $-C(=O)-NR^{61}-$, -O-C(=O)-O-, $-NR^{61}-C(=O)-O-$, $-O-C(=O)-NR^{61}-$, or $-NR^{61}-C(=O)-NR^{62}-$. Here, $R^{61}$ and $R^{62}$ are each independently a hydrogen atom or an alkyl group with a carbon number of 1 to 6. Of these, $Y^{23}$ and $Y^{24}$ are preferably each independently -O-, -C(=O)-O-, or -O-C(=O)-.

Examples of the alkyl group with a carbon number of 1 to 6 for $R^{61}$ and $R^{62}$ include methyl group, ethyl group, n-propyl group, and isopropyl group.

In the foregoing Formula (II), $L^{11}$ and $L^{12}$ are each independently an organic group of any of an alkylene group with a carbon number of 1 to 20 and a group obtained by substituting at least one methylene group ($-CH_2-$) contained in an alkylene group with a carbon number of 1 to 20 by -O- or -C(=O)-. Here, a hydrogen atom contained in the organic group for $L^{11}$ and $L^{12}$ may be substituted by at least one substituent selected from the group consisting of an alkyl group with a carbon number of 1 to 5, an alkoxy group with a carbon number of 1 to 5, and a halogen atom. In the "group obtained by substituting at least one methylene group ($-CH_2-$) contained in an alkylene group with a carbon number of 1 to 20 by -O- or -C(=O)-", -O- preferably does not substitute continuous methylene groups in the alkylene group (i.e. does not form a structure of -O-O-), and -C(=O)- preferably does not substitute continuous methylene groups in the alkylene group (i.e. does not form a structure of -C(=O)-C(=O)-).

The organic group for $L^{11}$ and $L^{12}$ is preferably an alkylene group with a carbon number of 1 to 20 that may have a substituent, more preferably an alkylene group with a carbon number of 2 to 12 that may have a substituent, further preferably an unsubstituted alkylene group with a carbon number of 2 to 12, and particularly preferably a group represented by $-(CH_2)_y-$ (where y is an integer of 2 to 12, and preferably an integer of 2 to 8).

In the foregoing Formula (II), one of $P^3$ and $P^4$ is a hydrogen atom or a polymerizable group, and the other one of $P^3$ and $P^4$ is a polymerizable group. Preferably, $P^3$ and $P^4$ are both a polymerizable group.

Examples of the polymerizable group for $P^3$ and $P^4$ are the same as those listed above as the polymerizable group for $P^1$ and $P^2$ in the polymerizable compound (I). Of these, acryloyloxy group and methacryloyloxy group are preferable, and acryloyloxy group is more preferable.

In terms of obtaining an optical film, etc. having excellent reverse wavelength dispersibility, the compound (II) preferably has a structure that is approximately bilaterally symmetric with respect to $Ar^2$. Specifically, the polymerizable compound (II) preferably has a symmetric structure with respect to the side (*) on which $P^3-L^{11}-Y^{23}-[B^{21}-Y^{21}]_c-A^{21}-Z^{21}-(*)$ and $(*)-Z^{22}-A^{22}-[Y^{22}-B^{22}]_d-Y^{24}-L^{12}-P^4$ bond with $Ar^2$.

The expression "having a symmetric structure with respect to (*)" means, for example, to have a structure of -C(=O)-O-(*) and (*)-O-C(=O)-, a structure of -O-(*) and (*)-O-, or a structure of -O-C(=O)-(*) and (*)-C(=O)-O-.

In terms of enhancing the affinity between the polymerizable compounds (I) and (II) to make the preparation of the polymerizable composition at relatively low temperature easier and further enhance the stability around room temperature, the polymerizable compounds (I) and (II) preferably have the same structure except $Ar^1$ and C(Q)=N-N(Ax)(Ay) in the polymerizable compound (I) and $Ar^2$ in the polymerizable compound (II). In detail, for example, it is preferable that $P^1$-$L^1$-$Y^{13}$-$[B^{11}$-$Y^{11}]_a$-$A^{11}$-$Z^{11}$- in the polymerizable compound (I) and $P^3$-$L^{11}$-$Y^{23}$-$[B^{21}$-$Y^{21}]_c$-$A^{21}$-$Z^{21}$- in the polymerizable compound (II) have the same structure and -$Z^{12}$-$A^{12}$-$[Y^{12}$-$B^{12}]_b$-$Y^{14}$-$L^2$-$P^2$ in the polymerizable compound (I) and -$Z^{22}$-$A^{22}$-$[Y^{22}$-$B^{22}]_d$-$Y^{24}$-$L^{12}$-$P^4$ in the polymerizable compound (II) have the same structure.

The polymerizable compound (II) can be synthesized by combining synthesis reactions known in the art. Specifically, the polymerizable compound (I) can be synthesized with reference to methods described in various literatures (e.g. March's Advanced Organic Chemistry (Wiley), S.R. Sandler and W. Karo "Organic Functional Group Preparations", jointly translated by Naoki Inamoto (Hirokawa Shoten)) and JP 2010-031223 A.

(1-3) Mixing ratio of polymerizable compounds (I) and (II)

Although the mixing ratio of the polymerizable compounds (I) and (II) is not limited, the proportion of the polymerizable compound (I) in the total of the polymerizable compounds (I) and (II) is preferably 5 mass% or more, more preferably 15 mass% or more, further preferably 25 mass% or more, and particularly preferably 40 mass% or more, and is preferably 90 mass% or less, more preferably 80 mass% or less, further preferably 70 mass% or less, and particularly preferably 60 mass% or less. If the proportion of the polymerizable compound (I) in the total of the polymerizable compounds (I) and (II) is 5 mass% or more, the preparation of the polymerizable composition at relatively low temperature can be made easier, and the stability around room temperature can be further enhanced.

(2) Polymerizable composition

The presently disclosed polymerizable composition contains the foregoing mixture (mixture containing the polymerizable compounds (I) and (II)) and a polymerization initiator.

As described later, the presently disclosed polymerizable composition is useful as the raw material for the manufacture of the presently disclosed polymer, optical film, and optically anisotropic product. The presently disclosed polymerizable composition can be prepared at relatively low temperature, and has excellent stability around room temperature. The use of the presently disclosed polymerizable composition allows for manufacture of an optical film, etc. capable of uniform polarized light conversion over a wide wavelength range.

The polymerization initiator is blended for more efficient polymerization reaction of the polymerizable compounds (I) and (II) contained in the polymerizable composition.

Examples of polymerization initiators used include radical polymerization initiators, anion polymerization initiators, and cation polymerization initiators.

For radical polymerization initiators, both of thermal radical generators (compounds that on heating generate active species that may initiate polymerization of polymerizable compounds) and photo-radical generators (compounds that on exposure to exposure light such as visible ray, ultraviolet ray (e.g. i line), far-ultraviolet ray, electron ray, or X ray generate active species that may initiate polymerization of polymerizable compounds) can be used, with photo-radical generators being suitable.

Examples of the photo-radical generators include acetophenone compounds, biimidazole compounds, triazine compounds, O-acyloxime compounds, onium salt compounds, benzoin compounds, benzophenone compounds, α-diketone compounds, polynuclear quinone compounds, xanthone compounds, diazo compounds, and imidesulfonate compounds. These compounds are components that on exposure to light generate one or both of active radicals and active acid. These photo-radical generators may be used alone or in combination.

Specific examples of the acetophenone compounds include 2-hydroxy-2-methyl-1-phenylpropane-1-one, 2-methyl-1-[4-(methylthio)phenyl]-2-morpholinopropane-1-one, 2-benzyl-2-dimethylamino-1-(4-morpholinophenyl)butane-1 -one, 1-hydroxycyclohexyl phenyl ketone, 2,2-dimethoxy-1,2-diphenylethane-1-one, 1,2-octanedione, and 2-benzyl-2-dimethylamino-4'-morpholinobutyrophenone.

Specific examples of the biimidazole compounds include 2,2'-bis(2-chlorophenyl)-4,4',5,5'-tetrakis(4-ethoxycarbonylphenyl)-1,2'-bii midazole, 2,2'-bis(2-bromophenyl)-4,4',5,5'-tetrakis(4-ethoxycarbonylphenyl)-1,2'-bii midazole, 2,2'-bis(2-chlorophenyl)-4,4',5,5'-tetraphenyl-1,2'-biimidazole, 2,2'-bis(2,4-dichlorophenyl)-4,4',5,5'-tetraphenyl-1,2'-biimidazole, 2,2'-bis(2,4,6-trichlorophenyl)-4,4',5,5'-tetraphenyl-1,2'-biimidazole, 2,2'-bis(2-bromophenyl)-4,4',5,5'-tetraphenyl-1,2'-biimidazole, 2,2'-bis(2,4-dibromophenyl)-4,4',5,5'-tetraphenyl-1,2'-biimidazole, and 2,2'-bis(2,4,6-tribromophenyl)-4,4',5,5'-tetraphenyl-1,2'-biimidazole.

In the present disclosure, in the case where biimidazole compounds are used as photopolymerization initiators (photo-radical generators), it is preferable to use hydrogen donors in combination for further improvement in sensitivity.

By "hydrogen donor" is meant a compound that can donate hydrogen atom to a radical generated on exposure

to light from a biimidazole compound. Preferred hydrogen donors are mercaptan compounds and amine compounds defined below.

Examples of the mercaptan compounds include 2-mercaptobenzothiazole, 2-mercaptobenzoxazole, 2-mercaptobenzimidazole, 2,5-dimercapto-1,3,4-thiadiazole, and 2-mercapto-2,5-dimethylaminopyridine. Examples of the amine compounds include 4,4'-bis(dimethylamino)benzophenone, 4,4'-bis(diethylamino)benzophenone, 4-diethylaminoacetophenone, 4-dimethylaminopropiophenone, ethyl-4-dimethylaminobenzoate, 4-dimethylamino benzoic acid, and 4-dimethylaminobenzonitrile.

Examples of the triazine compounds include triazine compounds having a halomethyl group, such as 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(furan-2-yl)ethenyl]-4,6-bis(trichloromethyl)-s-triazine, 2-[2-(4-diethylamino-2-methylphenyl)ethenyl]-4,6-bis(trichloromethyl)-s-tria zine, 2-[2-(3,4-dimethoxyphenyl)ethenyl]-4,6-bis(trichloromethyl)-s-triazine, 2-(4-methoxyphenyl)-4,6-bis(trichloromethyl)-s-triazine, 2-(4-ethoxystyryl)-4,6-bis(trichloromethyl)-s-triazine, and 2-(4-n-butoxyphenyl)-4,6-bis(trichloromethyl)-s-triazine.

Specific examples of the O-acyloxime compounds include 1-[4-(phenylthio)phenyl]-heptane-1,2-dione2-(O-benzoyloxime), 1-[4-(phenylthio)phenyl]-octane-1,2-dione2-(O-benzoyloxime), 1-[4-(benzoyl)phenyl]-octane-1,2-dione2-(O-benzoyloxime), 1-[9-ethyl-6-(2-methylbenzoyl)-9H-carbozole-3-yl]-ethanone1-(O-acetyloxim e), 1-[9-ethyl-6-(3-methylbenzoyl)-9H-carbozole-3-yl]-ethanone1-(O-acetyloxim e), 1-(9-ethyl-6-benzoyl-9H-carbozole-3-yl)-ethanone1-(O-acetyloxime), ethanone-1-[9-ethyl-6-(2-methyl-4-tetrahydrofuranylbenzoyl)-9H-carbozole-3 -yl]-1-(O-acetyloxime), ethanone-1-[9-ethyl-6-(2-methyl-4-tetrahydropyranylbenzoyl)-9H-carbozole-3-yl]-1-(O-acetyloxime), ethanone-1-[9-ethyl-6-(2-methyl-5-tetrahydrofuranylbenzoyl)-9H-carbozole-3 -yl]-1-(O-acetyloxime), ethanone-1-[9-ethyl-6-(2-methyl-5-tetrahydropyranylbenzoyl)-9H-carbozole-3-yl]-1-(O-acetyloxime), ethanone-1-[9-ethyl-6-{2-methyl-4-(2,2-dimethyl-1,3-dioxolanyl)benzoyl}-9 H-carbozole-3-yl]-1-(O-acetyloxime), ethanone-1-[9-ethyl-6-(2-methyl-4-tetrahydrofuranylmethoxybenzoyl)-9H-car bozole-3-yl]-1-(O-acetyloxime), ethanone-1-[9-ethyl-6-(2-methyl-4-tetrahydropyranylmethoxybenzoyl)-9H-ca rbozole-3-yl]-1-(O-acetyloxime), ethanone-1-[9-ethyl-6-(2-methyl-5-tetrahydrofuranylmethoxybenzoyl)-9H-car bozole-3-yl]-1-(O-acetyloxime), ethanone-1-[9-ethyl-6-(2-methylbenzoyl)-9H-carbozole-3-yl]-1-(O-acetyloxi me), ethanone-1-[9-ethyl-6-(2-methyl-5-tetrahydropyranylmethoxybenzoyl)-9H-ca rbozole-3-yl]-1-(O-acetyloxime), and ethanone-1-[9-ethyl-6-{2-methyl-4-(2,2-dimethyl-1,3-dioxolanyl)methoxyben zoyl}-9H-carbozole-3-yl]-1-(O-acetyloxime).

Commercially available photo-radical generators can be used directly. Specific examples include Irgacure 907, Irgacure 184, Irgacure 369, Irgacure 651, Irgacure 819, Irgacure 907, and Irgacure OXE02 (produced by BASF), and ADEKAARKLS N-1919T (produced by ADEKA Corporation).

Examples of the anion polymerization initiators include: alkyllithium compounds; monolithium or monosodium salts of biphenyl, naphthalene, pyrene, and the like; and polyfunctional initiators such as dilithium salts and trilithium salts.

Examples of the cation polymerization initiators include: protonic acids such as sulfuric acid, phosphoric acid, perchloric acid, and trifluoromethanesulfonic acid; Lewis acids like boron trifluoride, aluminum chloride, titanium tetrachloride, and tin tetrachloride; and aromatic onium salts or combinations of aromatic onium salts with reductants.

These polymerization initiators may be used alone or in combination.

In the presently disclosed polymerizable composition, the polymerization initiator is blended at an amount of typically 0.1 to 30 parts by mass and preferably 0.5 to 10 parts by mass, per 100 parts by mass of the total of the polymerizable compounds (I) and (II).

The presently disclosed polymerizable composition is preferably blended with surfactants for adjustment of surface tension. Although the surfactants are not limited, nonionic surfactants are generally preferred. Commercially available nonionic surfactants will suffice, e.g. nonionic surfactants made of oligomers with a molecular weight on the order of several thousands, such as Ftergent 208G (produced by NEOS).

In the presently disclosed polymerizable composition, the surfactant is blended at an amount of typically 0.01 to 10 parts by mass and preferably 0.1 to 2 parts by mass, per 100 parts by mass of the total of the polymerizable compounds (I) and (II).

The presently disclosed polymerizable composition preferably contains solvents. Although the solvents are not limited, organic solvents are preferable. Examples of organic solvents that can be used include: ketones such as acetone, methyl ethyl ketone, methyl isobutyl ketone, cyclopentanone, and cyclohexanone; esters such as butyl acetate and amyl acetate; halogenated hydrocarbons such as dichloromethane, chloroform, and dichloroethane; ethers such as tetrahydrofuran, tetrahydropyran, 1,2-dimethoxyethane, 1,4-dioxane, cyclopentyl methyl ether, and 1,3-dioxolane; and aprotic polar solvents such as N,N-dimethylformamide, N,N-dimethylacetamide, dimethyl sulfoxide, γ-butyrolactone, and N-methylpyrrolidone. These solvents may be used alone or in combination at any ratio. Of these organic solvents, preferred are those having a boiling point of 60 °C to 200 °C from the viewpoint of handling capability. In terms of the chemical stability and the boiling point of the solvent and the solubility of the polymerizable compound, ethers and ketones are preferred solvents.

Although the concentration of the polymerizable compounds in the polymerizable composition containing the

solvent is not limited, the total proportion of the polymerizable compounds (I) and (II) in the polymerizable composition is preferably 5 mass% to 40 mass%, and more preferably 10 mass% to 35 mass%.

In addition to the mixture containing the polymerizable compounds (I) and (II), the polymerization initiator, the surfactant, and the solvent, the presently disclosed polymerizable composition may further contain other components at amounts that do not compromise the effects of the present disclosure. Examples of the other components include metals, metal complexes, dyes, pigments, fluorescent materials, phosphorescent materials, leveling agents, thixotropic agents, gelling agents, polysaccharides, ultraviolet absorbers, infrared absorbers, antioxidants, ion-exchange resins, and metal oxides such as titanium oxide.

Examples of the other components also include other copolymerizable monomers. Specific examples include, but are not limited to, 4'-methoxyphenyl 4-(2-methacryloyloxyethyloxy)benzoate, biphenyl 4-(6-methacryloyloxyhexyloxy)benzoate, 4 '-cyanobiphenyl 4-(2-acryloyloxyethyloxy)benzoate, 4'-cyanobiphenyl 4-(2-methacryloyloxyethyloxy)benzoate, 3',4'-difluorophenyl 4-(2-methacryloyloxyethyloxy)benzoate, naphthyl 4-(2-methacryloyloxyethyloxy)benzoate, 4-acryloyloxy-4'-decylbiphenyl, 4-acryloyloxy-4'-cyanobiphenyl, 4-(2-acryloyloxyethyloxy)-4'-cyanobiphenyl, 4-(2-methacryloyloxyethyloxy)-4'-methoxybiphenyl, 4-(2-methacryloyloxyethyloxy)-4'-(4"-fluorobenzyloxy)-biphenyl, 4-acryloyloxy-4'-propylcyclohexylphenyl, 4-methacryloyl-4'-butylbicyclohexyl, 4-acryloyl-4'-amyltolane, 4-acryloyl-4'-(3,4-difluorophenyl)bicyclohexyl, (4-amylphenyl) 4-(2-acryloyloxyethyl)benzoate, (4-(4'-propylcyclohexyl)phenyl) 4-(2-acryloyloxyethyl)benzoate, a commercially available product "LC-242" (produced by BASF), trans-1,4-bis[4-[6-(acryloyloxy)hexyloxy]phenyl]cyclohexanedicarboxylate, and compounds disclosed in JP 2007-002208 A, JP 2009-173893 A, JP 2009-274984 A, JP 2010-030979 A, JP 2010-031223 A, JP 2011-006360 A, and JP 2010-24438 A.

These other components are blended at amounts of typically 0.005 to 20 parts by mass per 100 parts by mass of the total of the polymerizable compounds (I) and (II).

The presently disclosed polymerizable composition can be typically prepared by mixing and dissolving predetermined amounts of a mixture containing the polymerizable compounds (I) and (II), a polymerization initiator, and optional other components in the foregoing suitable solvent.

In this case, the polymerizable compounds (I) and (II) as a mixture may be added in the form of pre-mix or may be added separately.

(3) Polymer

The presently disclosed polymer can be obtained by polymerizing a mixture containing the foregoing polymerizable compounds (mixture containing the polymerizable compounds (I) and (II)) or the foregoing polymerizable composition.

By the term "polymerization" herein is meant a chemical reaction in a broad sense including a crosslinking reaction as well as a normal polymerization reaction.

The presently disclosed polymer typically includes a monomer unit derived from the polymerizable compound (I) (repeat unit (I)') and a monomer unit derived from the polymerizable compound (II) (repeat unit (II)').

Examples of the structure of the repeat unit (I)' in the case of using the polymerizable compound (I) having the polymerizable group represented by $CH_2=CR^p-C(=O)-O-$ as $P^1$ and $P^2$ and the structure of the repeat unit (II)' in the case of using the polymerizable compound (II) having the polymerizable group represented by $CH_2=CR^p-C(=O)-O-$ as $P^3$ and $P^4$ are given below.

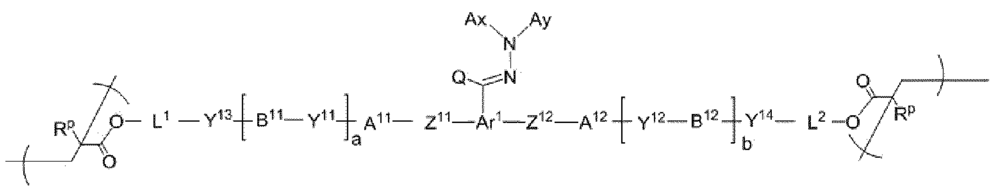

(I)'

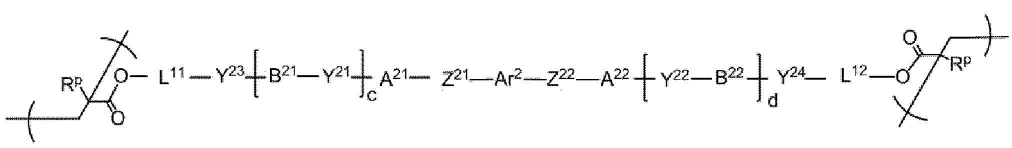

(II)'

[$Ar^1$,Ax, Ay, $Z^{11}$, $Z^{12}$, $A^{11}$, $A^{12}$, $B^{11}$, $B^{12}$, $Y^{11}$, $Y^{12}$, $Y^{13}$, $Y^{14}$, $L^1$, $L^2$, a, and b in Formula (I)' are as defined in Formula (I) and $R^p$ in Formula (I)' are each independently hydrogen atom, methyl group, or chlorine atom, and $Ar^2$, $Z^{21}$, $Z^{22}$, $A^{21}$, $A^{22}$, $B^{21}$, $B^{22}$, $Y^{21}$, $Y^{22}$, $Y^{23}$, $Y^{24}$, $L^{11}$, $L^{12}$, c, and d in Formula (II)' are as defined in Formula (II) and $R^p$ in Formula (II)' are each independently hydrogen atom, methyl group, or chlorine atom.]

Because the presently disclosed polymer is prepared using the mixture containing the polymerizable compounds (I) and (II), it can be advantageously used as the constituent material for an optical film, etc.

The presently disclosed polymer can be used in any shape or form according to its intended use, including film, powder, or layer made of an aggregation of powder.

Specifically, films made of the polymer can be suitably used as the constituent material for the below-described optical film and optically anisotropic product; powders made of the polymer can be utilized for paints, anti-forgery items, security items and the like; and layers made of the polymer powder can be suitably used as the constituent material for the optically anisotropic product.

The presently disclosed polymer can be suitably produced for example by (α) polymerizing the mixture containing the polymerizable compounds or the polymerizable composition in a suitable organic solvent, thereafter isolating the target polymer, dissolving the polymer in a suitable organic solvent to prepare a solution, applying the solution on a suitable substrate to form thereon a coating film, and drying the coating film followed by optional heating, or (β) dissolving the mixture containing the polymerizable compounds or the polymerizable composition in an organic solvent according to need, applying the resulting solution on a substrate by a coating method known in the art and then removing the solvent, and thereafter effecting polymerization by heating or actinic radiation.

Any organic solvent can be used for the polymerization by the method (α) as long as it is inert. Examples of the organic solvent include: aromatic hydrocarbons such as toluene, xylene, and mesitylene; ketones such as cyclohexanone, cyclopentanone, and methyl ethyl ketone; acetates such as butyl acetate and amyl acetate; halogenated hydrocarbons such as chloroform, dichloromethane, and dichloroethane; and ethers such as cyclopentyl methyl ether, tetrahydrofuran, and tetrahydropyran.

Of these organic solvents, preferred are those having a boiling point of 60 °C to 250 °C and more preferably those having a boiling point of 60 °C to 150 °C, from the viewpoint of handling capability.

Examples of organic solvents used to dissolve the isolated polymer in the method (α) and organic solvents used in the method (β) are the same as those listed above as the organic solvents that can be used in the polymerizable composition. Of these organic solvents, preferred are those having a boiling point of 60 °C to 200 °C, from the viewpoint of handling capability. These organic solvents may be used alone or in combination.

Substrates made of any of organic or inorganic materials known in the art can be used in the methods (α) and (β). Examples of the organic material include polycycloolefins (such as Zeonex® and Zeonor® (Zeonex and Zeonor are registered trademarks in Japan, other countries, or both) produced by Zeon Corporation), Arton® (Arton is a registered trademark in Japan, other countries, or both) produced by JSR Corporation, and Apel® (Apel is a registered trademark in Japan, other countries, or both) produced by Mitsui Chemicals Inc.), polyethylene terephthalates, polycarbonates, polyimides, polyamides, polymethyl methacrylates, polystyrenes, polyvinyl chlorides, polytetrafluoroethylene, celluloses, cellulose triacetate, and polyethersulfones. Examples of the inorganic material include silicon, glass, and calcite.

The substrate used may be single-layer or laminate.

The substrate is preferably made of organic material, and further preferably a resin film formed of organic material.

Additional examples of the substrate include those used for the production of the below-described optically anisotropic product.

Coating methods known in the art can be used for applying the polymer solution on the substrate in the method (α) and for applying the solution for polymerization reaction on the substrate in the method (β). Specific examples of usable coating methods include curtain coating, extrusion coating, roll coating, spin coating, dip coating, bar coating, spray coating, slide coating, print coating, gravure coating, die coating, and cap coating.

Drying or solvent removal in the methods (α) and (β) can be effected by natural drying, drying by heating, drying under reduced pressure, drying by heating under reduced pressure, or the like.

Polymerization of the mixture and the polymerizable composition can be effected for example by irradiation with actinic radiation or by thermal polymerization, with irradiation with actinic radiation being preferred as heating is unnecessary so that the reaction proceeds at room temperature. Irradiation with UV or other like light is particularly preferred because the operation is simple.

The temperature during irradiation is preferably set to 30 °C or less. The irradiation intensity is typically 1 $W/m^2$ to 10 $kW/m^2$, and preferably 5 $W/m^2$ to 2 $kW/m^2$.

The polymer obtained as described above can be transferred from the substrate for use, removed from the substrate for single use, or used as it is as the constituent material for an optical film etc. without being removed from the substrate.

The polymer removed from the substrate can also be made into powder form by a grinding method known in the art before use.

The number-average molecular weight of the presently disclosed polymer obtained as described above is preferably 500 to 500,000, and more preferably 5,000 to 300,000. If the number-average molecular weight is in such ranges, the resulting film advantageously exhibits high hardness as well as high handling capability. The number-average

molecular weight of the polymer can be determined by gel permeation chromatography (GPC) using monodisperse polystyrene as a standard and tetrahydrofuran as an eluant.

The presently disclosed polymer allows for manufacture of a high performance optical film etc. capable of uniform polarized light conversion over a wide wavelength range.

(4) Optical film

The presently disclosed optical film is formed using the presently disclosed polymer, and includes a layer having an optical function. By "optical function" as used herein is meant simple transmittance, reflection, refraction, birefringence, or the like. The optical film may or may not have optical anisotropy.

The presently disclosed optical film may be used in any of the following arrangements: "alignment substrate/(alignment film)/optical film" where the optical film remains formed on an alignment substrate that may have an alignment film; "transparent substrate film/optical film" where the optical film has been transferred to a transparent substrate film or the like different from the alignment substrate; and single optical film form in the case where the optical film is self-supportive.

Usable alignment films and alignment substrates are the same as those exemplified for the below-described optically anisotropic product.

The presently disclosed optical film can be produced by (A) applying on an alignment substrate a solution containing the mixture or the polymerizable composition or the polymerizable composition containing a solvent, drying the resulting coating film, subjecting the film to heat treatment (for alignment of liquid crystals), and irradiation and/or heating treatment (for polymerization); or (B) applying on an alignment substrate a solution of a liquid crystal polymer obtained by polymerization of the mixture or the polymerizable composition, and optionally drying the resulting coating film.

The presently disclosed optical film can be used for optically anisotropic products, alignment films for liquid crystal display devices, color filters, low-pass filters, polarization prisms, and various optical filters.

The presently disclosed optical film preferably has $\alpha$ and $\beta$ values that fall within predetermined ranges, which can be calculated as follows based on phase differences at 449.9 nm, 548.5 nm, and 650.2 nm in wavelength measured with an ellipsometer. Specifically, $\alpha$ value is preferably 0.700 or more and more preferably 0.750 or more, and is preferably 0.990 or less, more preferably 0.900 or less, and further preferably 0.840 or less. $\beta$ value is preferably 1.000 or more, more preferably 1.010 or more, and further preferably 1.030 or more, and is preferably 1.250 or less, and more preferably 1.200 or less.

$$\alpha = (\text{phase difference at } 449.9 \text{ nm})/(\text{phase difference at } 548.5 \text{ nm}).$$

$$\beta = (\text{phase difference at } 650.2 \text{ nm})/(\text{phase difference at } 548.5 \text{ nm}).$$

(5) Optically anisotropic product

The presently disclosed optically anisotropic product has a layer having the presently disclosed polymer as the constituent material.

The presently disclosed optically anisotropic product can be obtained for example by forming an alignment film on a substrate and forming a layer made of the presently disclosed polymer (liquid crystal layer) on the alignment film. The presently disclosed optically anisotropic product may be obtained by directly forming a layer made of the presently disclosed polymer (liquid crystal layer) on a substrate or may consist only of a layer made of the presently disclosed polymer (liquid crystal layer).

The layer made of the polymer may be formed of a polymer film or may be an aggregate of a powdery polymer.

The alignment film is formed on the surface of the substrate to regulate the polymerizable compounds to align in one direction in the plane.

The alignment film can be obtained for example by applying a solution containing a polymer such as polyimide, polyvinyl alcohol, polyester, polyarylate, polyamideimide, or polyetherimide (alignment film composition) on the substrate to form a film, drying the film, and rubbing the film in one direction.

The thickness of the alignment film is preferably 0.001 $\mu$m to 5 $\mu$m, and further preferably 0.001 $\mu$m to 1 $\mu$m.

Any method can be used for the rubbing treatment. For example, the alignment film may be rubbed in a given direction using a roll around which a cloth or felt formed of synthetic fiber (e.g. nylon) or natural fiber (e.g. cotton) is wound. It is preferable to wash the alignment film with isopropyl alcohol or the like after completion of the rubbing treatment, in order to remove fine powder (foreign substance) formed during the rubbing treatment to clean the surface

of the alignment film.

Alternative to the rubbing treatment, the alignment film can be provided with a function of in-plane one-direction alignment by irradiation with polarized UV light on the surface of the alignment film.

Examples of the substrates on which the alignment film is to be formed include glass substrates and substrates formed of synthetic resin films. Examples of synthetic resins include thermoplastic resins such as acrylic resins, polycarbonate resins, polyethersulfone resins, polyethylene terephthlate resins, polyimide resins, polymethyl methacrylate resins, polysulfone resins, polyarylate resins, polyethylene resins, polystyrene resins, polyvinyl chloride resins, cellulose diacetate, cellulose triacetate, and alicyclic olefin polymers.

Examples of the alicyclic olefin polymers include: cyclic olefin random multi-component copolymers described in JP H05-310845 A and US 5179171 A; hydrogenated polymers described in JP H05-97978 A and US 5202388 A; and thermoplastic dicyclopentadiene open-ring polymers and hydrogenated products thereof described in JP H11-124429 A (WO 99/20676 A1).

In the present disclosure, examples of methods of forming a liquid crystal layer made of the presently disclosed polymer on the alignment film are the same as those described in the above chapter for the presently disclosed polymer (the methods ($\alpha$) and ($\beta$)).

The resulting liquid crystal layer may be of any thickness, and typically has a thickness of 1 $\mu$m to 10 $\mu$m.

The presently disclosed optically anisotropic product can be used as any product, e.g. as a retardation film, a viewing-angle enhancing film, or the like.

The presently disclosed optically anisotropic product preferably has $\alpha$ and $\beta$ values that fall within predetermined ranges, which can be calculated as follows based on phase differences at 449.9 nm, 548.5 nm, and 650.2 nm in wavelength measured with an ellipsometer. Specifically, $\alpha$ value is preferably 0.700 or more and more preferably 0.750 or more, and is preferably 0.990 or less, more preferably 0.900 or less, and further preferably 0.840 or less. $\beta$ value is preferably 1.000 or more, more preferably 1.010 or more, and further preferably 1.030 or more, and is preferably 1.250 or less, and more preferably 1.200 or less.

$$\alpha = (\text{phase difference at } 449.9 \text{ nm})/(\text{phase difference at } 548.5 \text{ nm}).$$

$$\beta = (\text{phase difference at } 650.2 \text{ nm})/(\text{phase difference at } 548.5 \text{ nm}).$$

(6) Polarizing plate, etc.

The presently disclosed polarizing plate includes the presently disclosed optically anisotropic product and a polarizing film.

A specific example of the presently disclosed polarizing plate is a polarizing plate obtained by laminating the presently disclosed optically anisotropic product on a polarizing film either directly or with other layer(s) (e.g. glass plate) disposed between the optically anisotropic product and the polarizing film.

Any method can be used for the manufacture of the polarizing film. Examples of methods of manufacturing a PVA polarizing film include: a method wherein iodine ions are adsorbed onto a PVA film followed by uniaxial stretching of the PVA film; a method wherein a PVA film is uniaxially stretched followed by adsorption of iodine ions; a method wherein adsorption of iodine ions to a PVA film and uniaxial stretching are simultaneously performed; a method wherein a PVA film is dyed with dichroic dye followed by uniaxial stretching; a method wherein a PVA film is uniaxially stretched followed by dying with dichroic dye; and a method wherein dying of a PVA film with dichroic dye and uniaxial stretching are simultaneously performed. Examples of methods of manufacturing a polyene polarizing film include known methods in the art, e.g., a method wherein a PVA film is uniaxially stretched followed by heating and dehydration in the presence of a dehydration catalyst, and a method wherein a polyvinyl chloride film is uniaxially stretched followed by heating and dechlorination in the presence of a dechlorination catalyst.

In the presently disclosed polarizing plate, the polarizing film and the presently disclosed optically anisotropic product may be bonded with an adhesive layer made of an adhesive (including tackifier). The average thickness of the adhesive layer is typically 0.01 $\mu$m to 30 $\mu$m, and preferably 0.1 $\mu$m to 15 $\mu$m. The adhesive layer preferably has a tensile fracture strength of 40 MPa or less as measured in accordance with JIS K 7113.

Examples of adhesives for the adhesive layer include acrylic adhesives, urethane adhesives, polyester adhesives, polyvinyl alcohol adhesives, polyolefin adhesives, modified polyolefin adhesives, polyvinyl alkyl ether adhesives, rubber adhesives, vinyl chloride-vinyl acetate adhesives, styrene-butadiene-styrene copolymer (SBS copolymer) adhesives and their hydrogenated product (SEBS copolymer) adhesives, ethylene adhesives such as ethylene-vinyl acetate copolymers and ethylene-styrene copolymers, and acrylate adhesives such as ethylene-methyl methacrylate copolymer,

ethylene-methyl acrylate copolymer, ethylene-ethyl methacrylate copolymer, and ethylene-ethyl acrylate copolymer.

The presently disclosed polarizing plate includes the presently disclosed optically anisotropic product, and therefore can be manufactured at low cost as well as having such superior performance as low reflected luminance and capability of uniform polarized light conversion over a wide wavelength range.

By using the presently disclosed polarizing plate, it is possible to suitably manufacture flat panel display devices that include a liquid crystal panel, organic electroluminescence display devices that include an organic electroluminescence panel, and antireflection films.

(7) Method of using polymerizable compound

The presently disclosed method of using a polymerizable compound is a method of using the polymerizable compound represented by the foregoing Formula (I) in order to suppress precipitation of a compound in a polymerizable composition.

If the polymerizable compound (I) is blended in the polymerizable composition, precipitation of a polymerizable compound other than the polymerizable compound (I) dissolved in the polymerizable composition can be suppressed particularly around room temperature, presumably because the polymerizable compound (I) has high solubility in industrially usable solvents. In particular, precipitation of a polymerizable compound such as the polymerizable compound (II) that has low solubility and is easy to precipitate can be suppressed effectively.

As the polymerizable composition in this use method, the presently disclosed polymerizable composition containing the polymerizable compound (I), the polymerizable compound (II), and a polymerization initiator can be used. The amount of the polymerizable compound (II) used and the like depend on the presently disclosed polymerizable composition.

EXAMPLES

The presently disclosed techniques will be described in more detail below by way of examples, which however shall not be construed as limiting the scope of the present disclosure in any way.

(Synthesis Example 1) Synthesis of compound 1

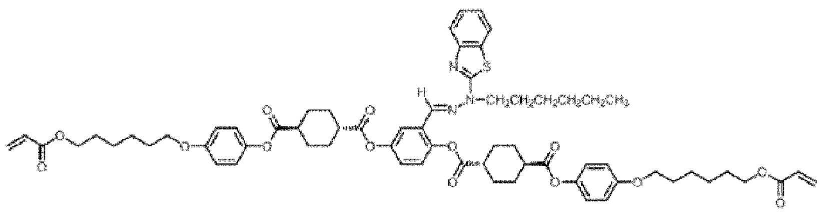

Compound 1

Compound 1 was synthesized according to Examples in WO 2014/010325 A1.

(Synthesis Example 2) Synthesis of compound A

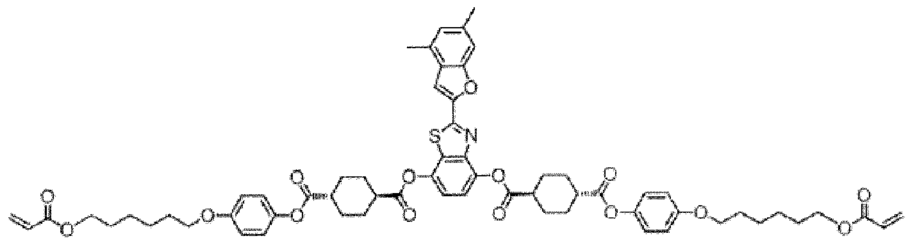

Compound A

Step 1: synthesis of intermediate 1-1

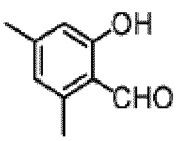

Intermediate 1-1

In a four-necked reactor equipped with a thermometer, 20.0 g (164 mmol) of 3,5-dimethylphenol was dissolved in 500 ml of acetonitrile under a nitrogen stream. 23.4 g (246 mmol) of magnesium chloride and 58.1 g (574 mmol) of triethylamine were added to this solution, and stirred at 25 °C for 30 min. After this, 14.8 g (492 mmol) of paraformaldehyde was added, and stirred at 75 °C for 3 hr. After the completion of the reaction, the reaction solution was cooled to 30 °C, and then 600 ml of 1M hydrochloric acid was added and extracted with 800 ml of diethylether. The diethylether layer was washed with 300 ml of a saturated aqueous solution of sodium hydrogen carbonate and 300 ml of saturated brine, and then dried with anhydrous magnesium sulfate. After filtering the magnesium sulfate, the diethylether was distilled under reduced pressure using a rotary evaporator, to obtain a white solid. The white solid was purified by silica gel column chromatography (hexane:ethyl acetate = 90:10 (volume ratio)), thus obtaining 17.7 g of intermediate 1-1 as a white solid (yield: 71.9%). The structure was identified by $^1$H-NMR. $^1$H-NMR spectral data is as follows.
$^1$H-NMR (500 MHz, $CDCl_3$, TMS, $\delta$ ppm): 11.95 (s, 1H), 10.22 (s, 1H), 6.61 (s, 1H), 6.53 (s, 1H), 2.54 (s, 3H), 2.30 (s, 3H).

Step 2: synthesis of intermediate 1-2

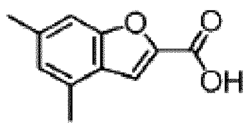

Intermediate 1-2

In a four-necked reactor equipped with a thermometer, 12.0 g (79.9 mmol) of intermediate 1-1 was dissolved in 105 ml of dimethylacetoamide under a nitrogen stream. 11.0 g (79.9 mmol) of potassium carbonate was added to this solution and heated to 80 °C, and then 13.3 g (79.9 mmol) of bromoethyl acetate was added over 30 min. The solution was stirred at 80 °C for 1 hr, and then heated to 130 °C and further stirred for 1 hr. After this, the reaction solution was cooled to 30 °C, and then 300 ml of 1M hydrochloric acid was added and extracted with 120 ml of methylisobutylketone. The methylisobutylketone layer was dried with sodium sulfate, the sodium sulfate was filtered, and then the methylisobutylketone was distilled under reduced pressure using a rotary evaporator to obtain a pale yellow solid. The pale yellow solid was dissolved in 500 ml of ethanol. 12.0 g (214 mmol) of potassium hydroxide was added to the solution, and stirred at 80 °C for 1 hr. After the completion of the reaction, ethanol was distilled under reduced pressure using a

rotary evaporator, thus obtaining a pale yellow solid. The pale yellow solid was dissolved in 300 ml of water, and the resulting solution was washed with 300 ml of toluene and 300 ml of heptane. A 2M sulfuric acid aqueous solution was added to the solution to adjust pH to 3, and then the precipitated solid was filtered, and the filtered solid was vacuum dried to obtain 12.3 g of intermediate 1-2 as a white solid (yield: 80.9 %). The structure was identified by $^1$H-NMR. $^1$H-NMR spectral data is as follows.
$^1$H-NMR (500 MHz, $CDCl_3$, TMS, δ ppm): 13.42 (brs, 1H), 7.69 (d, 1H, J=1.0Hz), 7.30 (s, 1H), 6.98 (s, 1H), 2.48 (s, 3H), 2.41 (s, 3H).

Step 3: synthesis of intermediate 1-3

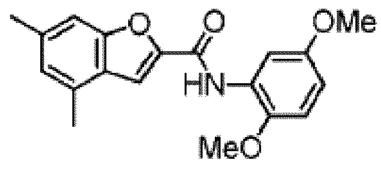

Intermediate 1-3

In a four-necked reactor equipped with a thermometer, 12.0 g (63.1 mmol) of intermediate 1-2 and 14.5 g (94.6 mmol) of 2,5-dimethoxyaniline were dissolved in 120 g of chloroform under a nitrogen stream. A mixed solution of 13.3 g (69.4 mmol) of 1-(3-dimethylaminopropyl)-3-ethylcarbodiimide hydrochloride and 120 g of chloroform was added to the solution, and stirred at 25 °C for 3 hr. After the completion of the reaction, chloroform was distilled under reduced pressure using a rotary evaporator, thus obtaining a pale yellow oil. A mixed solution of 200 ml of 1M hydrochloric acid, 200 ml of water, and 100 ml of methanol was added to the pale yellow oil, and stirred at 25 °C. The precipitated white solid was filtered, and the filtered solid was vacuum dried to obtain 16.7 g of intermediate 1-3 as a white solid (yield: 81.2 %). The structure was identified by $^1$H-NMR. $^1$H-NMR spectral data is as follows.
$^1$H-NMR (500 MHz, $CDCl_3$, TMS, δ ppm): 8.28 (d, 1H, J=3.0Hz), 7.56 (d, 1H, J=1.0Hz), 7.26 (s, 1H), 7.22 (s, 1H), 6.94 (s, 1H), 6.86 (d, 1H, J=9.0Hz), 6.64 (dd, 1H, J=3.0Hz, 9.0Hz), 3.97 (s, 3H), 3.81 (s, 3H), 2.51 (s, 3H), 2.49 (s, 3H).

Step 4: synthesis of intermediate 1-4

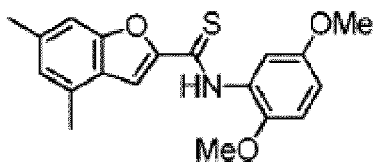

Intermediate 1-4

In a four-necked reactor equipped with a thermometer, 16.0 g (49.2 mmol) of intermediate 1-3 was dissolved in 200 ml of toluene under a nitrogen stream. 12.1 g (23.0 mmol) of 2,4-bis(4-methoxyphenyl)-1,3-dithia-2,4-diphosphetane was added to this solution, and heated under reflux for 4 hr. After the completion of the reaction, the reaction solution was cooled to 30 °C, and then 400 ml of 1M sodium hydroxide aqueous solution was added and extracted with 500 ml of toluene. 500 ml of toluene was distilled under reduced pressure from the resulting toluene layer using a rotary evaporator, and then 500 ml of heptane was added. The precipitated yellow solid was filtered, and the filtered solid was vacuum dried, thus obtaining 14.7 g of intermediate 1-4 as a yellow solid (yield: 87.5 %). The structure was identified by $^1$H-NMR. $^1$H-NMR spectral data is as follows.
$^1$H-NMR (500 MHz, $CDCl_3$, TMS, δ ppm): 10.45 (s, 1H), 9.13 (d, 1H, J=3.0Hz), 7.82 (d, 1H, J=1.0Hz), 7.18 (s, 1H), 6.93 (s, 1H), 6.91 (d, 1H, J=9.0Hz), 6.77 (dd, 1H, J=3.0Hz, 9.0Hz), 3.97 (s, 3H), 3.83 (s, 3H), 2.51 (s, 3H), 2.46 (s, 3H).

Step 5: synthesis of intermediate 1-5

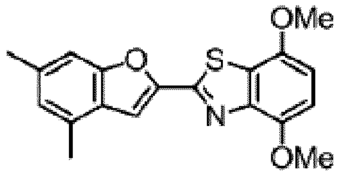

Intermediate 1-5

A four-necked reactor equipped with a thermometer was charged with 13.2 g (38.6 mmol) of intermediate 1-4, 220 g of water, and 11.9 g (212 mmol) of potassium hydroxide under a nitrogen stream, and stirred under ice cooling. 29.2 g (88.8 mmol) of potassium ferricyanide and 12 g of methanol were added to the resulting mixed solution, and then heated to 60 °C and stirred for 6 hr. After the completion of the reaction, the reaction solution was cooled to 30 °C, the precipitated yellow solid was filtered, and the filtered solid was vacuum dried, thus obtaining 10.2 g of intermediate 1-5 as a yellow solid (yield: 76.8 %). The structure was identified by $^1$H-NMR. $^1$H-NMR spectral data is as follows.
$^1$H-NMR (500 MHz, $CDCl_3$, TMS, $\delta$ ppm): 7.65 (d, 1H, J=1.0Hz), 7.21 (s, 1H), 6.91 (s, 1H), 6.84 (d, 1H, J=8.5Hz), 6.76 (d, 1H, J=8.5Hz), 4.04 (s, 3H), 3.97 (s, 3H), 2.51 (s, 3H), 2.46 (s, 3H).

Step 6: synthesis of intermediate 1-6

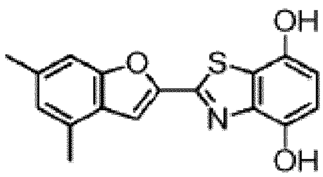

Intermediate 1-6

A four-necked reactor equipped with a thermometer was charged with 7.2 g (21.2 mmol) of intermediate 1-5 and 72 g of pyridine hydrochloride under a nitrogen stream, and stirred at 180 °C for 4 hr. After the completion of the reaction, the reaction solution was cooled to 30 °C, and 300 g of water was added. The precipitated solid was filtered, and washed with 30 g of water, 30 g of toluene, and 30 g of hexane. The resulting solid was vacuum dried, thus obtaining 6.38 g of intermediate 1-6 as a yellow solid (yield: 96.6 %). The structure was identified by $^1$H-NMR. $^1$H-NMR spectral data is as follows.
$^1$H-NMR (500 MHz, DMSO-d6, TMS, $\delta$ ppm): 9.91 (s, 1H), 9.59 (brs, 1H), 7.76 (d, 1H, J=1.0Hz), 7.36 (s, 1H), 6.99 (s, 1H), 6.79 (d, 1H, J=8.5Hz), 6.74 (d, 1H, J=8.5Hz), 2.53 (s, 3H), 2.43 (s, 3H).

Step 7: synthesis of intermediate A

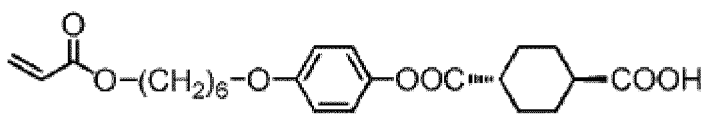

Intermediate A

A three-necked reactor equipped with a thermometer was charged with 17.98 g (104.42 mmol) of trans-1,4-cyclohexanedicarboxylic acid and 180 ml of tetrahydrofuran (THF) under a nitrogen stream. 6.58 g (57.43 mmol) of methanesulfonyl chloride was added, and the reactor was immersed in a water bath to adjust the reaction solution temperature to 20 °C. 6.34 g (62.65 mmol) of triethylamine was added dropwise over 10 min while retaining the reaction solution temperature to 20 °C to 30 °C. After the dropwise addition, the entire mass was further stirred at 25 °C for 2 hr.

To the resulting reaction solution were added 0.64 g (5.22 mmol) of 4-(dimethylamino)pyridine and 13.80 g (52.21 mmol) of 4-(6-acryloyloxy-hex-1-yloxy)phenol (produced by DKSH Japan K.K.), and the reactor was again immersed in the water bath to adjust the reaction solution temperature to 15 °C. 6.34 g (62.65 mmol) of triethylamine was added dropwise over 10 min while retaining the reaction solution temperature to 20 °C to 30 °C. After the dropwise addition, the entire mass was further stirred at 25 °C for 2 hr. After the completion of the reaction, 1,000 ml of distilled water and 100 ml of saturated brine were added to the reaction solution, and extracted twice with 400 ml of ethyl acetate. The organic layers were collected and dried over sodium sulfate anhydrous, and sodium sulfate was filtered off. The solvent was evaporated from the filtrate using a rotary evaporator, and the residue was purified by silica gel column chromatography (THF:toluene = 1:9 (volume ratio)). As a consequence, 14.11 g of intermediate A was obtained as a white solid (yield: 65 mol%). The structure of the target compound was identified by $^1$H-NMR. $^1$H-NMR spectral data is as follows.

$^1$H-NMR (500 MHz, DMSO-$d_6$, TMS, $\delta$ ppm): 12.12 (s,1H), 6.99 (d,2H,J=9.0Hz), 6.92 (d,2H,J=9.0Hz), 6.32 (dd,1H,J=1.5Hz,17.5Hz), 6.17 (dd,1H,J=10.0Hz,17.5Hz), 5.93 (dd,1H,J=1.5Hz,10.0Hz), 4.11 (t,2H,J=6.5Hz), 3.94 (t,2H,J=6.5Hz), 2.48-2.56 (m,1H), 2.18-2.26 (m,1H), 2.04-2.10 (m,2H), 1.93-2.00 (m,2H), 1.59-1.75 (m,4H), 1.35-1.52 (m,8H).

Step 8: synthesis of compound A

A four-necked reactor equipped with a thermometer was charged with 1.00 g (3.21 mmol) of intermediate 1-6 and 20 ml of chloroform under a nitrogen stream. 2.96 g (7.07 mmol) of intermediate A and 39.2 mg (0.321 mmol) of 4-dimethylaminopyridine were added to this solution, and cooled to 0 °C. After this, 972 mg (7.70 mmol) of N, N'-diisopropylcarbodiimide was added to the solution, and stirred at room temperature for 1.5 hr. After the completion of the reaction, the reaction solution was filtered using a filter medium precoated with a silica gel, and then concentrated under reduced pressure. The resulting residue was purified by silica gel column chromatography (chloroform:ethyl acetate = 90:10 (volume ratio)), thus obtaining 2.84 g of compound A as a white solid (yield: 79.5 %). The structure was identified by $^1$H-NMR. $^1$H-NMR spectral data is as follows.

$^1$H-NMR (500 MHz, $CDCl_3$, TMS, $\delta$ ppm): 7.53 (d, 1H, J=1.0Hz), 7.23 (s, 2H), 7.21 (s, 1H), 6.999 (d, 2H, J=9.0Hz), 6.995 (d, 2H, J=9.0Hz), 6.94 (s, 1H), 6.89 (d, 4H, J=9.0Hz), 6.40 (dd, 2H, J=1.5Hz, 17.5Hz), 6.12 (dd, 2H, J=10.5Hz, 17.5Hz), 5.82 (dd, 2H, J=1.5Hz, 10.5Hz), 4.18 (t, 4H, J=7.0Hz), 3.95 (t, 4H, J=6.5Hz), 2.84 (tt, 1H, J=3.5Hz, 12.0Hz), 2.59-2.75 (m, 3H), 2.54 (s, 3H), 2.47 (s, 3H), 2.42-2.46 (m, 2H), 2.31-2.41 (m, 6H), 1.69-1.87 (m, 16H), 1.41-1.57 (m, 8H).

(Synthesis Example 3) Synthesis of compound B

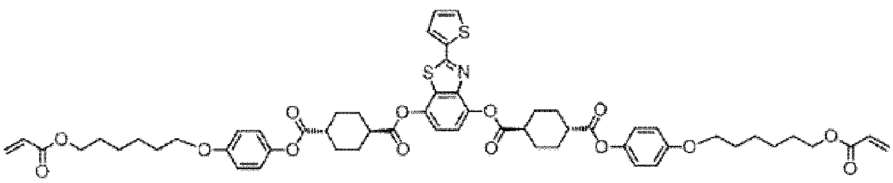

Compound B

Step 1: synthesis of intermediate 2-1

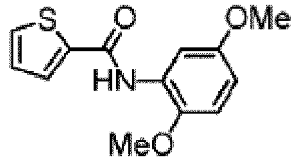

Intermediate 2-1

In a four-necked reactor equipped with a thermometer, 5.00 g (34.1 mmol) of 2-thenoylchloride and 5.22 g (34.1 mmol) of 2,5-dimethoxyaniline were dissolved in 50 g of chloroform under a nitrogen stream. 6.90 g (68.2 mmol) of triethylamine was added to this solution, and stirred at 60 °C for 2 hr. After the completion of the reaction, 50 g of water was added, and extracted with 100 ml of chloroform. 100 ml of chloroform was distilled under reduced pressure from the resulting chloroform layer using a rotary evaporator, and then 100 ml of heptane was added. The precipitated pale yellow solid was filtered, and the filtered solid was vacuum dried, thus obtaining 7.79 g of intermediate 2-1 as a pale yellow solid (yield: 86.7 %). The structure was identified by $^1$H-NMR. $^1$H-NMR spectral data is as follows.
$^1$H-NMR (500 MHz, $CDCl_3$, TMS, $\delta$ ppm): 8.45 (s, 1H), 8.20 (d, 1H, J=3.0Hz), 7.61 (dd, 1H, J=1.0Hz, 3.5Hz), 7.54 (dd, 1H, J=1.0Hz, 5.0Hz), 7.13 (dd, 1H, J=3.5Hz, 5.0Hz), 6.83 (d, 1H, J=9.0Hz), 6.61 (dd, 1H, J=3.0Hz, 9.0Hz), 3.89 (s, 3H), 3.81 (s, 3H).

Step 2: synthesis of intermediate 2-2

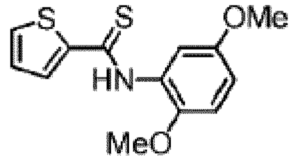

Intermediate 2-2

In a four-necked reactor equipped with a thermometer, 7.00 g (26.6 mmol) of intermediate 2-1 was dissolved in 100 ml of toluene under a nitrogen stream. 6.45 g (15.9 mmol) of 2,4-bis(4-methoxyphenyl)-1,3-dithia-2,4-diphosphetane was added to this solution, and heated under reflux for 4 hr. After the completion of the reaction, the reaction solution was cooled to 30 °C, and then 400 ml of 1M sodium hydroxide aqueous solution was added and extracted with 500 ml of toluene. Toluene was distilled under reduced pressure from the resulting toluene layer using a rotary evaporator, thus obtaining an oil. The obtained oil was purified by silica gel column chromatography (toluene:ethyl acetate = 90:10 (volume ratio)), thus obtaining 7.07 g of compound 2-2 as an orange oil (yield: 95.2 %). The structure was identified by $^1$H-NMR. $^1$H-NMR spectral data is as follows.
$^1$H-NMR (500 MHz, $CDCl_3$, TMS, $\delta$ ppm): 9.71 (s, 1H), 8.88 (s, 1H), 7.52 (dd, 1H, J=1.0Hz, 5.0Hz), 7.47 (dd, 1H, J=1.0Hz, 4.0Hz), 7.09 (dd, 1H, J=4.0Hz, 5.0Hz), 6.86 (d, 1H, J=9.0Hz), 6.70 (dd, 1H, J=3.0Hz, 9.0Hz), 3.89 (s, 3H), 3.78 (s, 3H).

Step 3: synthesis of intermediate 2-3

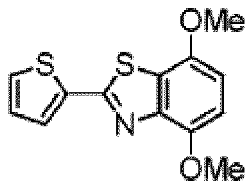

Intermediate 2-3

A four-necked reactor equipped with a thermometer was charged with 7.00 g (25.1 mmol) of intermediate 2-2, 120 g of water, and 8.20 g (146 mmol) of potassium hydroxide under a nitrogen stream, and stirred under ice cooling. 21.9 g (66.5 mmol) of potassium ferricyanide and 6 g of methanol were added to the resulting mixed solution, and then heated to 25 °C and stirred for 15 hr. After the completion of the reaction, the precipitated yellow solid was filtered, and the filtered solid was vacuum dried, thus obtaining 3.40 g of intermediate 2-3 as a yellow solid (yield: 46.1 %). The structure was identified by $^1$H-NMR. $^1$H-NMR spectral data is as follows.
$^1$H-NMR (400 MHz, $CDCl_3$, TMS, $\delta$ ppm): 7.67 (dd, 1H, J=1.2Hz, 3.6Hz), 7.46 (dd, 1H, J=1.2Hz, 5.2Hz), 7.11 (dd, 1H, J=3.6Hz, 5.2Hz), 6.82 (d, 1H, J=8.8Hz), 7.30 (d, 1H, J=8.8Hz), 4.02 (s, 3H), 3.95 (s, 3H).

Step 4: synthesis of intermediate 2-4

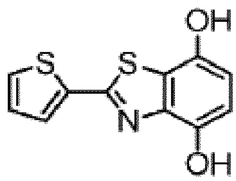

Intermediate 2-4

In a four-necked reactor equipped with a thermometer, 2.10 g (7.72 mmol) of intermediate 2-3 was dissolved in 50 ml of toluene under a nitrogen stream, and then cooled to 0 °C. 46.3 ml (46.3 mmol) of 1M boron tribromide dichloromethane solution was added to this solution, and stirred for 1 hr. After the completion of the reaction, the reaction solution was added to 200 ml of water, and the precipitated solid was filtered. The resulting solid was vacuum dried, thus obtaining 1.79 g of intermediate 2-4 as a yellow solid (yield: 93.2 %). The structure was identified by $^1$H-NMR. $^1$H-NMR spectral data is as follows.
$^1$H-NMR (500 MHz, DMSO-d6, TMS, $\delta$ ppm): 9.82 (s, 1H), 9.48 (s, 1H), 7.83 (dd, 1H, J=1.0Hz, 5.0Hz), 7.78 (dd, 1H, J=1.0Hz, 3.5Hz), 7.23 (dd, 1H, J=3.5Hz, 5.0Hz), 6.74 (d, 1H, J=8.5Hz), 6.68 (d, 1H, J=8.5Hz).

Step 5: synthesis of compound B

A four-necked reactor equipped with a thermometer was charged with 1.50 g (6.02 mmol) of intermediate 2-4 and 50 ml of chloroform under a nitrogen stream. 5.29 g (12.63 mmol) of intermediate A synthesized in the same way as Step 7 of compound A and 147 mg (1.20 mmol) of 4-dimethylaminopyridine were added to this solution, and cooled to 0 °C. After this, 1.82 g (14.5 mmol) of N,N'-diisopropylcarbodiimide was added to the solution, and stirred at room temperature for 1.5 hr. After the completion of the reaction, the reaction solution was filtered using a filter medium precoated with a silica gel, and then concentrated under reduced pressure. 100 ml of methanol was added to the resulting residue, and the precipitated solid was filtered. The resulting solid was vacuum dried, thus obtaining 4.69 g of compound B as a white solid (yield: 74.2 %). The structure was identified by $^1$H-NMR. $^1$H-NMR spectral data is as follows.
$^1$H-NMR (500 MHz, $CDCl_3$, TMS, $\delta$ ppm): 7.63 (dd, 1H, J=1.0Hz, 3.5Hz), 7.51 (dd, 1H, J=1.0Hz, 5.0Hz), 7.18 (s, 2H), 7.12 (dd, 1H, J=3.5Hz, 5.0Hz), 6.993 (d, 2H, J=9.0Hz), 6.987 (d, 2H, J=9.0Hz), 6.88 (d, 4H, J=9.0Hz), 6.40 (dd, 2H, J=1.5Hz, 17.5Hz), 6.12 (dd, 2H, J=10.0Hz, 17.5Hz), 5.82 (dd, 2H, J=1.5Hz, 10.0Hz), 4.17 (t, 4H, J=6.5Hz), 3.94 (t, 4H, J=6.5Hz), 2.79 (tt, 1H, J=3.5Hz, 11.5Hz), 2.58-2.71 (m, 3H), 2.42-2.45 (m, 2H), 2.31-2.36 (m, 6H), 1.66-1.89 (m, 16H), 1.42-1.54 (m, 8H).

<Measurement of phase transition temperature>

5 mg of each of compound 1 and compounds A and B was weighed and placed in solid state between two glass substrates with rubbed polyimide alignment films (product name: alignment treated glass substrate (produced by E.H.C Co., Ltd.)). The obtained assembly was placed on a hot plate and the temperature was raised from 50 °C to 200 °C, and then lowered to 50 °C. Structural changes of the compound during temperature rise and fall were observed with a polarized optical microscope (ECLIPSE LV100POL produced by NIKON).
The phase transition temperature measurement results are shown in Table 1.
In Table 1, "C" refers to "Crystal", "N" refers to "Nematic", and "I" refers to "Isotropic". The term "Crystal" means that the test compound was in a solid phase, the term "Nematic" means that the test compound was in a nematic liquid

crystal phase, and the term "Isotropic" means that the test compound was in an isotropic liquid phase.

| Compound ID | Phase transition temperature |
|---|---|
| Compound 1 | 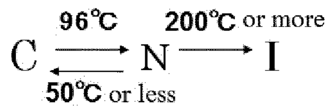 |
| Compound A | 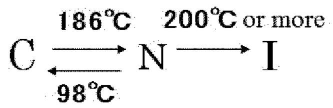 |
| Compound B | 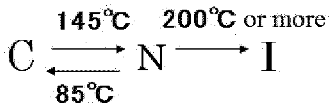 |

<Evaluation of ease of preparation and stability of polymerizable composition>

(Example 1-1)

100 mg of compound 1 obtained in Synthesis Example 1, 400 mg of compound A obtained in Synthesis Example 2, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 1-1 was heated to 60 °C, and held for 10 min. After this, the composition 1-1 was held at each temperature in increments of 5 °C for 10 min, until the whole quantity dissolved. Visually inspecting at which temperature the crystals dissolved to form a clear solution revealed that the crystals dissolved at 80 °C.

The resulting solution was then heated to 90 °C, and filtered through a disposable filter with a pore size of 0.45 μm while maintaining the temperature, to obtain polymerizable composition 1-1. This polymerizable composition 1-1 was heated again to 90 °C, to obtain a clear solution. Subsequently, the polymerizable composition 1-1 was returned to room temperature (23 °C), and the time from when the polymerizable composition 1-1 returned to room temperature to when the crystals precipitated was measured. The results are shown in Table 2.

(Example 1-2)

Composition 1-2 was obtained in the same way as composition 1-1, except that, instead of 2.0 g of cyclopentanone, 2.0 g of a mixed solvent composed of 40 wt% of cyclopentanone and 60 wt% of 1,3-dioxolane prepared separately was used. The resulting composition 1-2 was heated to 60 °C, and held for 10 min. After this, the composition 1-2 was held at each temperature in increments of 5 °C for 10 min, until the whole quantity dissolved. Visually inspecting at which temperature the crystals dissolved to form a clear solution revealed that the crystals dissolved at 70 °C.

The resulting solution was then heated to 90 °C, and filtered through a disposable filter with a pore size of 0.45 μm while maintaining the temperature, to obtain polymerizable composition 1-2. This polymerizable composition 1-2 was heated again to 90 °C, to obtain a clear solution. Subsequently, the polymerizable composition 1-2 was returned to room temperature (23 °C), and the time from when the polymerizable composition 1-2 returned to room temperature to when the crystals precipitated was measured. The results are shown in Table 2.

(Example 2-1)

250 mg of compound 1 obtained in Synthesis Example 1, 250 mg of compound A obtained in Synthesis Example 2, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 2-1 was heated to 60 °C, and held for 10 min. After this, the composition 2-1 was held at each temperature in increments of 5 °C for 10 min, until the whole quantity dissolved. Visually inspecting at which temperature the crystals dissolved to form a clear solution revealed that the crystals dissolved at 80 °C.

The resulting solution was then heated to 90 °C, and filtered through a disposable filter with a pore size of 0.45 μm while maintaining the temperature, to obtain polymerizable composition 2-1. This polymerizable composition 2-1 was heated again to 90 °C, to obtain a clear solution. Subsequently, the polymerizable composition 2-1 was returned

to room temperature (23 °C), and the time from when the polymerizable composition 2-1 returned to room temperature to when the crystals precipitated was measured. The results are shown in Table 2.

(Example 2-2)

Composition 2-2 was obtained in the same way as composition 2-1, except that, instead of 2.0 g of cyclopentanone, 2.0 g of a mixed solvent composed of 40 wt% of cyclopentanone and 60 wt% of 1,3-dioxolane prepared separately was used. The resulting composition 2-2 was heated to 60 °C, and held for 10 min. After this, the composition 2-2 was held at each temperature in increments of 5 °C for 10 min, until the whole quantity dissolved. Visually inspecting at which temperature the crystals dissolved to form a clear solution revealed that the crystals dissolved at 70 °C.

The resulting solution was then heated to 90 °C, and filtered through a disposable filter with a pore size of 0.45 μm while maintaining the temperature, to obtain polymerizable composition 2-2. This polymerizable composition 2-2 was heated again to 90 °C, to obtain a clear solution. Subsequently, the polymerizable composition 2-2 was returned to room temperature (23 °C), and the time from when the polymerizable composition 2-2 returned to room temperature to when the crystals precipitated was measured. The results are shown in Table 2.

(Example 3-1)

400 mg of compound 1 obtained in Synthesis Example 1, 100 mg of compound A obtained in Synthesis Example 2, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 3-1 was heated to 60 °C, and held for 10 min. After this, the composition 3-1 was held at each temperature in increments of 5 °C for 10 min, until the whole quantity dissolved. Visually inspecting at which temperature the crystals dissolved to form a clear solution revealed that the crystals dissolved at 65 °C.

The resulting solution was then heated to 90 °C, and filtered through a disposable filter with a pore size of 0.45 μm while maintaining the temperature, to obtain polymerizable composition 3-1. This polymerizable composition 3-1 was heated again to 90 °C, to obtain a clear solution. Subsequently, the polymerizable composition 3-1 was returned to room temperature (23 °C), and the time from when the polymerizable composition 3-1 returned to room temperature to when the crystals precipitated was measured. The results are shown in Table 2.

(Example 3-2)

Composition 3-2 was obtained in the same way as composition 3-1, except that, instead of 2.0 g of cyclopentanone, 2.0 g of a mixed solvent composed of 40 wt% of cyclopentanone and 60 wt% of 1,3-dioxolane prepared separately was used. The resulting composition 3-2 was heated to 60 °C, and held for 10 min. After this, the composition 3-2 was held at each temperature in increments of 5 °C for 10 min, until the whole quantity dissolved. Visually inspecting at which temperature the crystals dissolved to form a clear solution revealed that the crystals dissolved at 60 °C.

The resulting solution was then heated to 90 °C, and filtered through a disposable filter with a pore size of 0.45 μm while maintaining the temperature, to obtain polymerizable composition 3-2. This polymerizable composition 3-2 was heated again to 90 °C, to obtain a clear solution. Subsequently, the polymerizable composition 3-2 was returned to room temperature (23 °C), and the time from when the polymerizable composition 3-2 returned to room temperature to when the crystals precipitated was measured. The results are shown in Table 2.

(Example 4-1)

100 mg of compound 1 obtained in Synthesis Example 1, 300 mg of compound A obtained in Synthesis Example 2, 100 mg of compound B obtained in Synthesis Example 3, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 4-1 was heated to 60 °C, and held for 10 min. After this, the composition 4-1 was held at each temperature in increments of 5 °C for 10 min, until the whole quantity dissolved. Visually inspecting at which temperature the crystals dissolved to form a clear solution revealed that the crystals dissolved at 70 °C.

The resulting solution was then heated to 90 °C, and filtered through a disposable filter with a pore size of 0.45 μm while maintaining the temperature, to obtain polymerizable composition 4-1. This polymerizable composition 4-1 was heated again to 90 °C, to obtain a clear solution. Subsequently, the polymerizable composition 4-1 was returned to room temperature (23 °C), and the time from when the polymerizable composition 4-1 returned to room temperature to when the crystals precipitated was measured. The results are shown in Table 3.

(Example 4-2)

Composition 4-2 was obtained in the same way as composition 4-1, except that, instead of 2.0 g of cyclopentanone, 2.0 g of a mixed solvent composed of 40 wt% of cyclopentanone and 60 wt% of 1,3-dioxolane prepared separately was used. The resulting composition 4-2 was heated to 60 °C, and held for 10 min. After this, the composition 4-2 was held at each temperature in increments of 5 °C for 10 min, until the whole quantity dissolved. Visually inspecting at which temperature the crystals dissolved to form a clear solution revealed that the crystals dissolved at 60 °C.

The resulting solution was then heated to 90 °C, and filtered through a disposable filter with a pore size of 0.45 μm while maintaining the temperature, to obtain polymerizable composition 4-2. This polymerizable composition 4-2 was heated again to 90 °C, to obtain a clear solution. Subsequently, the polymerizable composition 4-2 was returned to room temperature (23 °C), and the time from when the polymerizable composition 4-2 returned to room temperature to when the crystals precipitated was measured. The results are shown in Table 3.

(Comparative Example 1-1)

500 mg of compound A obtained in Synthesis Example 2, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 5-1 was heated to 60 °C, and held for 10 min. After this, the composition 5-1 was held at each temperature in increments of 5 °C for 10 min, until the whole quantity dissolved. Visually inspecting at which temperature the crystals dissolved to form a clear solution revealed that the crystals dissolved at 90 °C.

The resulting solution was then heated to 90 °C, and filtered through a disposable filter with a pore size of 0.45 μm while maintaining the temperature, to obtain polymerizable composition 5-1. This polymerizable composition 5-1 was heated again to 90 °C, to obtain a clear solution. Subsequently, the polymerizable composition 5-1 was returned to room temperature (23 °C), and the time from when the polymerizable composition 5-1 returned to room temperature to when the crystals precipitated was measured. The results are shown in Table 2.

(Comparative Example 1-2)

Composition 5-2 was obtained in the same way as composition 5-1, except that, instead of 2.0 g of cyclopentanone, 2.0 g of a mixed solvent composed of 40 wt% of cyclopentanone and 60 wt% of 1,3-dioxolane prepared separately was used. The resulting composition 5-2 was heated to 60 °C, and held for 10 min. After this, the composition 5-2 was held at each temperature in increments of 5 °C for 10 min, until the whole quantity dissolved. Visually inspecting at which temperature the crystals dissolved to form a clear solution revealed that the crystals dissolved at 85 °C.

The resulting solution was then heated to 90 °C, and filtered through a disposable filter with a pore size of 0.45 μm while maintaining the temperature, to obtain polymerizable composition 5-2. This polymerizable composition 5-2 was heated again to 90 °C, to obtain a clear solution. Subsequently, the polymerizable composition 5-2 was returned to room temperature (23 °C), and the time from when the polymerizable composition 5-2 returned to room temperature to when the crystals precipitated was measured. The results are shown in Table 2.

(Comparative Example 2-1)

375 mg of compound A obtained in Synthesis Example 2, 125 mg of compound B obtained in Synthesis Example 3, 15.4 mg of photopolymerization initiator Irgacure #819 (produced by BASF), 0.51 mg of surfactant BYK361N (produced by BYK Japan KK), and 2.0 g of cyclopentanone were mixed. The resulting composition 6-1 was heated to 60 °C, and held for 10 min. After this, the composition 6-1 was held at each temperature in increments of 5 °C for 10 min, until the whole quantity dissolved. Visually inspecting at which temperature the crystals dissolved to form a clear solution revealed that the crystals dissolved at 80 °C.

The resulting solution was then heated to 90 °C, and filtered through a disposable filter with a pore size of 0.45 μm while maintaining the temperature, to obtain polymerizable composition 6-1. This polymerizable composition 6-1 was heated again to 90 °C, to obtain a clear solution. Subsequently, the polymerizable composition 6-1 was returned to room temperature (23 °C), and the time from when the polymerizable composition 6-1 returned to room temperature to when the crystals precipitated was measured. The results are shown in Table 3.

(Comparative Example 2-2)

Composition 6-2 was obtained in the same way as composition 6-1, except that, instead of 2.0 g of cyclopentanone, 2.0 g of a mixed solvent composed of 40 wt% of cyclopentanone and 60 wt% of 1,3-dioxolane prepared separately was used. The resulting composition 6-2 was heated to 60 °C, and held for 10 min. After this, the composition 6-2 was

held at each temperature in increments of 5 °C for 10 min, until the whole quantity dissolved. Visually inspecting at which temperature the crystals dissolved to form a clear solution revealed that the crystals dissolved at 75 °C.

The resulting solution was then heated to 90 °C, and filtered through a disposable filter with a pore size of 0.45 μm while maintaining the temperature, to obtain polymerizable composition 6-2. This polymerizable composition 6-2 was heated again to 90 °C, to obtain a clear solution. Subsequently, the polymerizable composition 6-2 was returned to room temperature (23 °C), and the time from when the polymerizable composition 6-2 returned to room temperature to when the crystals precipitated was measured. The results are shown in Table 3.

Table 2

| | Polymerizable composition | Solvent type | Polymerizable compound (I) | Polymerizable compound (II) | | Polymerization initiator Irgacure #819 (mass%) | Leveling agent BYK361N (mass%) | Solvent (mass%) | Tenperature at which whole quantity dis-solved (°C) | Tine from re-turn to room temperature to precipitation |
|---|---|---|---|---|---|---|---|---|---|---|
| | | | Compound 1 (mass%) | Compound A (mass%) | Compound B (mass%) | | | | | |
| Example 1-1 | 1-1 | Cyclopentanone | 3.97 | 15.90 | 0.00 | 0.61 | 0.02 | 79.49 | 80 | 3 min |
| Example 1-2 | 1-2 | Cyclopentanone/ 1,3-di:nolane | 3.97 | 15.90 | 0.00 | 0.61 | 0.02 | 79.49 | 70 | 30 min |
| Example 2-1 | 2-1 | Cyclopentanone | 9.94 | 9.94 | 0.00 | 0.61 | 0.02 | 79.49 | 80 | 3 hr |
| Example 2-2 | 2-2 | Cyclopentanone/ 1,3-dioxolane | 9.94 | 9.94 | 0.00 | 0.61 | 0.02 | 79.49 | 70 | 6 hr |
| Example 3-1 | 3-1 | Cyclopentanone | 15.90 | 3.97 | 0.00 | 0.61 | 0.02 | 79.49 | 65 | 12 hr or more |
| Example 3-2 | 3-2 | Cyclopentanone/ 1,3-dioxolane | 15.90 | 3.97 | 0.00 | 0.61 | 0.02 | 79.49 | 60 | 24 hr or more |
| Comparative Example 1-1 | 5-1 | Cyclopentanone | 0.00 | 19.87 | 0.00 | 0.61 | 0.02 | 79.49 | 90 | 30 sec |
| Comparative Example 1-2 | 5-2 | Cyclopentanone/ 1,3-dioxolane | 0.00 | 19.87 | 0.00 | 0.61 | 0.02 | 79.49 | 85 | 45 sec |

Table 3

| | Polymerizable composition | Solvent type | Polymerizable compound (I) | Polymerizable compound (II) | | Polymerization initiator Irgacure #819 (mass%) | Leveling agent BYK361N (mass%) | Solvent (mass%) | Temperature at which whole quantity dissolved (°C) | Time from return to room temperature to precipitation |
|---|---|---|---|---|---|---|---|---|---|---|
| | | | Compound 1 (mass%) | Compound A (mass%) | Compound B (mass%) | | | | | |
| Example 4-1 | 4-1 | Cyclopentanone | 3.97 | 11.92 | 3.97 | 0.61 | 0.02 | 79.49 | 70 | 40 min |
| Example 4-2 | 4-2 | Cyclopentanone/ 13-dioxolane | 3.97 | 11.92 | 3.97 | 0.61 | 0.02 | 79.49 | 60 | 1.5 hr |
| Comparative Example 2-1 | 6-1 | Cyclopentanone | 0.00 | 14.91 | 4.97 | 0.61 | 0.02 | 79.49 | 80 | 10 min |
| Comparative Example 2-2 | 6-2 | Cyclopentanone/ 1,3-dioxolane | 0.00 | 14.91 | 4.97 | 0.61 | 0.02 | 79.49 | 75 | 13 min |

<Evaluation of optical properties>

(Examples 5-1 to 8-2, Comparative Examples 3-1 to 4-2)

(i) Formation of liquid crystal layer using polymerizable composition

Using a #4 wire bar coater, each of polymerizable compositions 1-1 to 6-2 obtained as described above was applied to a transparent glass substrate with a rubbed polyimide alignment film (product name: alignment treated glass substrate (produced by E.H.C Co., Ltd.)). The resulting coating film was dried for 1 min at the temperature shown in Table 4 and subjected to alignment treatment for 1 min at the temperature shown in Table 4 to form a liquid crystal layer.

(ii) Formation of optically anisotropic product

The liquid crystal layer produced in section (i) above was irradiated with UV light at 2500 $mJ/cm^2$ at the temperature shown in Table 4 from the coated surface side to effect polymerization, thus obtaining an optically anisotropic product.

(iii) Measurement of phase difference

For each sample obtained in section (ii) above, the phase differences between 400 nm and 800 nm were measured using an ellipsometer (M2000U produced by J.A. Woollam).

(iv) Evaluation of wavelength dispersion

Wavelength dispersion was evaluated based on $\alpha$ and $\beta$ values calculated as described below using the measured phase differences.

$$\alpha = \text{(phase difference at 449.9 nm)/(phase difference at 548.5 nm).}$$

$$\beta = \text{(phase difference at 650.2 nm)/(phase difference at 548.5 nm).}$$

In the case where the optically anisotropic product exhibits ideal wavelength dispersibility showing a broad band property, i.e. reverse wavelength dispersibility, $\alpha$ value is less than 1 and $\beta$ value is greater than 1.

Changes in $\alpha$ and $\beta$ values were observed, and the effects of mixing a plurality of types of polymerizable compounds were investigated. The results demonstrate that, even in the case of using the polymerizable compounds (I) and (II) in combination, excellent reverse wavelength dispersibility was maintained and optical performance was higher than or equal to that in the case of using the polymerizable compound (II) alone. On the other hand, the use of the polymerizable compounds (I) and (II) in combination caused decreases in drying temperature and alignment treatment temperature in some cases.

| | Polymerizable composition | Drying temperature (°C) | Alignment treatment temperature (°C) | Temperature on exposure (°C) | Exposure value (mJ) | α value | β value |
|---|---|---|---|---|---|---|---|
| Example 5-1 | 1-1 | 160 | 160 | 160 | 2500 | 0.786 | 1.055 |
| Example 5-2 | 1-2 | 160 | 160 | 160 | | 0.784 | 1.053 |
| Example 6-1 | 2-1 | 150 | 150 | 150 | | 0.783 | 1.056 |
| Example 6-2 | 2-2 | 150 | 150 | 150 | | 0.781 | 1.056 |
| Example 7-1 | 3-1 | 120 | 80 | 80 | | 0.789 | 1.053 |
| Example 7-2 | 3-2 | 120 | 80 | 80 | | 0.787 | 1.051 |
| Example 8-1 | 4-1 | 140 | 140 | 140 | | 0.833 | 1.035 |
| Example 8-2 | 4-2 | 140 | 140 | 140 | | 0.829 | 1.033 |
| Comparative Example 3-1 | 5-1 | 180 | 180 | 180 | | 0.786 | 1.058 |
| Comparative Example 3-2 | 5-2 | 180 | 180 | 180 | | 0.788 | 1.055 |
| Comparative Example 4-1 | 6-1 | 150 | 150 | 150 | | 0.841 | 1.029 |
| Comparative Example 4-2 | 6-2 | 150 | 150 | 150 | | 0.840 | 1.027 |

INDUSTRIAL APPLICABILITY

It is therefore possible to provide a polymerizable composition that is capable of forming an optical film and an optically anisotropic product having excellent reverse wavelength dispersibility, can be prepared at relatively low temperature, and has excellent stability around room temperature.

It is also possible to provide a mixture useful in the preparation of the polymerizable composition.

It is also possible to provide an optical film and an optically anisotropic product having excellent reverse wavelength dispersibility, and a polarizing plate, a flat panel display device, an organic electroluminescent (EL) display device, and an antireflection film using the optically anisotropic product.

It is further possible to provide a method of using a polymerizable compound to suppress precipitation of a compound in a polymerizable composition.

## Claims

**1.** A mixture comprising:

a polymerizable compound represented by the following Formula (I):

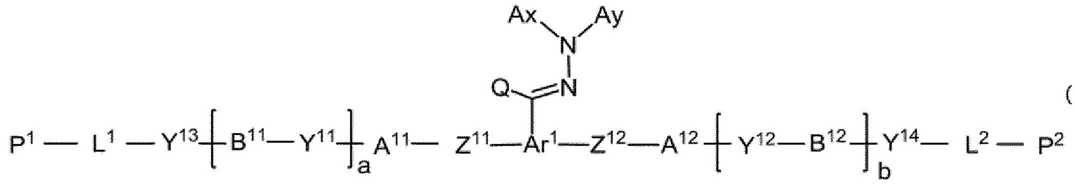

(I)

where $Ar^1$ represents an aromatic group that may have a substituent,
Q represents a hydrogen atom or an alkyl group with a carbon number of 1 to 6,
Ax represents an organic group having at least one aromatic ring selected from the group consisting of an

aromatic hydrocarbon ring with a carbon number of 6 to 30 and an aromatic heterocyclic ring with a carbon number of 2 to 30, and the aromatic ring of Ax may have a substituent,

Ay represents a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, $-C(=O)-R^{11}$, $-SO_2-R^{12}$, $-CS-NH-R^{13}$, an aromatic hydrocarbon ring group with a carbon number of 6 to 30 that may have a substituent, or an aromatic heterocyclic group with a carbon number of 2 to 30 that may have a substituent, $R^{11}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, $R^{12}$ represents an alkyl group with a carbon number of 1 to 6, or an aromatic hydrocarbon ring group with a carbon number of 6 to 20 that may have a substituent, and $R^{13}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, an aromatic hydrocarbon ring group with a carbon number of 5 to 20 that may have a substituent, or an aromatic heterocyclic group with a carbon number of 5 to 20 that may have a substituent,

$Z^{11}$ and $Z^{12}$ each independently represent a single bond, $-O-CH_2-$, $-CH_2-O-$, $-C(=O)-O-$, $-O-C(=O)-$, $-C(=O)-S-$, $-S-C(=O)-$, $-NR^{21}-C(=O)-$, $-C(=O)-NR^{21}-$, $-CF_2-O-$, $-O-CF_2-$, $-CH_2-CH_2-$, $-CF_2-CF_2-$, $-O-CH_2-CH_2-O-$, $-CH=CH-C(=O)-O-$, $-O-C(=O)-CH=CH-$, $-CH_2-CH_2-C(=O)-O-$, $-O-C(=O)-CH_2-CH_2-$, $-CH_2-CH_2-O-C(=O)-$, $-C(=O)-O-CH_2-CH_2-$, $-CH_2-C(=O)-O-$, $-O-C(=O)-CH_2-$, $-CH_2-O-C(=O)-$, $-C(=O)-O-CH_2-$, $-CH=CH-$, $-N=CH-$, $-CH=N-$, $-N=C(CH_3)-$, $-C(CH_3)=N-$, $-N=N-$, or $-C\equiv C-$, and $R^{21}$ represents a hydrogen atom or an alkyl group with a carbon number of 1 to 6,

$A^{11}$, $A^{12}$, $B^{11}$, and $B^{12}$ each independently represent a cyclic aliphatic group that may have a substituent or an aromatic group that may have a substituent,

$Y^{11}$ to $Y^{14}$ each independently represent a single bond, $-O-$, $-C(=O)-$, $-C(=O)-O-$, $-O-C(=O)-$, $-NR^{31}-C(=O)-$, $-C(=O)-NR^{31}-$, $-O-C(=O)-O-$, $-NR^{31}-C(=O)-O-$, $-O-C(=O)-NR^{31}-$, or $-NR^{31}-C(=O)-NR^{32}-$, and $R^{31}$ and $R^{32}$ each independently represent a hydrogen atom or an alkyl group with a carbon number of 1 to 6,

$L^1$ and $L^2$ each independently represent an organic group of any of an alkylene group with a carbon number of 1 to 20 and a group obtained by substituting at least one methylene group ($-CH_2-$) contained in an alkylene group with a carbon number of 1 to 20 by -O- or -C(=O)-, and a hydrogen atom contained in the organic group for $L^1$ and $L^2$ may be substituted by an alkyl group with a carbon number of 1 to 5, an alkoxy group with a carbon number of 1 to 5, or a halogen atom,

one of $P^1$ and $P^2$ represents a hydrogen atom or a polymerizable group, and the other one of $P^1$ and $P^2$ represents a polymerizable group, and

a and b are each independently 0 or 1; and

a polymerizable compound represented by the following Formula (II):

$$P^3-L^{11}-Y^{23}\left[B^{21}-Y^{21}\right]_c A^{21}-Z^{21}-Ar^2-Z^{22}-A^{22}\left[Y^{22}-B^{22}\right]_d Y^{24}-L^{12}-P^4 \quad (II)$$

where $Ar^2$ represents any of the following Formulas (III-1) to (III-4):

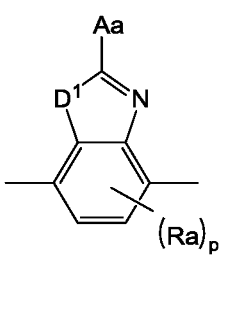
(III-1)

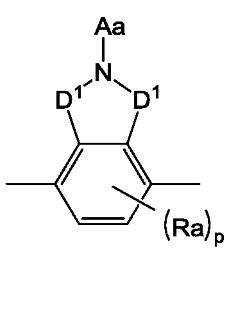
(III-2)

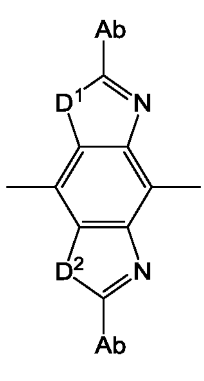
(III-3)

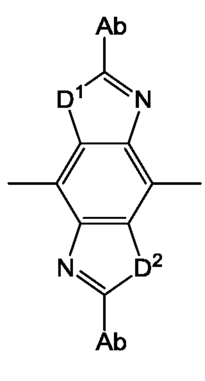
(III-4)

where Ra each independently represent a halogen atom, an alkyl group with a carbon number of 1 to 6, a cyano group, a nitro group, an alkylsulfinyl group with a carbon number of 1 to 6, an alkylsulfonyl group with a carbon number of 1 to 6, a carboxyl group, a fluoroalkyl group with a carbon number of 1 to 6, an alkoxy group with a carbon number of 1 to 6, an alkylthio group with a carbon number of 1 to 6, an N-alkylamino group with a carbon number of 1 to 6, an N,N-dialkylamino group with a carbon number of 2 to 12, an N-alkylsulfamoyl group with a carbon number of 1 to 6, or an N,N-dialkylsulfamoyl group with a carbon number of 2 to 12,

$D^1$ and $D^2$ each independently represent $-CR^{41}R^{42}-$, -S-, $-NR^{41}-$, -C(=O)-, or -O-, and $R^{41}$ and $R^{42}$ each independently represent a hydrogen atom or an alkyl group with a carbon number of 1 to 4,

Aa and Ab each independently represent an aromatic hydrocarbon ring group or an aromatic heterocyclic group that may be substituted,

p represents an integer of 0 to 2, and in the case where a plurality of Ra, $D^1$, or Ab are present, the plurality of Ra, $D^1$, or Ab may be the same or different,

$Z^{21}$ and $Z^{22}$ each independently represent a single bond, $-O-CH_2-$, $-CH_2-O-$, -C(=O)-O-, -O-C(=O)-, -C(=O)-S-, -S-C(=O)-, $-NR^{51}-C(=O)-$, $-C(=O)-NR^{51}-$, $-CF_2-O-$, $-O-CF_2-$, $-CH_2-CH_2-$, $-CF_2-CF_2-$, $-O-CH_2-CH_2-O-$, -CH=CH-C(=O)-O-, -O-C(=O)-CH=CH-, $-CH_2-CH_2-C(=O)-O-$, $-O-C(=O)-CH_2-CH_2-$, $-CH_2-CH_2-O-C(=O)-$, $-C(=O)-O-CH_2-CH_2-$, $-CH_2-C(=O)-O-$, $-O-C(=O)-CH_2-$, $-CH_2-O-C(=O)-$, $-C(=O)-O-CH_2-$, -CH=CH-, -N=CH-, -CH=N-, $-N=C(CH_3)-$, $-C(CH_3)=N-$, -N=N-, or -C≡C-, and $R^{51}$ represents a hydrogen atom or an alkyl group with a carbon number of 1 to 6,

$A^{21}$, $A^{22}$, $B^{21}$, and $B^{22}$ each independently represent a cyclic aliphatic group that may have a substituent or an aromatic group that may have a substituent,

$Y^{21}$ to $Y^{24}$ each independently represent a single bond, -O-, -C(=O)-, -C(=O)-O-, -O-C(=O)-, $-NR^{61}-C(=O)-$, $-C(=O)-NR^{61}-$, -O-C(=O)-O-, $-NR^{61}-C(=O)-O-$, $-O-C(=O)-NR^{61}-$, or $-NR^{61}-C(=O)-NR^{62}-$, and $R^{61}$ and $R^{62}$ each independently represent a hydrogen atom or an alkyl group with a carbon number of 1 to 6,

$L^{11}$ and $L^{12}$ each independently represent an organic group of any of an alkylene group with a carbon number of 1 to 20 and a group obtained by substituting at least one methylene group ($-CH_2-$) contained in an alkylene group with a carbon number of 1 to 20 by -O- or -C(=O)-, and a hydrogen atom contained in the organic group for $L^{11}$ and $L^{12}$ may be substituted by an alkyl group with a carbon number of 1 to 5, an alkoxy group with a carbon number of 1 to 5, or a halogen atom,

one of $P^3$ and $P^4$ represents a hydrogen atom or a polymerizable group, and the other one of $P^3$ and $P^4$ represents a polymerizable group, and

c and d are each independently 0 or 1.

2. The mixture according to claim 1, wherein a proportion of the polymerizable compound represented by the Formula (I) in a total of the polymerizable compound represented by the Formula (I) and the polymerizable compound represented by the Formula (II) is 5 mass% or more and 90 mass% or less.

3. The mixture according to claim 1 or 2, wherein Ay is an alkyl group with a carbon number of 1 to 20 that may have a substituent, an alkenyl group with a carbon number of 2 to 20 that may have a substituent, an alkynyl group with a carbon number of 2 to 20 that may have a substituent, an aromatic hydrocarbon ring group with a carbon number of 6 to 30 that may have a substituent, or an aromatic heterocyclic group with a carbon number of 2 to 30 that may have a substituent.

4. The mixture according to any of claims 1 to 3, wherein Ax is a group represented by the following Formula (IV):

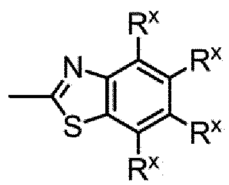

(IV)

where $R^X$ represents a hydrogen atom, a halogen atom, an alkyl group with a carbon number of 1 to 6, a cyano group, a nitro group, a fluoroalkyl group with a carbon number of 1 to 6, an alkoxy group with a carbon number of 1 to 6, $-OCF_3$, or $-C(=O)-O-R^2$, $R^2$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, a plurality of $R^X$ may all be the same or may be different, and at least one

C-$R^X$ forming a ring may be substituted by a nitrogen atom.

**5.** The mixture according to any of claims 1 to 4, wherein $Ar^1$ is a benzene ring group.

**6.** The mixture according to claim 1 or 2, wherein the polymerizable compound represented by the Formula (I) is a polymerizable compound represented by the following Formula (V):

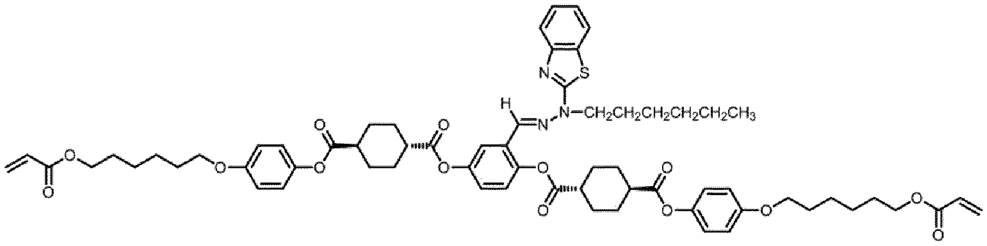

(V)

,

and

the polymerizable compound represented by the Formula (II) is at least any of a polymerizable compound represented by the following Formula (VI):

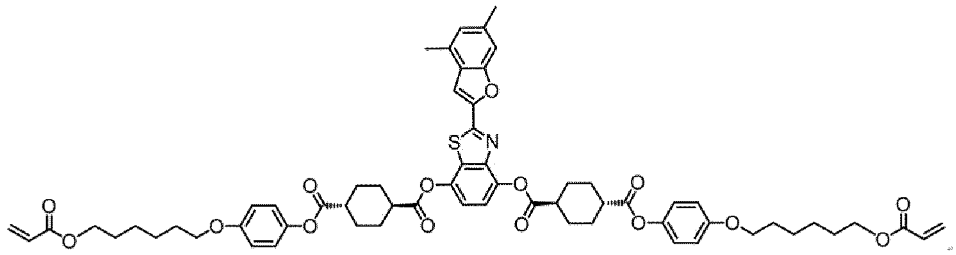

(VI)

and

a polymerizable compound represented by the following Formula (VII):

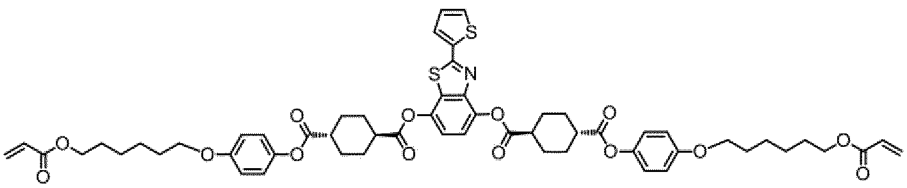

(VII)

.

**7.** A polymerizable composition comprising:

the mixture according to any of claims 1 to 6; and
a polymerization initiator.

**8.** The polymerizable composition according to claim 7, further comprising a solvent.

**9.** The polymerizable composition according to claim 8, wherein the solvent contains at least any of ethers and ketones.

**10.** A polymer obtainable by polymerization of the mixture according to any of claims 1 to 6.

**11.** A polymer obtainable by polymerization of the polymerizable composition according to any of claims 7 to 9.

**12.** An optical film comprising the polymer according to claim 10 or 11 as a constituent material.

**13.** An optically anisotropic product comprising a layer having the polymer according to claim 10 or 11 as a constituent material.

**14.** A polarizing plate comprising:

the optically anisotropic product according to claim 13; and
a polarizing film.

**15.** A flat panel display device comprising:

the polarizing plate according to claim 14; and
a liquid crystal panel.

**16.** An organic electroluminescent display device comprising:

the polarizing plate according to claim 14; and
an organic electroluminescent panel.

**17.** An antireflection film comprising the polarizing plate according to claim 14.

**18.** A method of using a polymerizable compound represented by the following Formula (I) to suppress precipitation of a compound in a polymerizable composition:

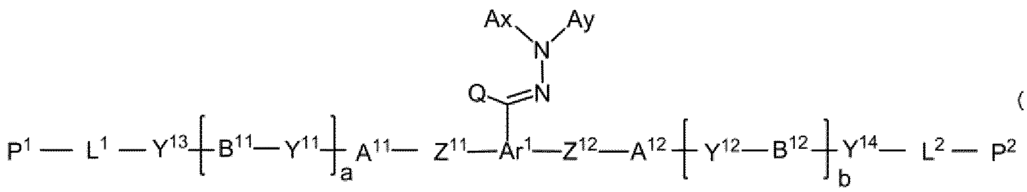
(I)

where $Ar^1$ represents an aromatic group that may have a substituent,
Q represents a hydrogen atom or an alkyl group with a carbon number of 1 to 6,
Ax represents an organic group having at least one aromatic ring selected from the group consisting of an aromatic hydrocarbon ring with a carbon number of 6 to 30 and an aromatic heterocyclic ring with a carbon number of 2 to 30, and the aromatic ring of Ax may have a substituent,
Ay represents a hydrogen atom, an alkyl group with a carbon number of 1 to 20 that may have a substituent, an alkenyl group with a carbon number of 2 to 20 that may have a substituent, an alkynyl group with a carbon number of 2 to 20 that may have a substituent, a cycloalkyl group with a carbon number of 3 to 12 that may have a substituent, $-C(=O)-R^{11}$, $-SO_2-R^{12}$, $-CS-NH-R^{13}$, an aromatic hydrocarbon ring group with a carbon number of 6 to 30 that may have a substituent, or an aromatic heterocyclic group with a carbon number of 2 to 30 that may have a substituent, $R^{11}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, or an aromatic hydrocarbon ring group with a carbon number of 5 to 12 that may have a substituent, $R^{12}$ represents an alkyl group with a carbon number of 1 to 6, or an aromatic hydrocarbon ring group with a carbon number of 6 to 20 that may have a substituent, and $R^{13}$ represents an alkyl group with a carbon number of 1 to 20 that may have a substituent, an alkenyl group with a carbon number of 2 to 20 that may have a substituent, a cycloalkyl group with a carbon number of 3 to 12 that may have a substituent, an aromatic hydrocarbon ring group with a carbon number of 5 to 20 that may have a substituent, or an aromatic heterocyclic group with a carbon number of 5 to 20 that may have a substituent,
$Z^{11}$ and $Z^{12}$ each independently represent a single bond, $-O-CH_2-$, $-CH_2-O-$, $-C(=O)-O-$, $-O-C(=O)-$, $-C(=O)-S-$, $-S-C(=O)-$, $-NR^{21}-C(=O)-$, $-C(=O)-NR^{21}-$, $-CF_2-O-$, $-O-CF_2-$, $-CH_2-CH_2-$, $-CF_2-CF_2-$, $-O-CH_2-CH_2-O-$, $-CH=CH-C(=O)-O-$, $-O-C(=O)-CH=CH-$, $-CH_2-CH_2-C(=O)-O-$, $-O-C(=O)-CH_2-CH_2-$, $-CH_2-CH_2-O-C(=O)-$, $-C(=O)-O-CH_2-CH_2-$, $-CH_2-C(=O)-O-$, $-O-C(=O)-CH_2-$, $-CH_2-O-C(=O)-$, $-C(=O)-O-CH_2-$, $-CH=CH-$, $-N=CH-$, $-CH=N-$, $-N=C(CH_3)-$, $-C(CH_3)=N-$, $-N=N-$, or $-C\equiv C-$, and $R^{21}$ represents a hydrogen atom or an alkyl group with a carbon number of 1 to 6,
$A^{11}$, $A^{12}$, $B^{11}$, and $B^{12}$ each independently represent a cyclic aliphatic group that may have a substituent or an

aromatic group that may have a substituent,
$Y^{11}$ to $Y^{14}$ each independently represent a single bond, -O-, -C(=O)-, -C(=O)-O-, -O-C(=O)-, -$NR^{31}$-C(=O)-, -C(=O)-$NR^{31}$-, -O-C(=O)-O-, -$NR^{31}$-C(=O)-O-, -O-C(=O)-$NR^{31}$-, or -$NR^{31}$-C(=O)-$NR^{32}$-, and $R^{31}$ and $R^{32}$ each independently represent a hydrogen atom or an alkyl group with a carbon number of 1 to 6,
$L^1$ and $L^2$ each independently represent an organic group of any of an alkylene group with a carbon number of 1 to 20 and a group obtained by substituting at least one methylene group ($-CH_2-$) contained in an alkylene group with a carbon number of 1 to 20 by -O- or -C(=O)-, and a hydrogen atom contained in the organic group for $L^1$ and $L^2$ may be substituted by an alkyl group with a carbon number of 1 to 5, an alkoxy group with a carbon number of 1 to 5, or a halogen atom,
one of $P^1$ and $P^2$ represents a hydrogen atom or a polymerizable group, and the other one of $P^1$ and $P^2$ represents a polymerizable group, and
a and b are each independently 0 or 1.

**INTERNATIONAL SEARCH REPORT**

International application No. PCT/JP2017/035728

A. CLASSIFICATION OF SUBJECT MATTER
*C08F220/34*(2006.01)i, *C09K3/00*(2006.01)i, *G02B5/30*(2006.01)i

According to International Patent Classification (IPC) or to both national classification and IPC

B. FIELDS SEARCHED

Minimum documentation searched (classification system followed by classification symbols)
C08F220/34, C09K3/00, G02B5/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| P,X<br>P,A | WO 2017/038266 A1 (DIC Corp.), 09 March 2017 (09.03.2017), claims; examples (Family: none) | 1-5,7-17<br>6,18 |
| X<br>A | WO 2016/114347 A1 (DIC Corp.), 21 July 2016 (21.07.2016), claims; paragraphs [0005] to [0008]; examples & TW 201700586 A | 1,2,4,5,7-17<br>3,6,18 |
| A | JP 2016-053709 A (Fujifilm Corp.), 14 April 2016 (14.04.2016), claims; examples & US 2015/0277006 A1 claims; examples & CN 104950371 A & KR 10-2015-0113886 A | 1-18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 October 2017 (13.10.17) | 24 October 2017 (24.10.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/035728

C (Continuation). DOCUMENTS CONSIDERED TO BE RELEVANT

| Category* | Citation of document, with indication, where appropriate, of the relevant passages | Relevant to claim No. |
|---|---|---|
| A | WO 2014/132978 A1 (Fujifilm Corp.), 04 September 2014 (04.09.2014), claims; examples & TW 201439612 A | 1-18 |
| A | JP 2016-098258 A (Nippon Zeon Co., Ltd.), 30 May 2016 (30.05.2016), claims (Family: none) | 1-18 |
| A | WO 2016/031946 A1 (Fujifilm Corp.), 03 March 2016 (03.03.2016), claims; examples (Family: none) | 1-18 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010031223 A
- WO 2014010325 A1
- JP 2007002208 A
- JP 2009173893 A
- JP 2009274984 A
- JP 2010030979 A
- JP 2011006360 A
- JP 2010024438 A
- JP H05310845 A
- US 5179171 A
- JP H0597978 A
- US 5202388 A
- JP H11124429 A
- WO 9920676 A1


### Non-patent literature cited in the description


- March's Advanced Organic Chemistry. **S.R. SANDLER ; W. KARO.** Organic Functional Group Preparations. Wiley